# EUROPEAN PATENT APPLICATION

(11) **EP 3 858 842 A1**
(43) Date of publication of application: **04.08.2021**
(21) Application number: 21164003.2
(22) Date of filing: 03.02.2017
(51) Int. Cl.: C07F 15/00, C09K 11/06, H01L 51/00

(54) **ORGANIC ELECTROLUMINESCENT MATERIALS AND DEVICES**

(30) Priority: 09.02.2016 US 201662293100 P; 19.05.2016 US 201662338616 P; 17.01.2017 US 201715407337
(62) Divisional of application: 17154666.6
(71) Applicant: Universal Display Corporation, Ewing, NJ 08618 (US)
(72) Inventor: TSAI, Jui-Yi, Ewing, NJ New Jersey 08618 (US); XIA, Chuanjun, Ewing, NJ New Jersey 08618 (US); LIN, Chun, Ewing, NJ New Jersey 08618 (US); PALACIOS, Adrian U., Ewing, NJ New Jersey 08618 (US); OÑATE, Enrique, Ewing, NJ New Jersey 08618 (US); ESTERUELAS, Miguel A., Ewing, NJ New Jersey 08618 (US); BOUDREAULT, Pierre-Luc T., Ewing, NJ New Jersey 08618 (US)
(74) Representative: Hansen, Norbert

(57) **Abstract**

Novel Iridium complexes having three different bidentate ligands useful for phosphorescent emitters in OLEDs are disclosed. At least one of the three different bidentate ligands is a carbene ligand.

## Description

### CROSS-REFERENCE TO RELATED APPLICATIONS

This application claims priority under 35 U.S.C. §119(e)(1) from United States Provisional Application Serial No. 62/293,100 filed February 9, 2016, and United States Provisional Application Serial No. 62/338,616 filed May 19, 2016, the entire contents of which are incorporated herein by reference.

### FIELD

The present invention relates to compounds for use as phosphorescent emitters, and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

One example of a green emissive molecule is tris(2-phenylpyridine) iridium, denoted Ir(ppy)₃, which has the following structure:

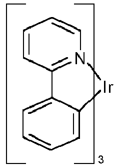

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704, which is incorporated herein by reference in its entirety.

### SUMMARY

Disclosed herein are Iridium complexes comprising three different bidentate ligands, wherein at least one of them is a carbene ligand. They are useful compounds for phosphorescent emitters. The inventors believe that incorporating three different bidentate ligands to Ir(III) metal to form a heteroleptic complex with three different bidentate ligands would be beneficial for OLED performance. For example, the thermal properties, electrochemical properties, and photophysical properties of the complex can be tuned by selecting three proper ligands. It offers more flexibility for materials design than three identical ligands.

According to an aspect of the present disclosure, a compound having a formula M(L_{A})ₓ(L_{B})_{y}(L_{C})_{z} is disclosed, wherein the ligand L_{A} is 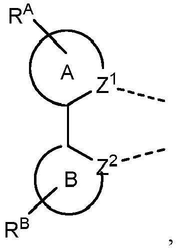 the ligand L_{B} is 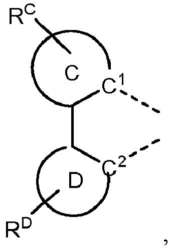 and the ligand Lc is 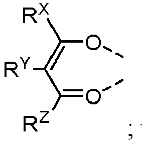 wherein M is a metal having an atomic number greater than 40; wherein x is 0, 1, or 2; wherein y is 1, 2, or 3; wherein z is 0, 1, or 2; wherein x+y+z is the oxidation state of the metal M; wherein L_{A} is different from L_{B}, and when x, y, or z is larger than 1, each plurality of L_{A}, L_{B}, or L_{C} are also different; wherein rings A, B, C, and D are each independently a 5 or 6-membered carbocyclic or heterocyclic ring; wherein R^{A}, R^{B}, R^{C}, and R^{D} each independently represent mono substitution up to the maximum possible number of substitutions, or no substitution; wherein Z¹ and Z² are each independently selected from the group consisting of carbon or nitrogen; wherein C¹ is an anionic donor carbon atom, C² is a neutral carbene carbon atom; wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any adjacent substituents are optionally joined or fused into a ring.

According to another aspect, an OLED is disclosed wherein the OLED comprises: an anode; a cathode; and an organic layer, disposed between the anode and the cathode, comprising A compound having a formula M(L_{A})ₓ(L_{B})_{y}(L_{C})_{z}: wherein the ligand L_{A} is 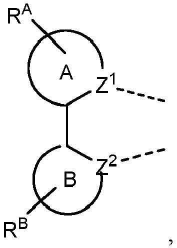 the ligand L_{B} is 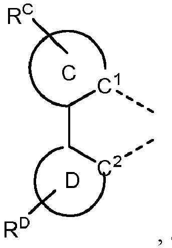 and the ligand L_{C} is 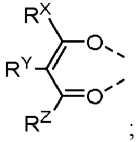 wherein M is a metal having an atomic number greater than 40; wherein x is 0, 1, or 2; wherein y is 1, 2, or 3; wherein z is 0, 1, or 2; wherein x+y+z is the oxidation state of the metal M; wherein L_{A} is different from L_{B}, and when x, y, or z is larger than 1, each plurality of L_{A}, L_{B}, or L_{C} are also different; wherein rings A, B, C, and D are each independently a 5 or 6-membered carbocyclic or heterocyclic ring; wherein R^{A}, R^{B}, R^{C}, and R^{D} each independently represent mono substitution up to the maximum possible number of substitutions, or no substitution; wherein Z¹ and Z² are each independently selected from the group consisting of carbon or nitrogen; wherein C¹ is an anionic donor carbon atom, C² is a neutral carbene carbon atom; wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any adjacent substituents are optionally joined or fused into a ring.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows Oak Ridge Thermal Ellipsoid Plot Program (ORTEP) diagram of complex **5a.**
FIG. 4 shows ORTEP diagram of complex **5b.**
FIG. 5 shows ORTEP diagram of complex **7a.**

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

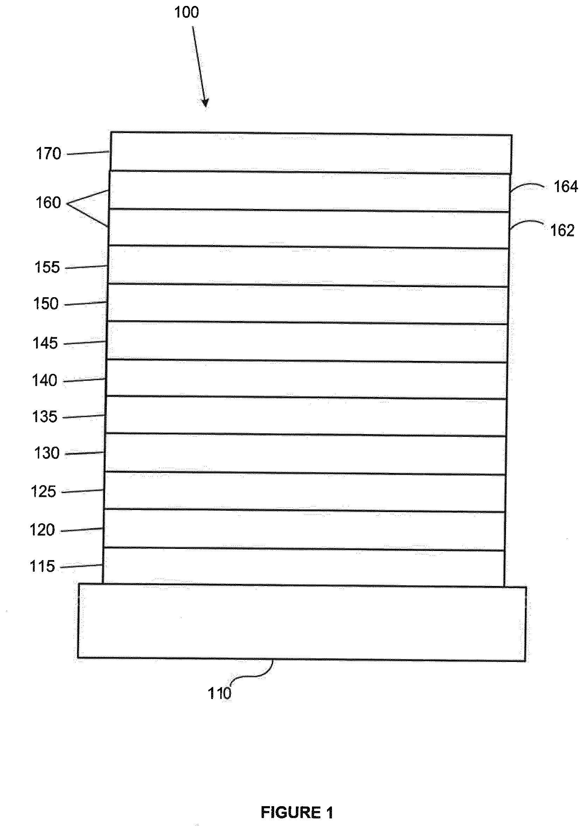

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

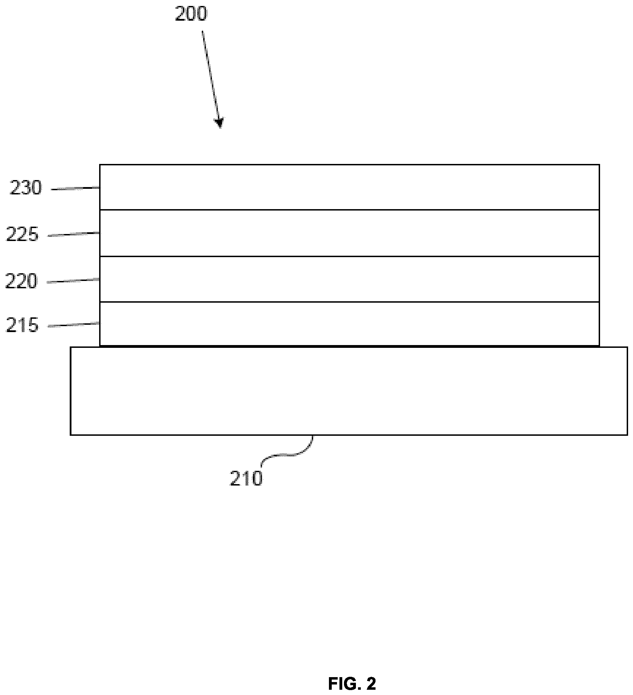

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGs. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJP. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, cell phones, tablets, phablets, personal digital assistants (PDAs), wearable device, laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo," "halogen," or "halide" as used herein includes fluorine, chlorine, bromine, and iodine.

The term "alkyl" as used herein contemplates both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl,and the like. Additionally, the alkyl group may be optionally substituted.

The term "cycloalkyl" as used herein contemplates cyclic alkyl radicals. Preferred cycloalkyl groups are those containing 3 to 10 ring carbon atoms and includes cyclopropyl, cyclopentyl, cyclohexyl, adamantyl, and the like. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates aromatic and non-aromatic cyclic radicals. Hetero-aromatic cyclic radicals also means heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers, such as tetrahydrofuran, tetrahydropyran, and the like. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" as used herein contemplates single-ring hetero-aromatic groups that may include from one to five heteroatoms. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

The alkyl, cycloalkyl, alkenyl, alkynyl, aralkyl, heterocyclic group, aryl, and heteroaryl may be unsubstituted or may be substituted with one or more substituents selected from the group consisting of deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is monosubstituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, aza-dibenzothiophene, etc. means that one or more of the C-H groups in the respective fragment can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

According to an aspect, a compound having a formula M(L_{A})ₓ(L_{B})_{y}(L_{C})_{z} is disclosed. In the formula, the ligand L_{A} is 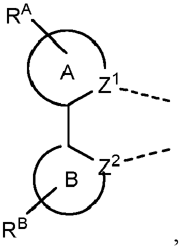 the ligand L_{B} is 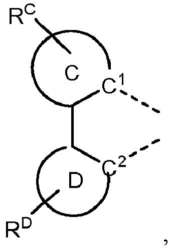 and the ligand L_{C} is 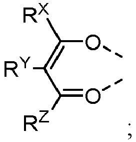
wherein M is a metal having an atomic number greater than 40;
wherein x is 0, 1, or 2;
wherein y is 1, 2, or 3;
wherein z is 0, 1, or 2;
wherein x+y+z is the oxidation state of the metal M;
wherein L_{A} is different from L_{B}, and when x, y, or z is larger than 1, each plurality of L_{A}, L_{B}, or L_{C} are also different;
wherein rings A, B, C, and D are each independently a 5 or 6-membered carbocyclic or heterocyclic ring;
wherein R^{A}, R^{B}, R^{C}, and R^{D} each independently represent mono substitution up to the maximum possible number of substitutions, or no substitution;
wherein Z¹ and Z² are each independently selected from the group consisting of carbon or nitrogen;
wherein C¹ is an anionic donor carbon atom, C² is a neutral carbene carbon atom;
wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any adjacent substituents are optionally joined or fused into a ring.

In some embodiments of the compound, M is selected from the group consisting of Ir, Rh, Re, Ru, Os, Pt, Au, and Cu. In some embodiments, M is Ir or Pt.

In some embodiments, Z¹ is a neutral donor nitrogen atom, Z² is an anionic donor carbon atom.

In some embodiments, rings A, B, and C are 6-membered aromatic rings, and ring D is a 5-member aromatic rings. In some embodiments, rings B and C are benzene.

In some embodiments, the compound is selected from the group consisting of: Ir(L_{A})(L_{B})(L_{C}), Ir(L_{A})(L_{B})₂, Ir(L_{A})₂(L_{B}), Pt(L_{A})(L_{B}), and Pt(L_{B})₂.

In some embodiments of the compound, the ligand L_{A} is selected from the group consisting of: 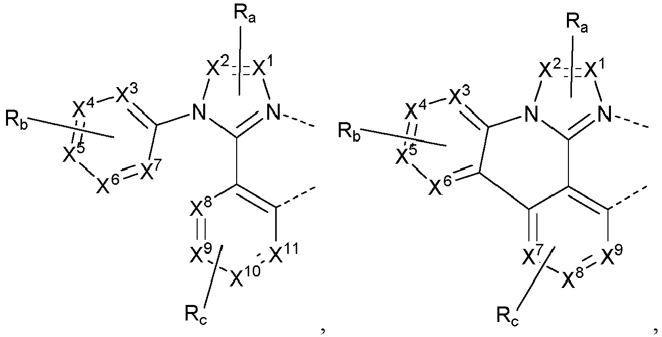 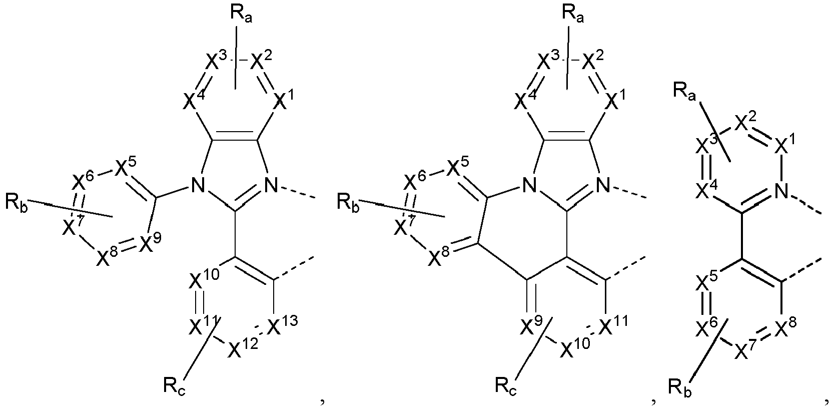 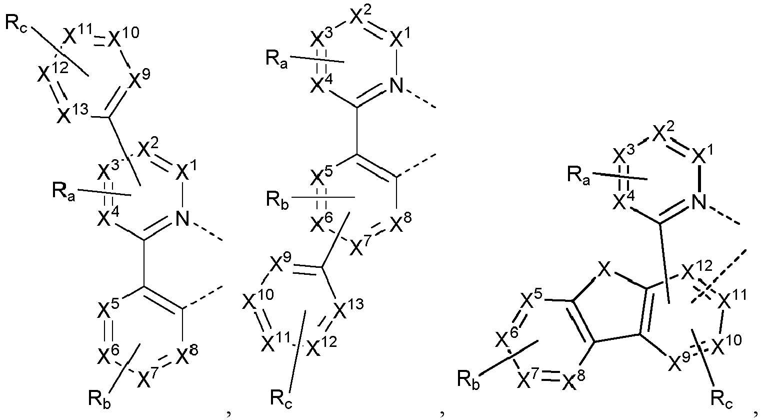 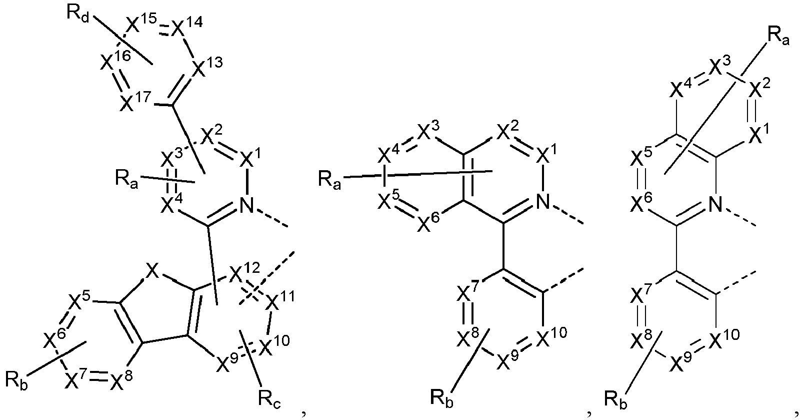 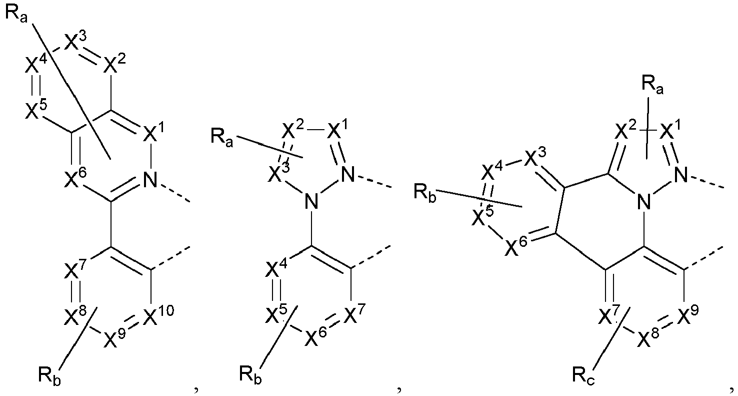 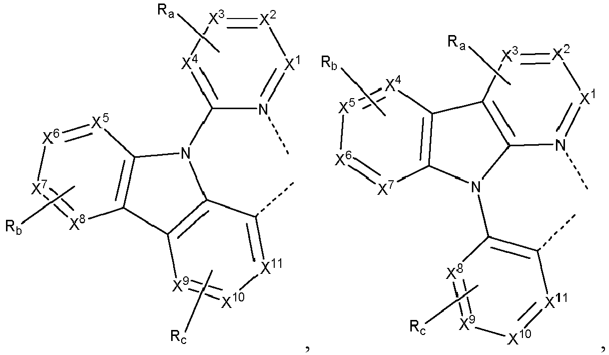 and 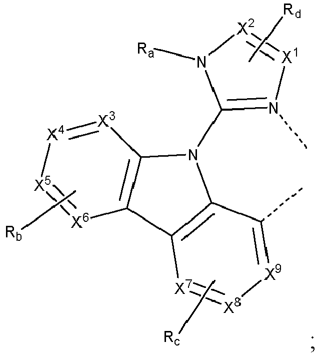
wherein each X¹ to X¹⁷ are independently selected from the group consisting of carbon and nitrogen;
wherein X is selected from the group consisting of BR', NR', PR', O, S, Se, C=O, S=O, SO₂, CR'R", SiR'R", and GeR'R";
wherein R' and R" are optionally fused or joined to form a ring;
wherein each Rₐ, R_{b}, R_{c}, and R_{d} may represent from mono substitution up to the maximum possible number of substitutions, or no substitution;
wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any two adjacent substituents of Rₐ, R_{b}, R_{c}, and R_{d} are optionally fused or joined to form a ring or form a multidentate ligand.

In some embodiments of the compound, the ligand L_{B} is selected from the group consisting of: 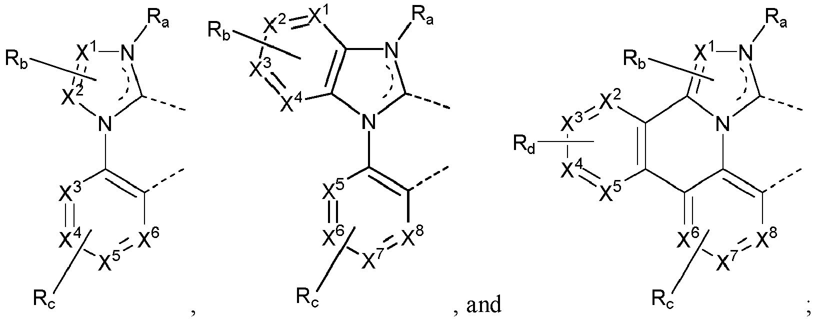
wherein each X¹ to X⁸ are independently selected from the group consisting of carbon and nitrogen;
wherein X is selected from the group consisting of BR', NR', PR', O, S, Se, C=O, S=O, SO₂, CR'R", SiR'R", and GeR'R";
wherein R' and R" are optionally fused or joined to form a ring;
wherein each Rₐ, R_{b}, R_{c}, and R_{d} may represent from mono substitution up to the maximum possible number of substitutions, or no substitution;
wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any two adjacent substituents of Rₐ, R_{b}, R_{c}, and R_{d} are optionally fused or joined to form a ring or form a multidentate ligand.

In some embodiments, the ligand Lc has the formula: 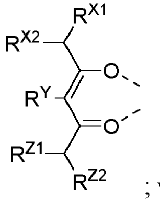 wherein R^{X1}, R^{X2}, R^{Z1}, and R^{Z2} are independently selected from group consisting of alkyl, cycloalkyl, aryl, and heteroaryl;
wherein at least one of R^{X1}, R^{X2}, R^{Z1}, and R^{Z2} has at least two carbon atoms.

In some embodiments, the ligand L_{A} is selected from the group consisting of: 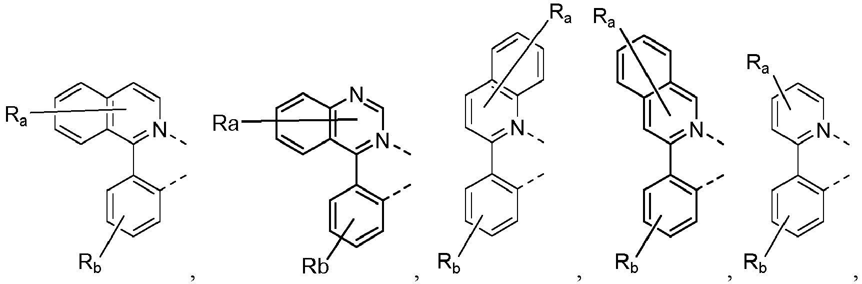 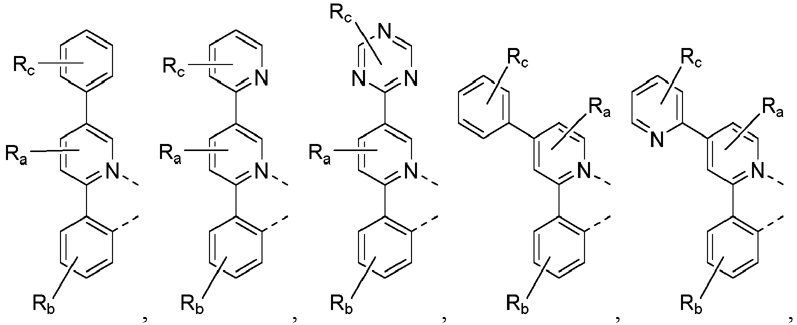 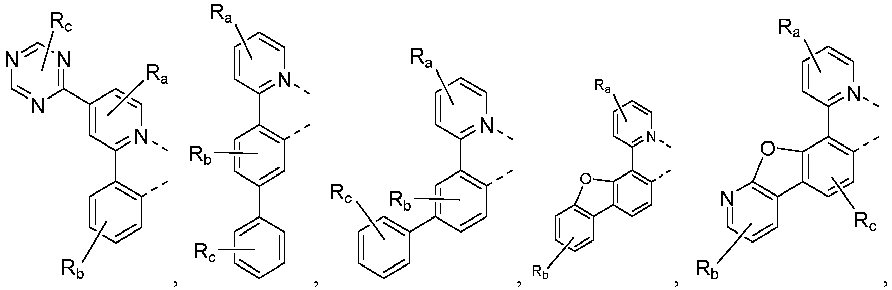 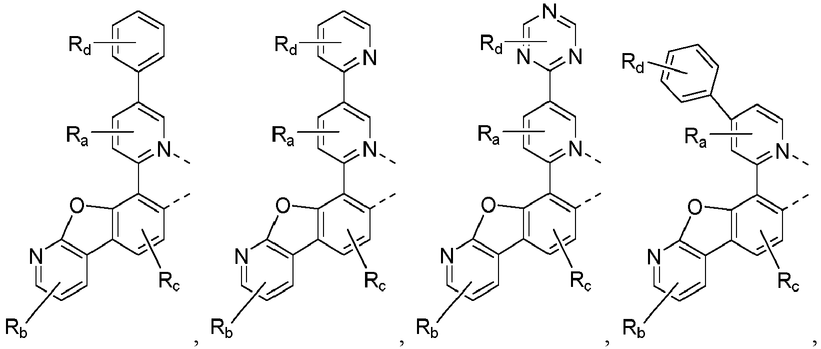 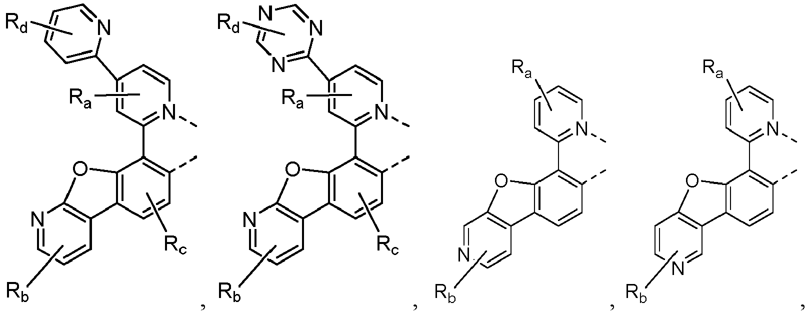 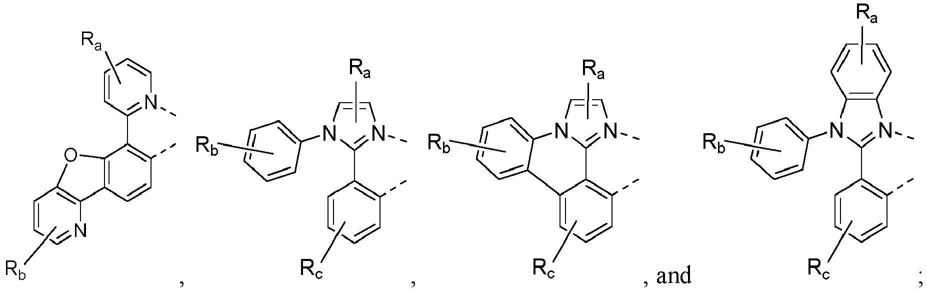
wherein each Rₐ, R_{b}, R_{c}, and R_{d} may represent from mono substitution up to the maximum possible number of substitutions, or no substitution;
wherein Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any two adjacent substituents of Rₐ, R_{b}, R_{c}, and R_{d} are optionally fused or joined to form a ring or form a multidentate ligand.

In some embodiments, the ligand L_{A} is selected from the group consisting of:

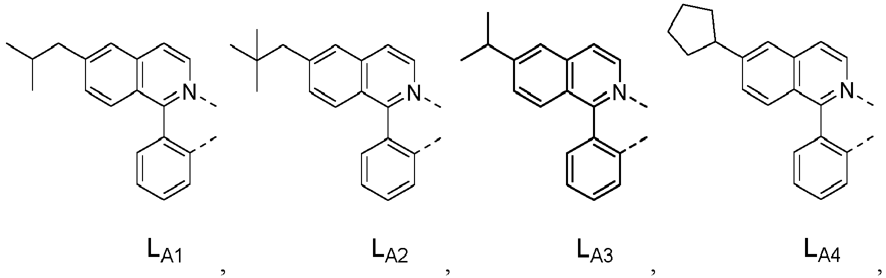

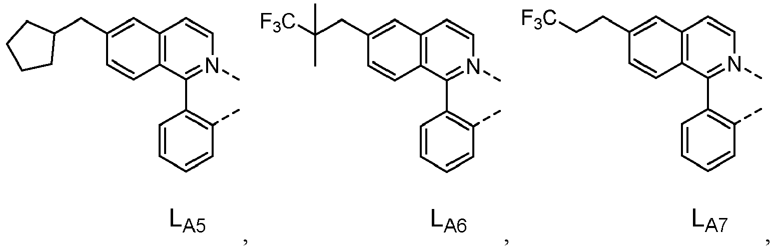

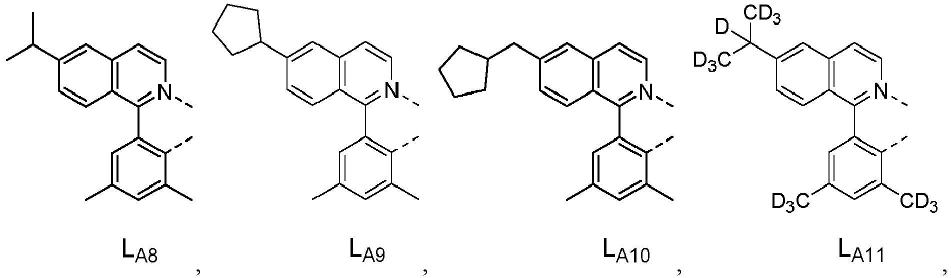

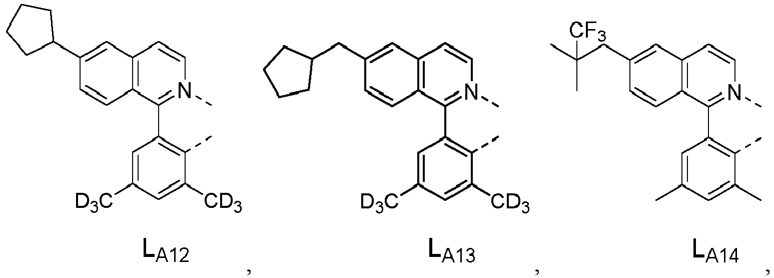

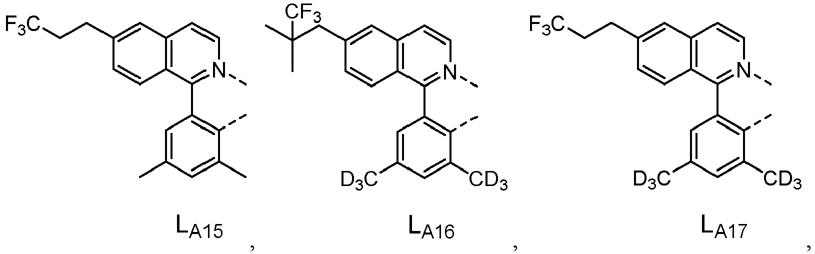

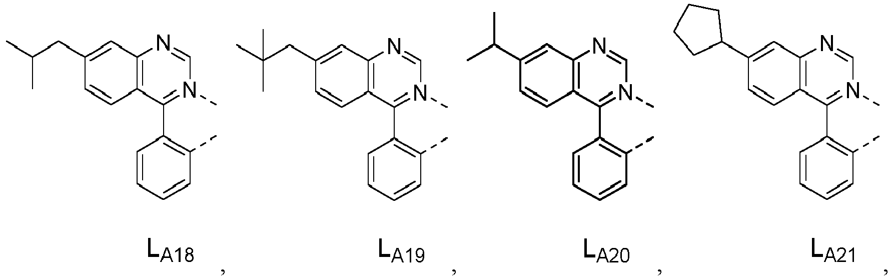

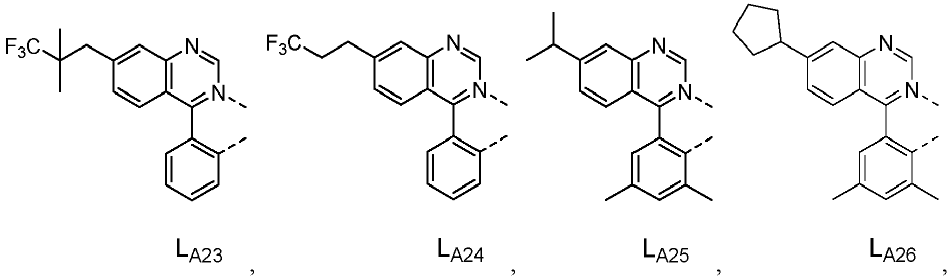

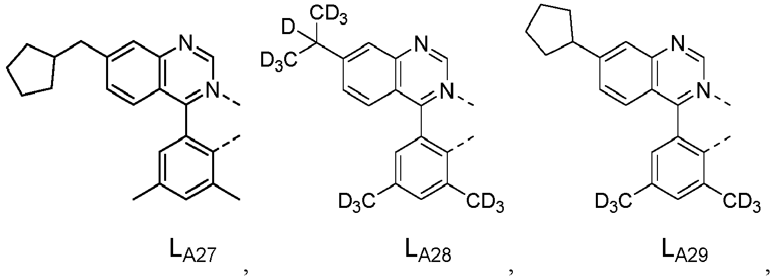

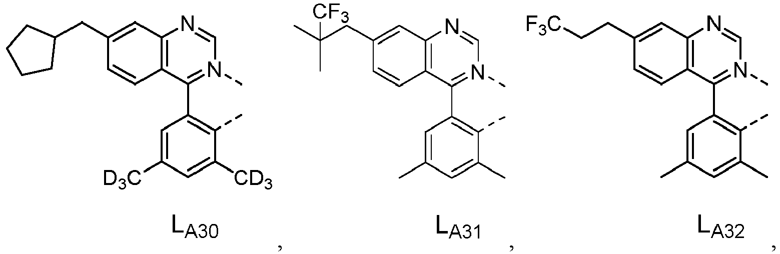

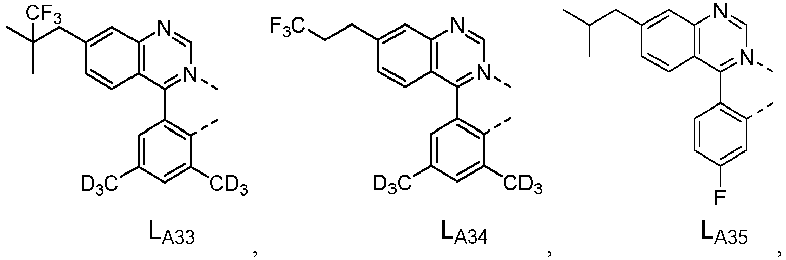

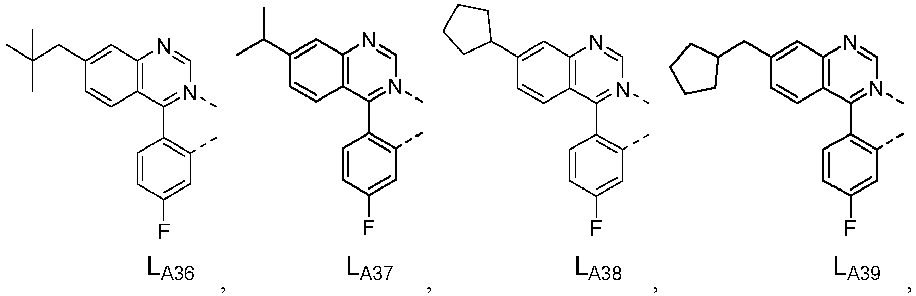

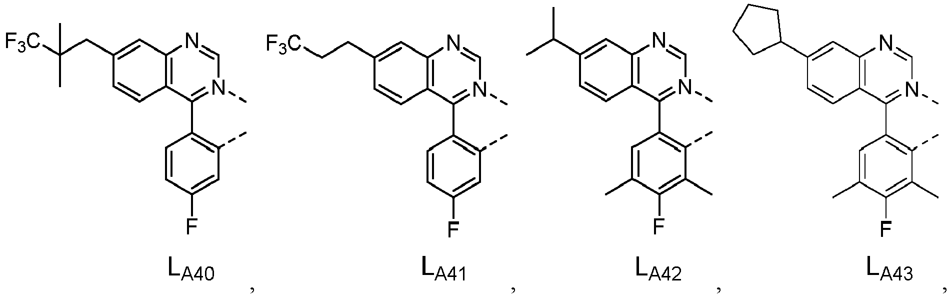

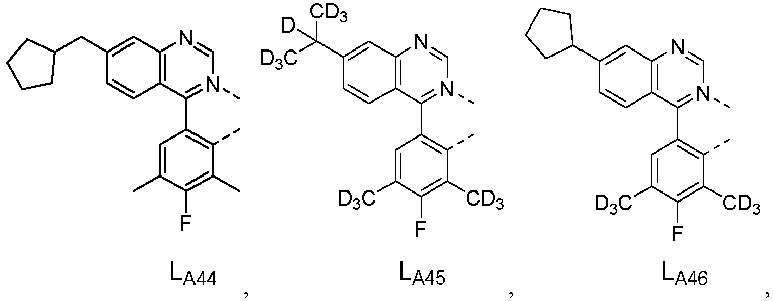

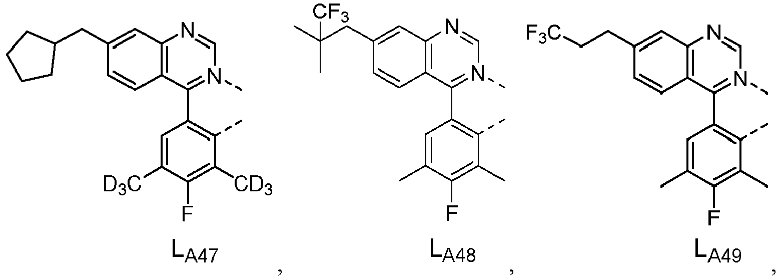

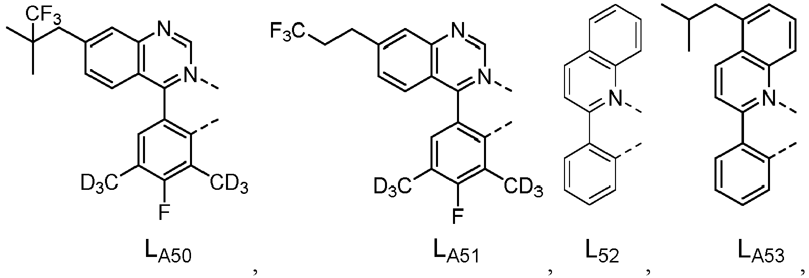

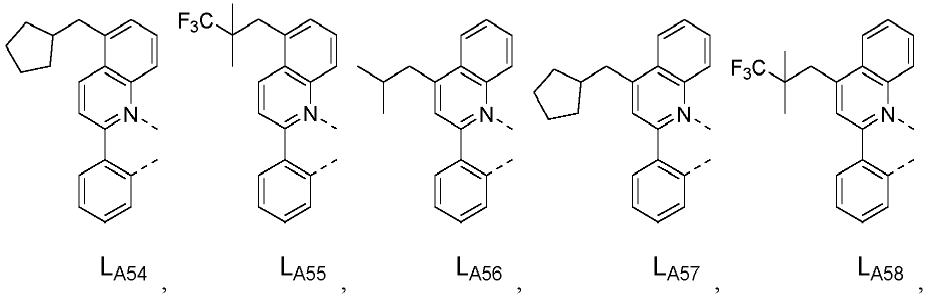

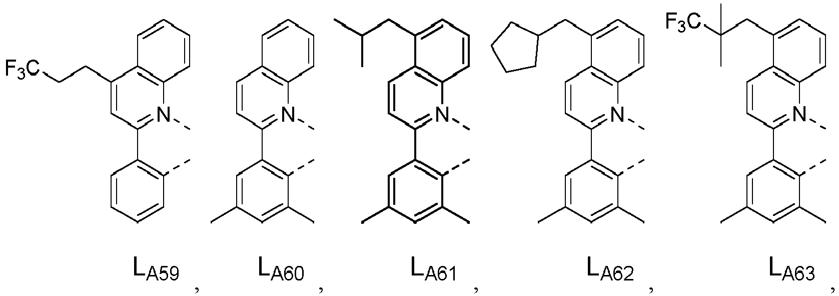

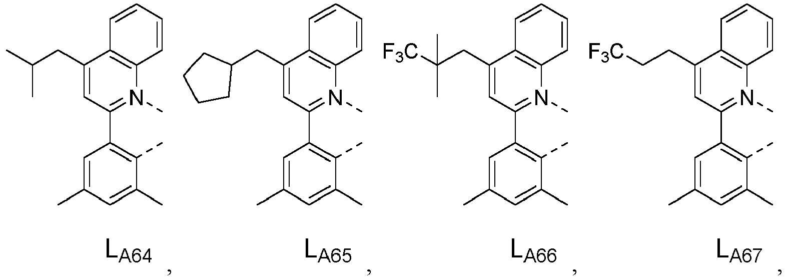

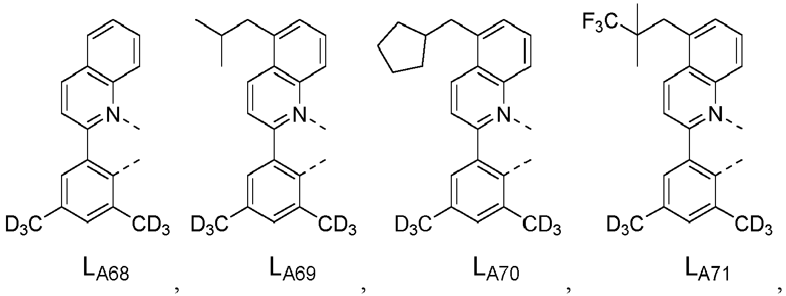

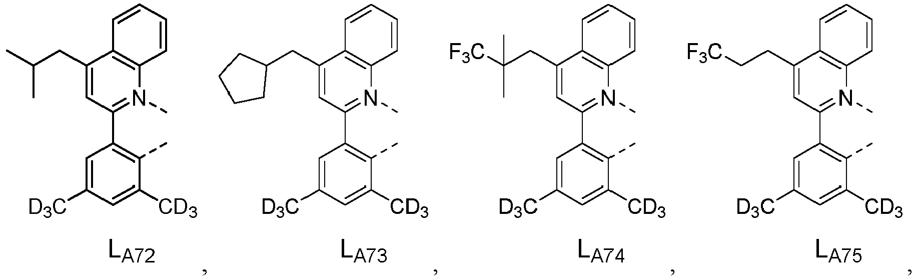

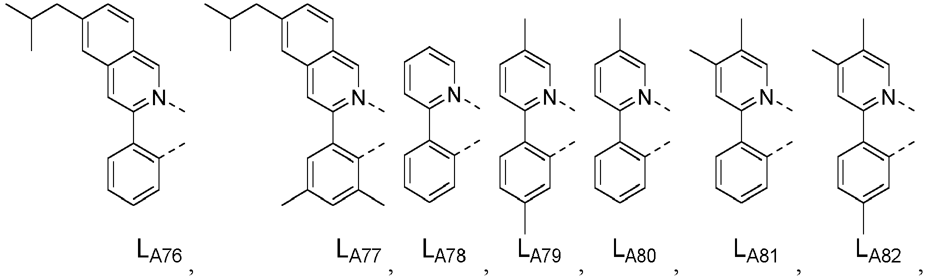

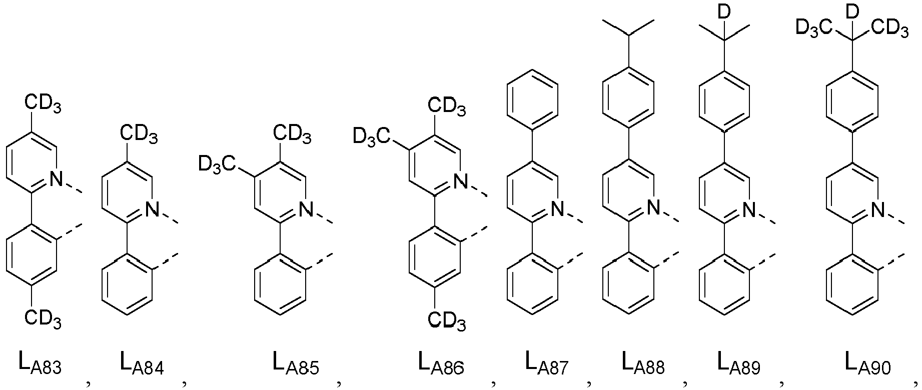

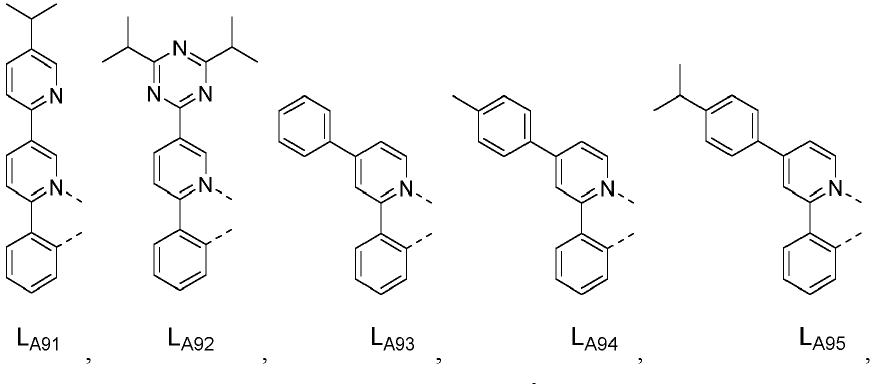

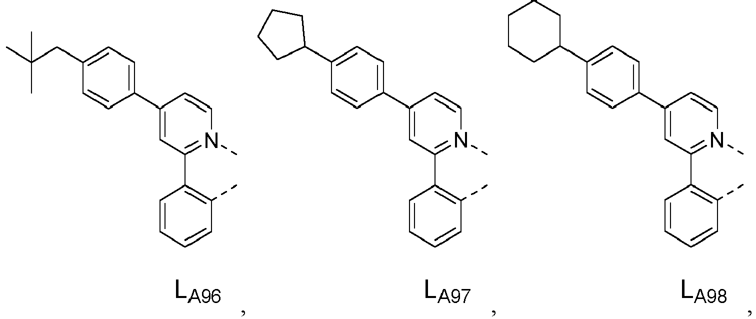

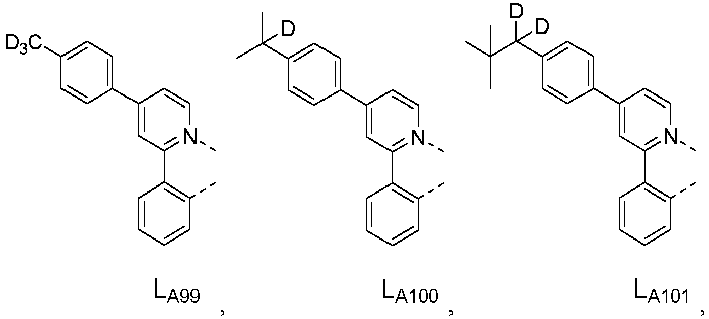

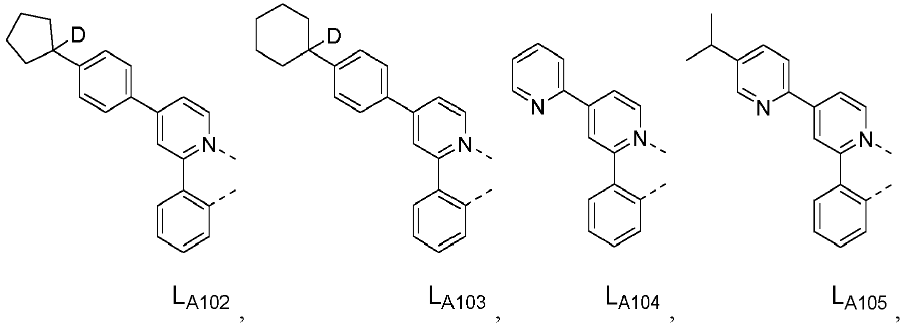

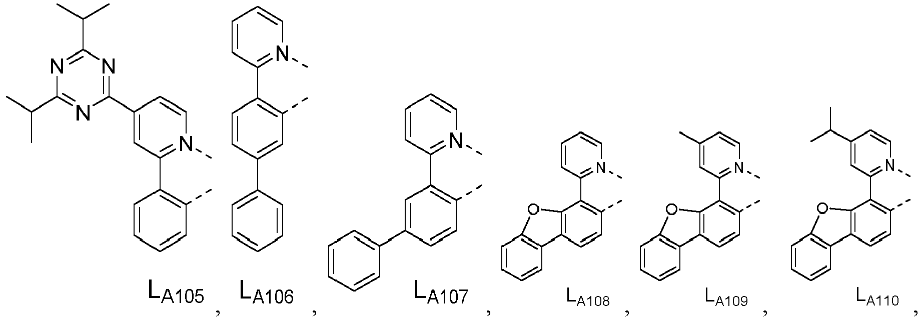

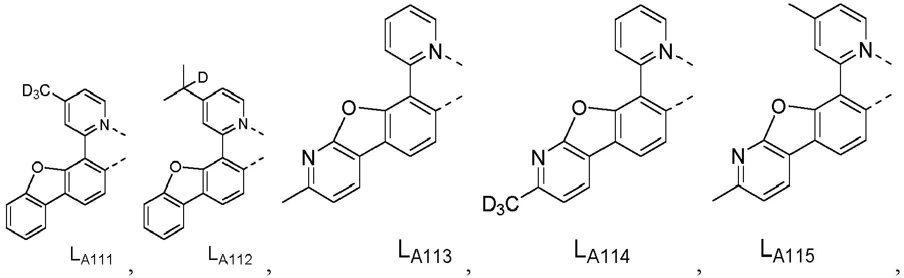

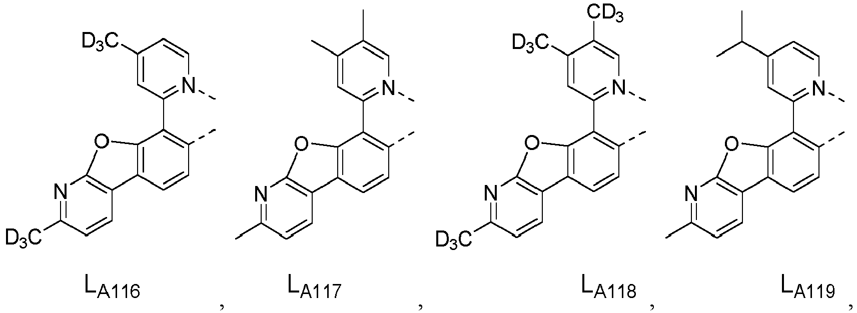

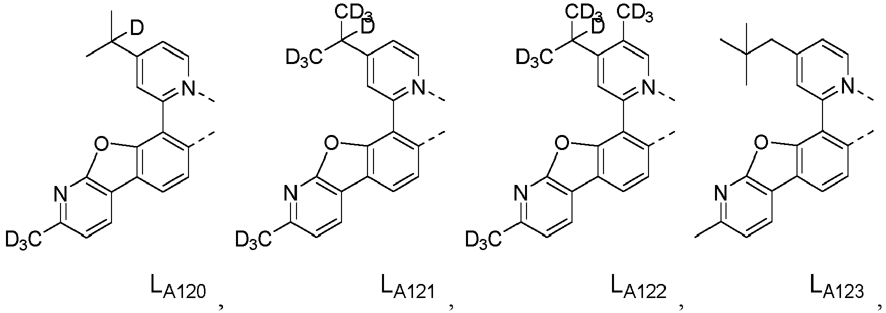

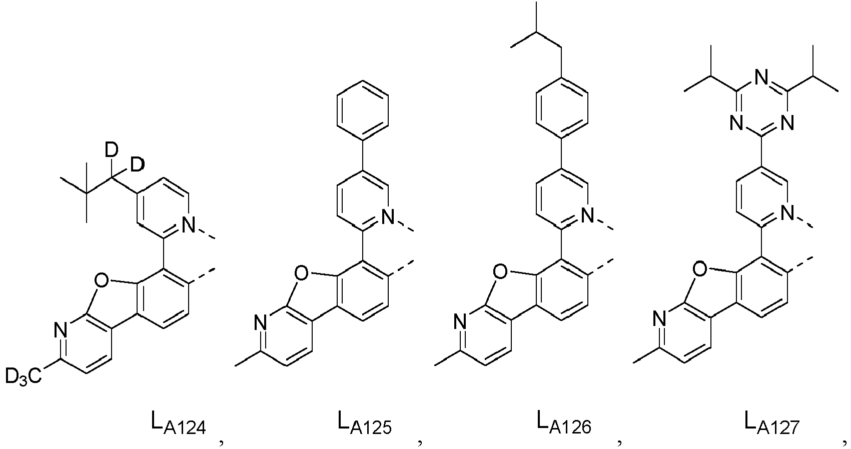

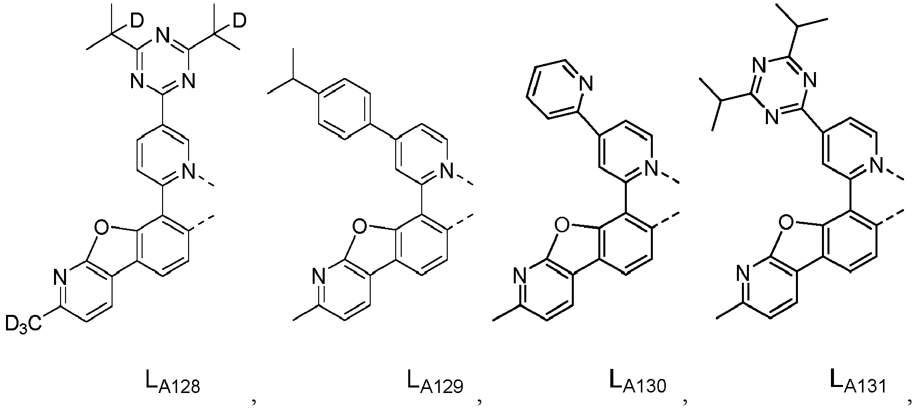

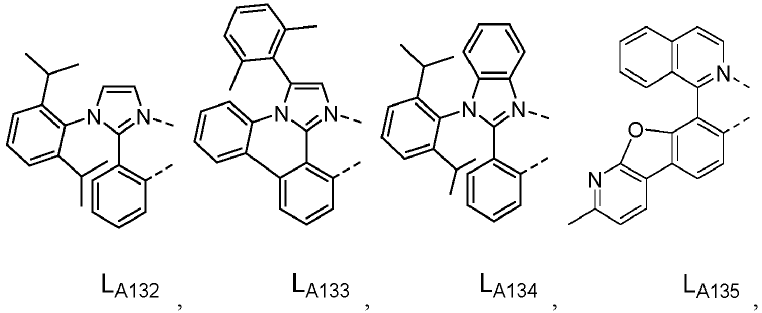

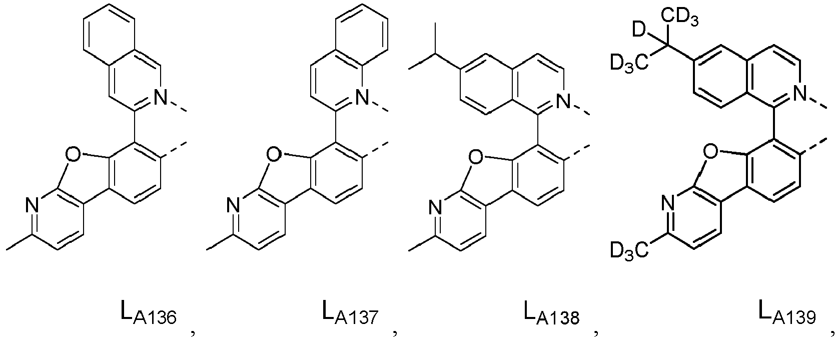

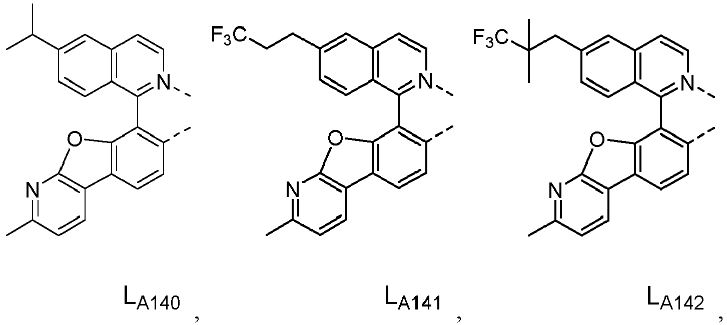

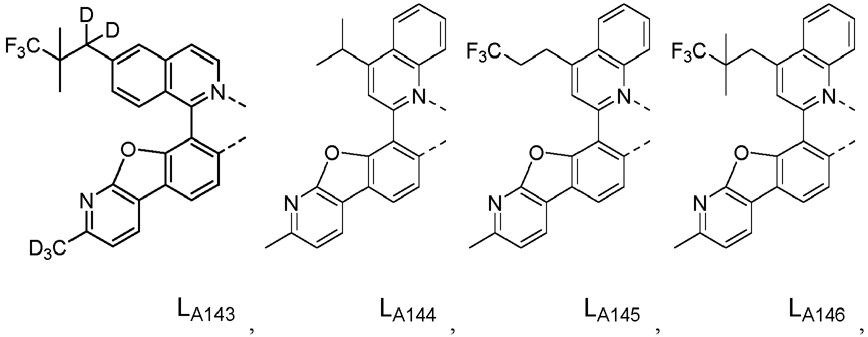

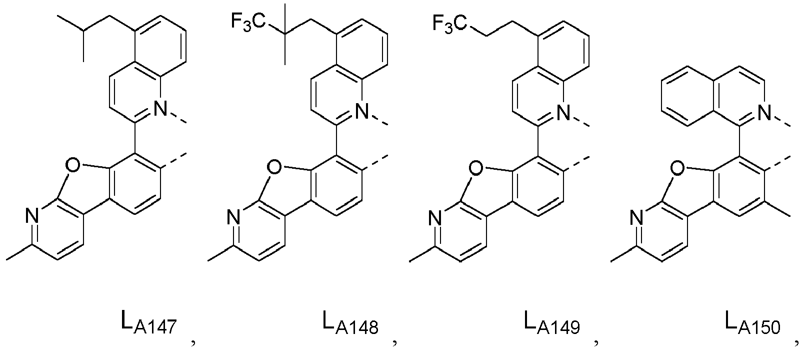

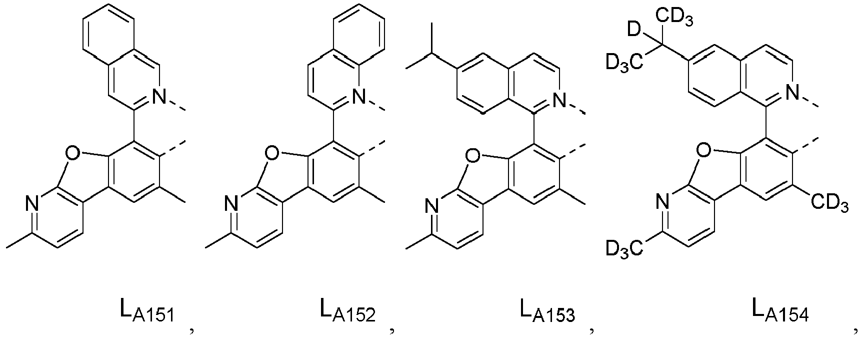

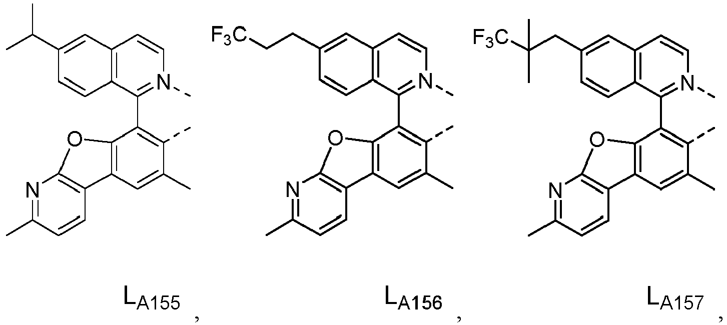

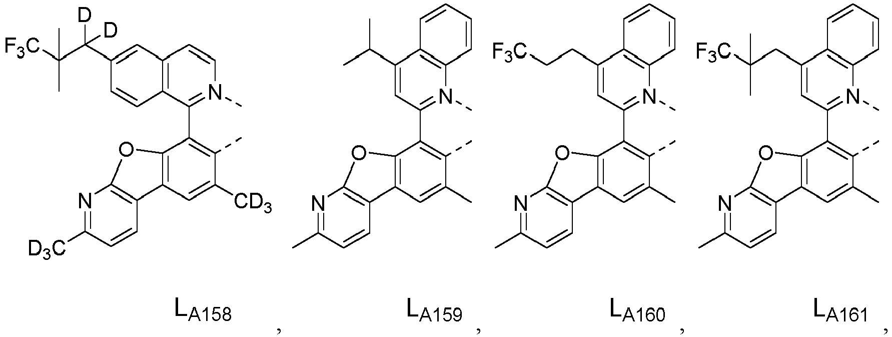

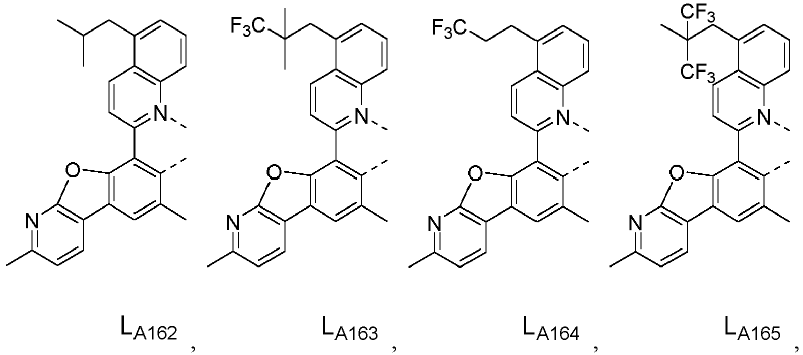

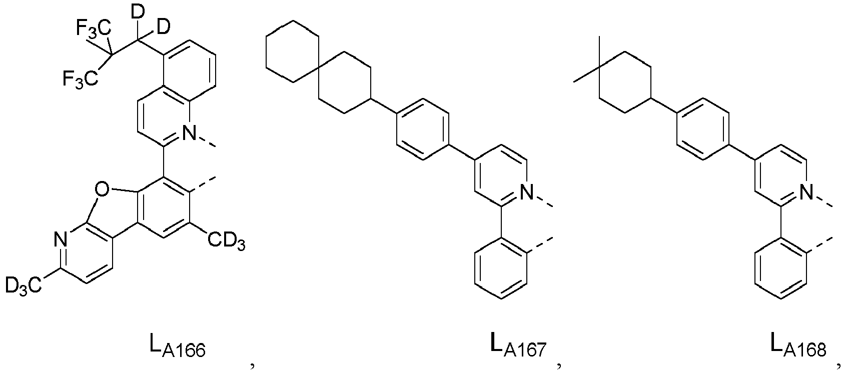

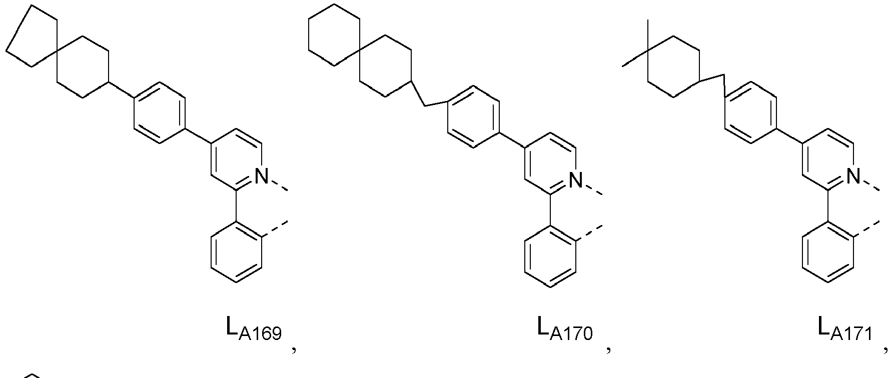

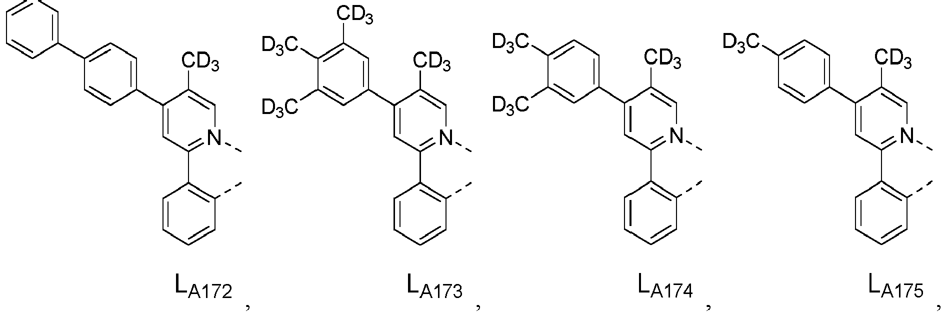

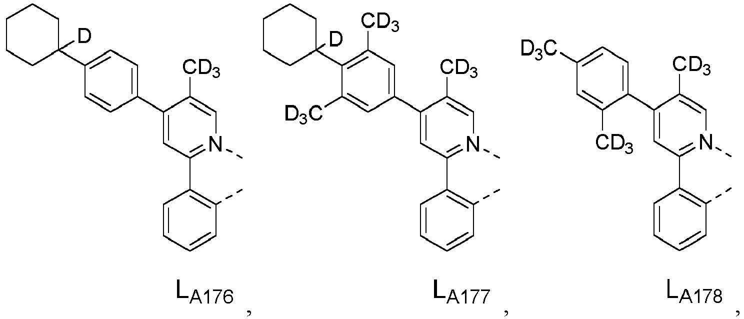

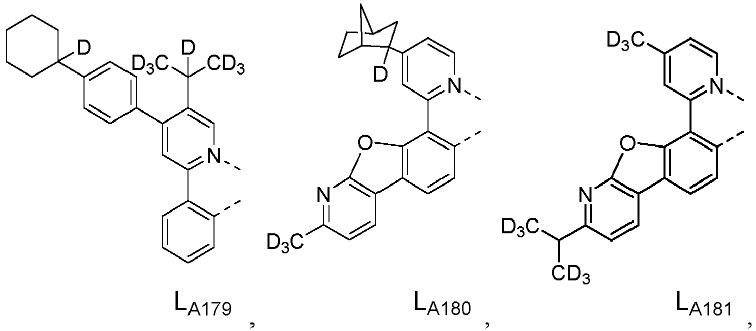

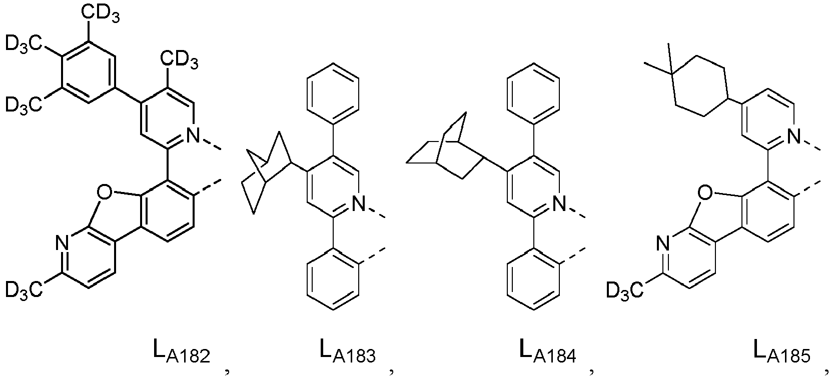

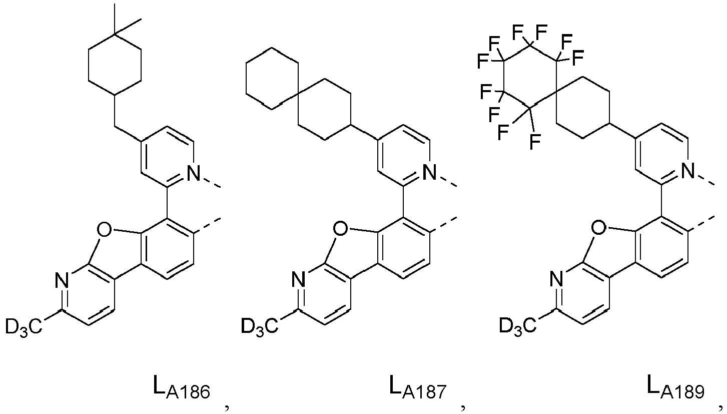

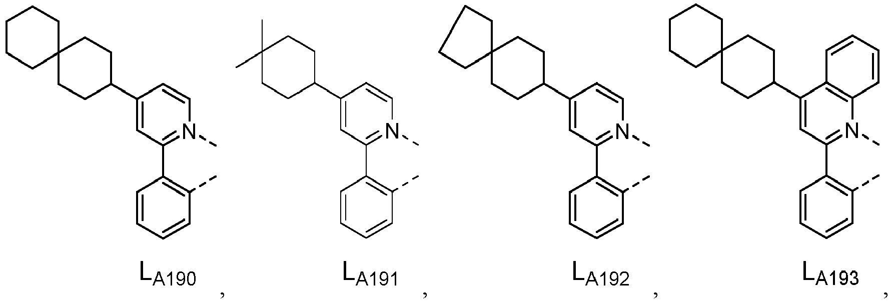

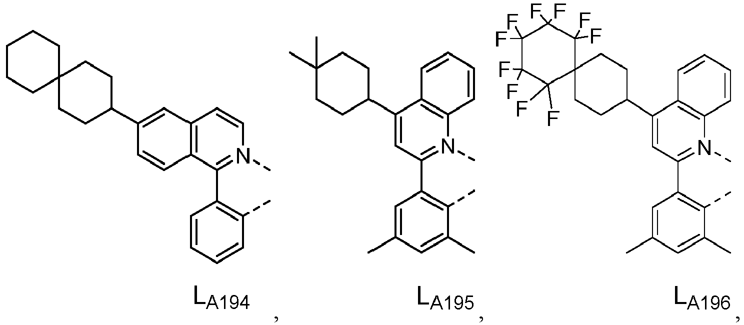

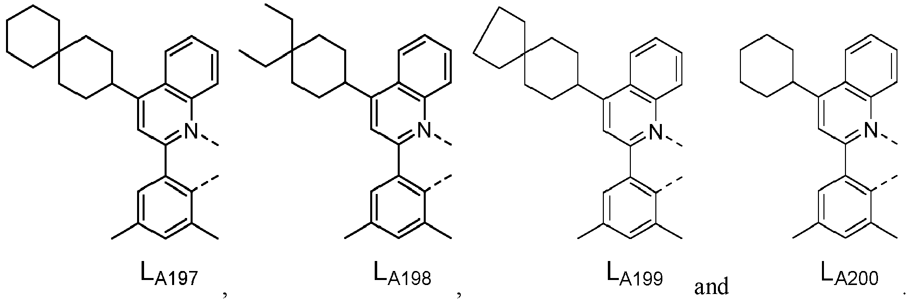

In some embodiments, the ligand L_{B} is selected from the group consisting of: 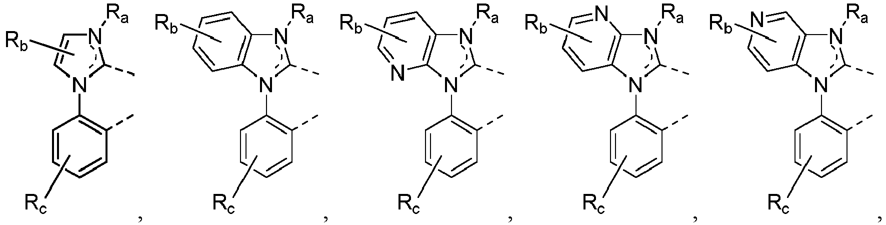 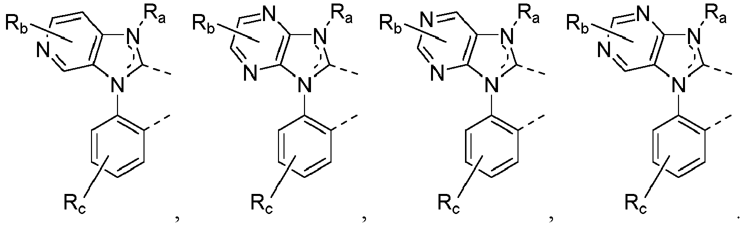 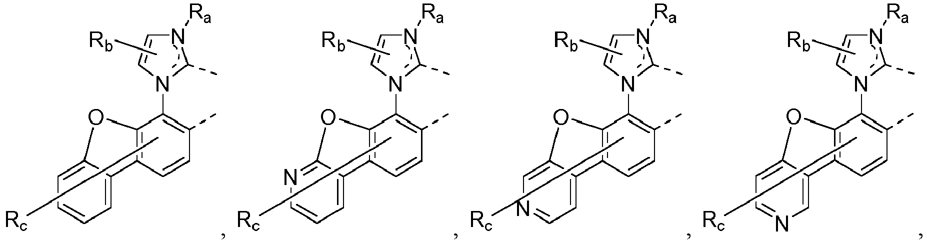 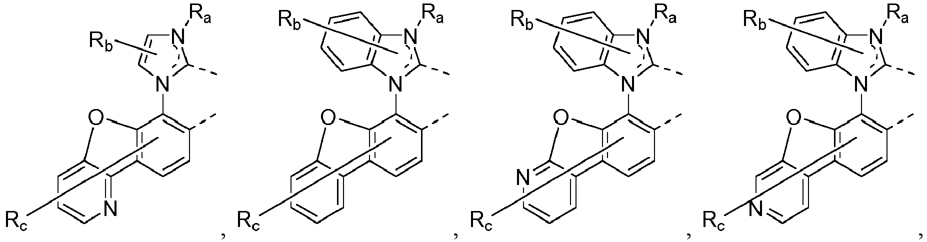 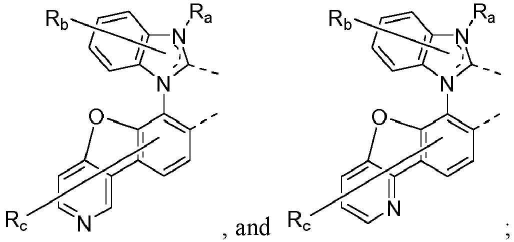
wherein each Rₐ, R_{b}, R_{c}, and R_{d} may represent from mono substitution up to the maximum possible number of substitutions, or no substitution;
wherein Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any two adjacent substituents of Rₐ, R_{b}, R_{c}, and R_{d} are optionally fused or joined to form a ring or form a multidentate ligand.

In some embodiments, the ligand L_{B} is selected from the group consisting of:

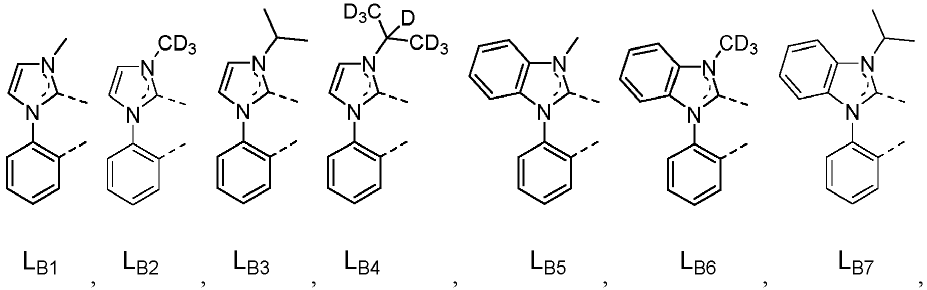

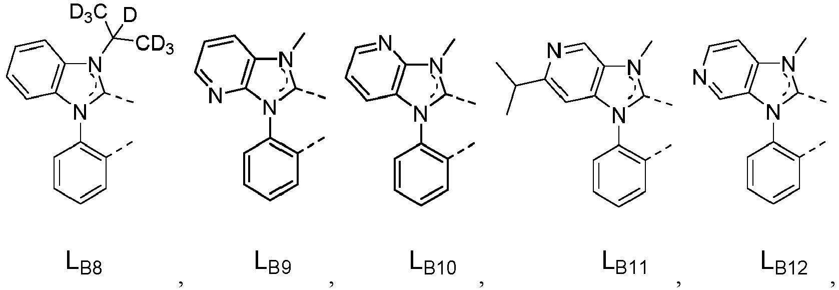

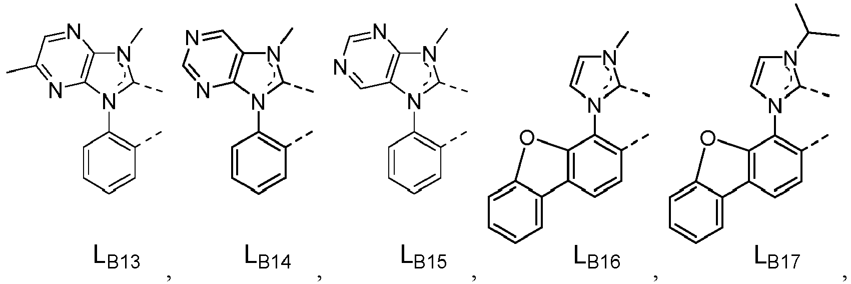

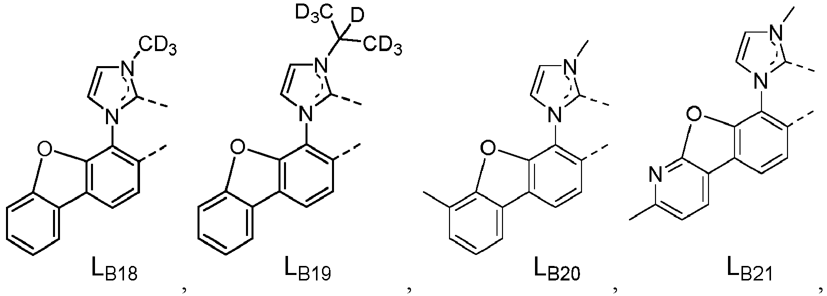

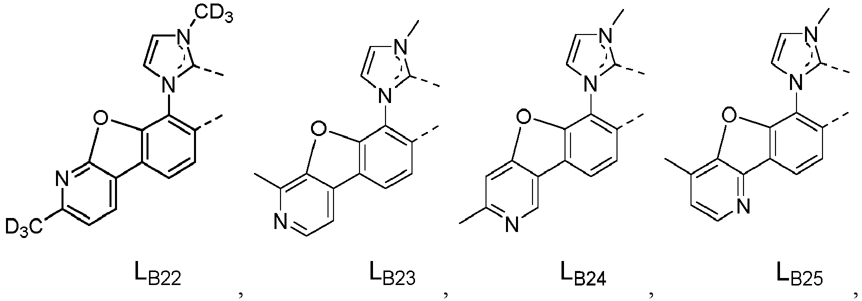

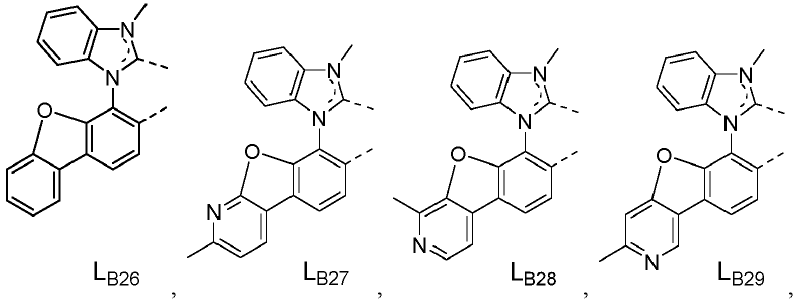

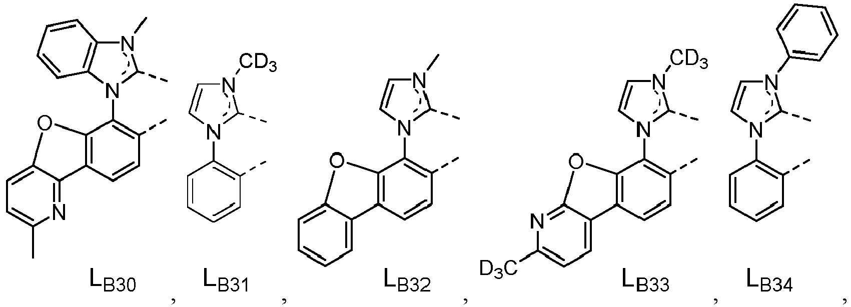

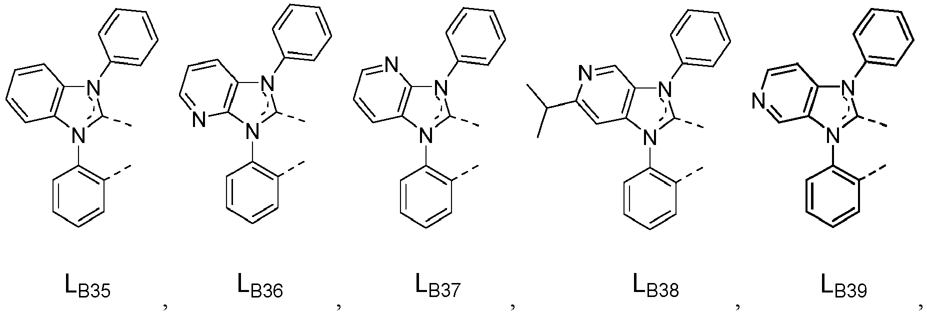

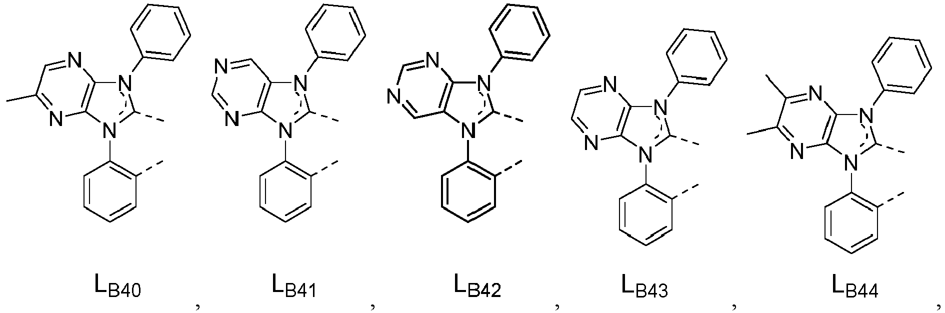

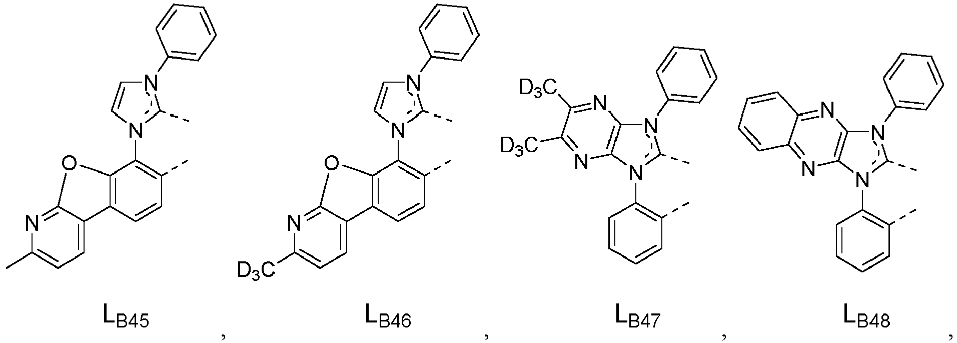

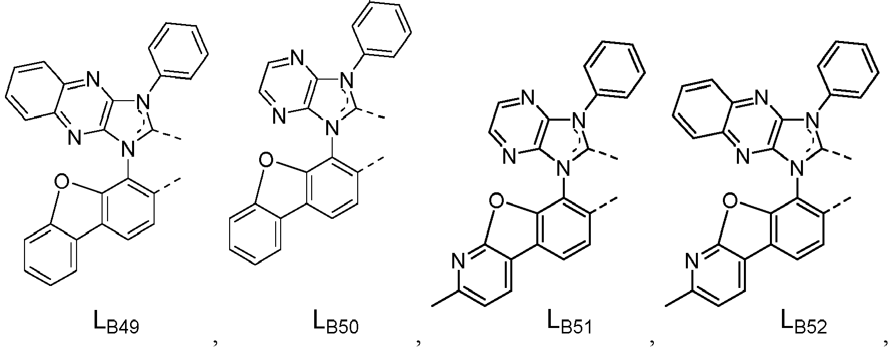

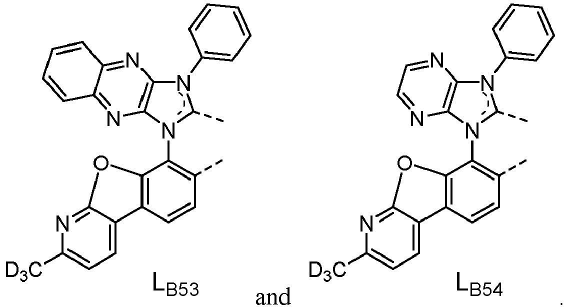

In some embodiments, the ligand Lc is selected from the group consisting of:

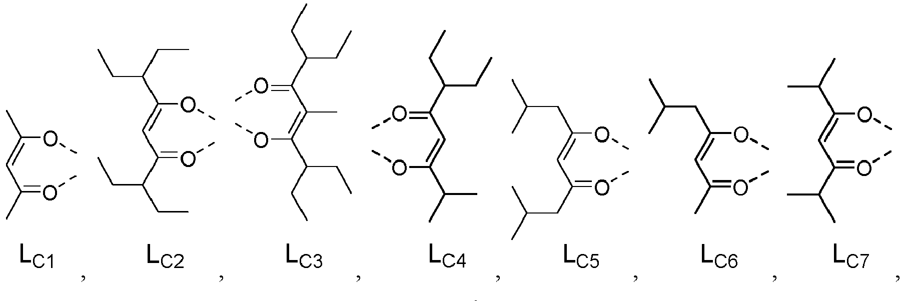

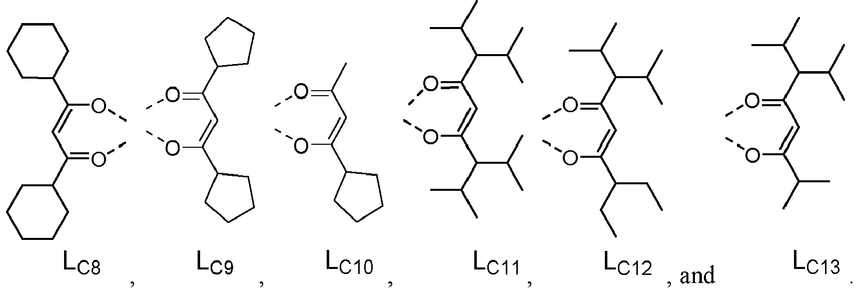

In embodiments where the ligand L_{A} is selected from the group consisting of L_{A1} through L_{A200}, the compound is selected from the group consisting of Compound A-1 through Compound A-140,400;
where each Compound A-*x* has the formula Ir(L_{A*i*})(L_{B*j*})(L_{C*k*});
wherein x = 10,800(*k*-1)+200(*j*-1)+*i* , *i* is an integer from 1 to 200, *j* is an integer from 1 to 54; and *k* is an integer from 1 to 13;
wherein L_{B*j*} has the following structure: 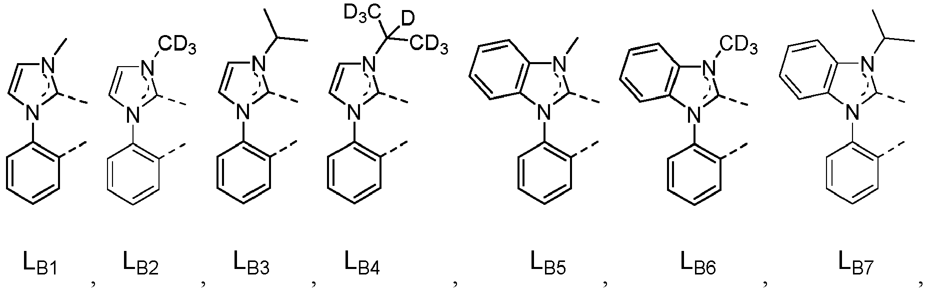 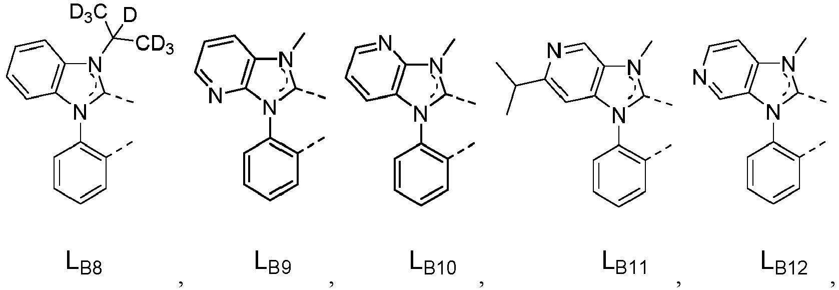 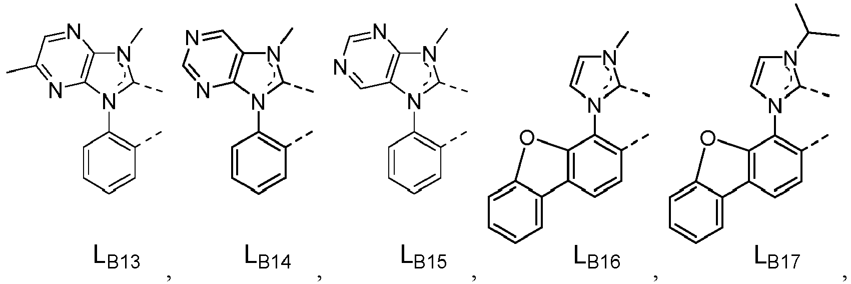 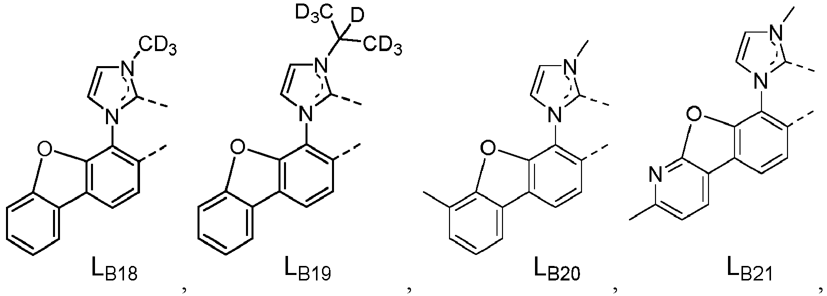 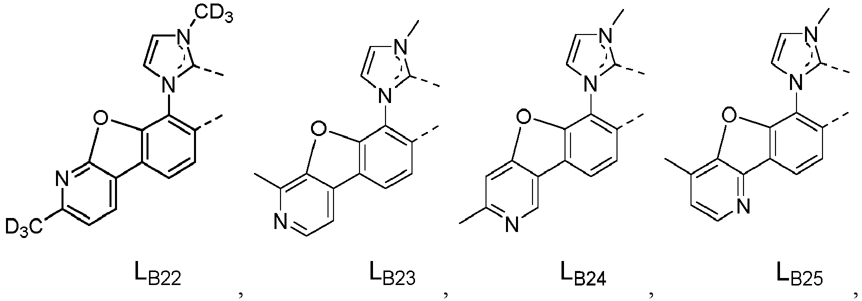 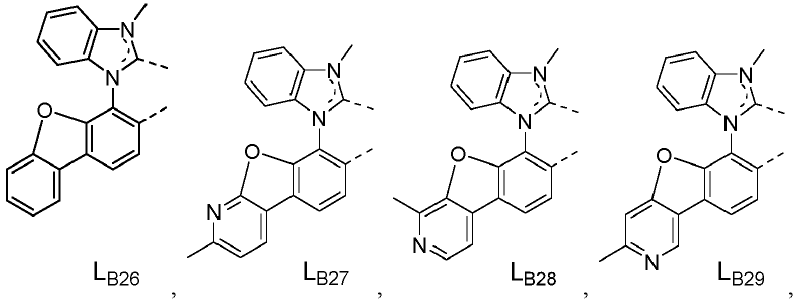 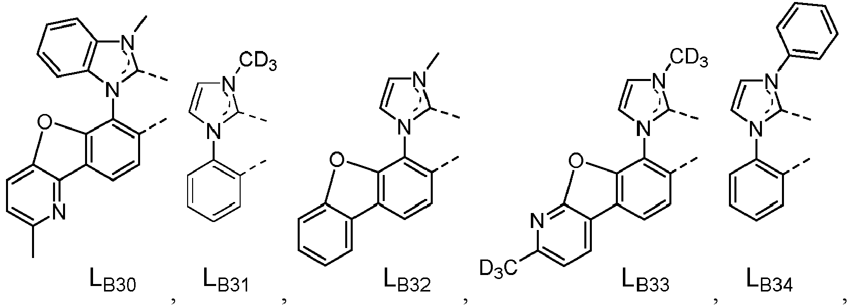 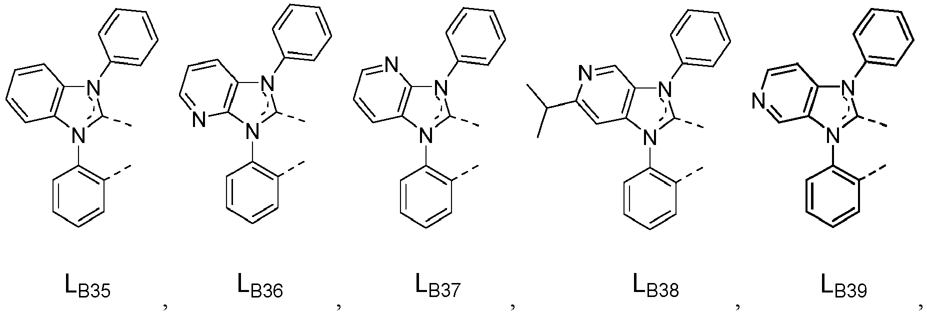 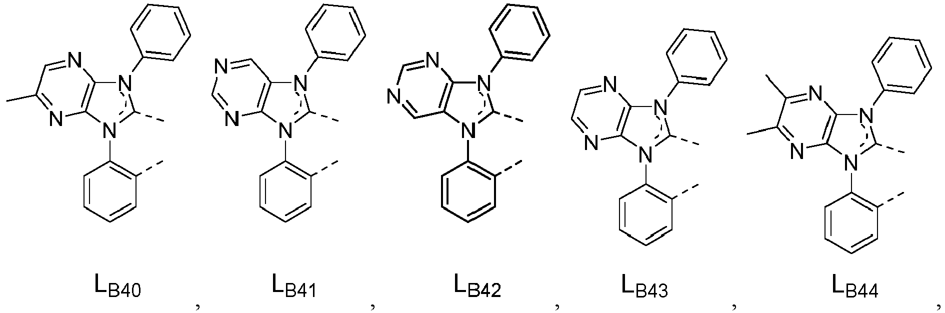 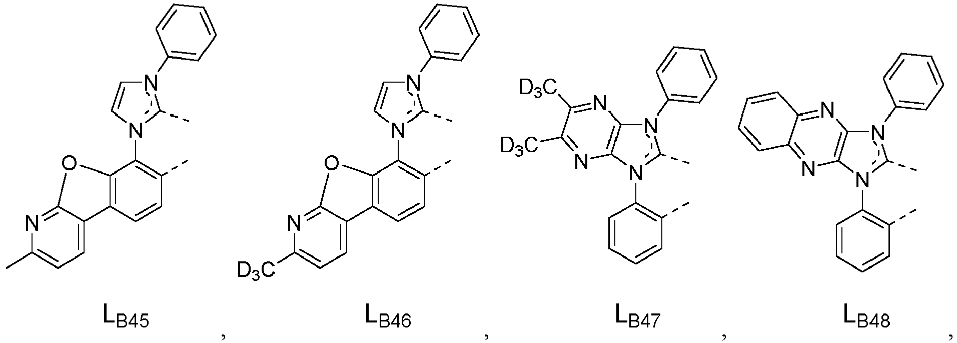 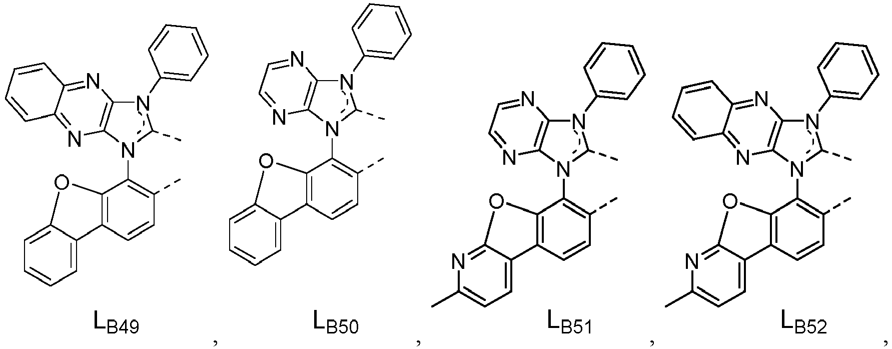 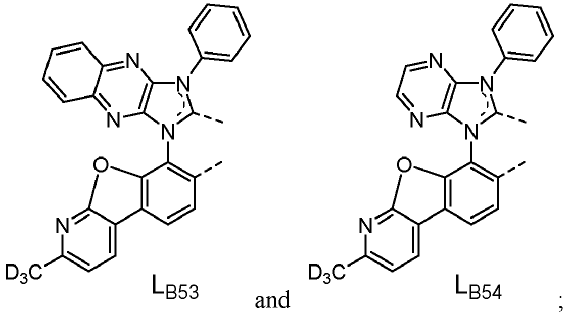
wherein L_{C*k*} has the following structure:

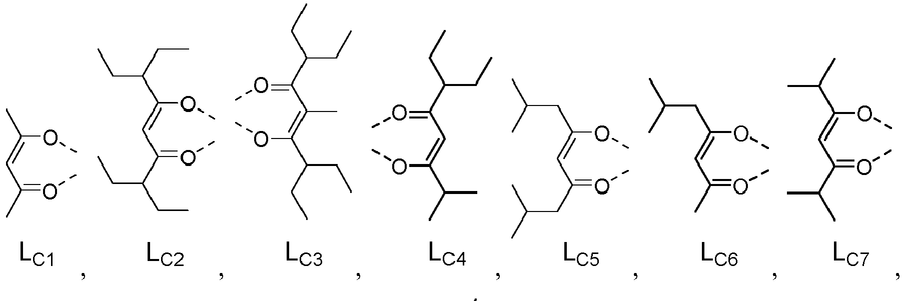

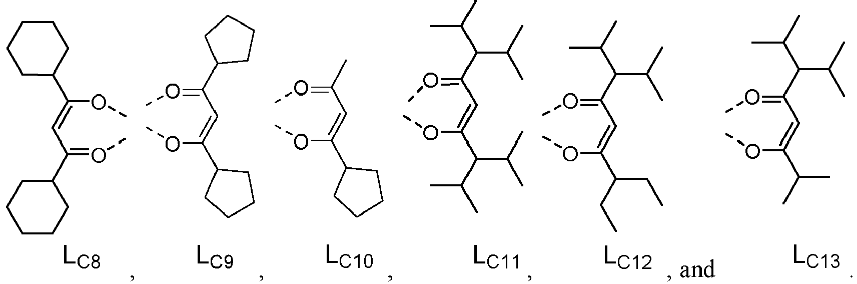

In embodiments where the ligand L_{A} is selected from the group consisting of L_{A1} through L_{A200}, the compound has the formula Ir(L_{A*i*})(L_{B*j*})(L_{B*j'*}), where *j* is not equal to *j*';
wherein *i* is an integer from 1 to 200, *j* is an integer from 1 to 54; and *j*' is an integer from 1 to 54;
wherein L_{B*j*} has the following structure:

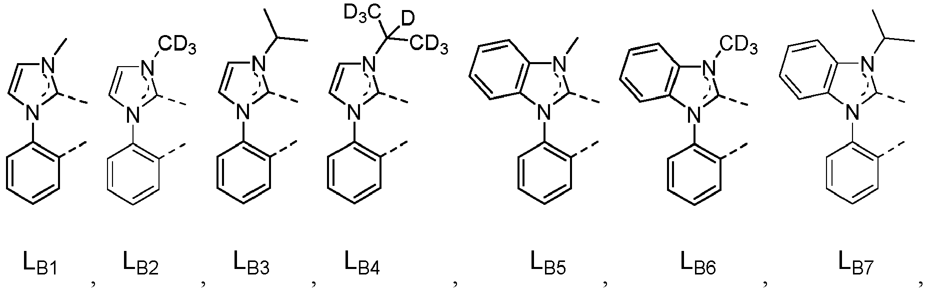

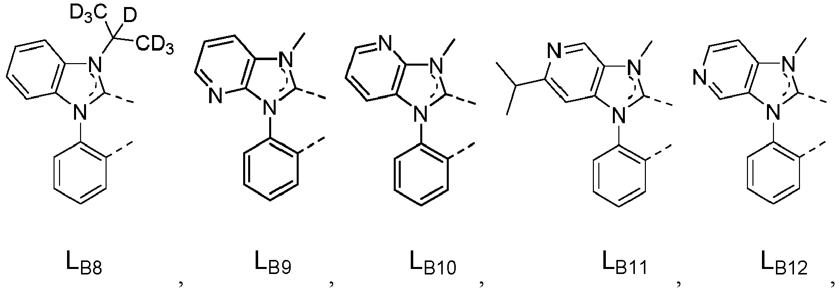

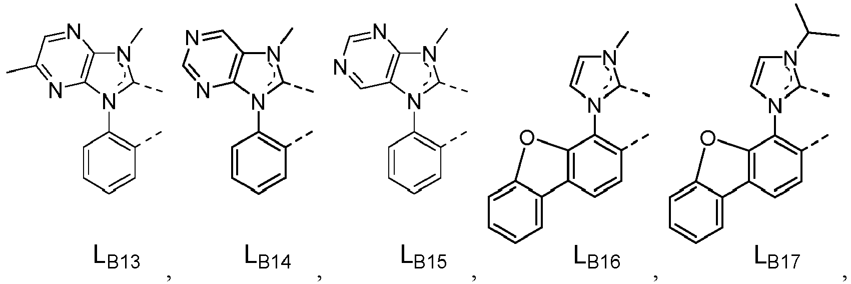

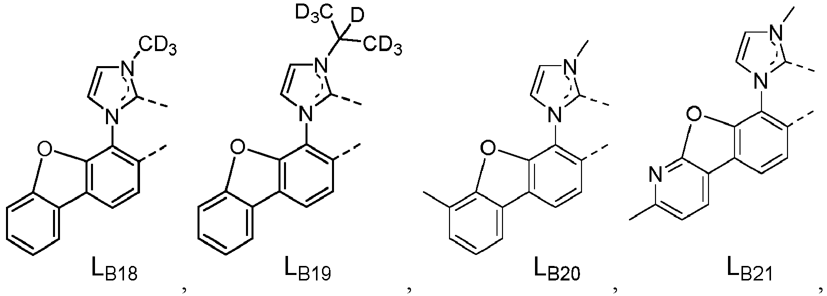

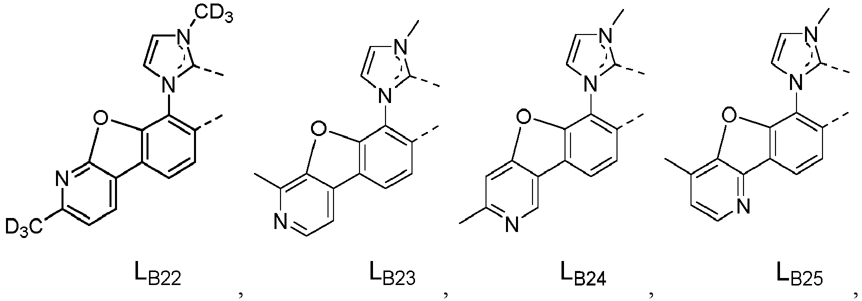

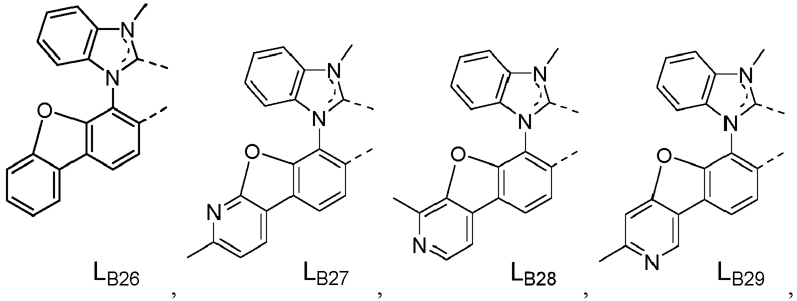

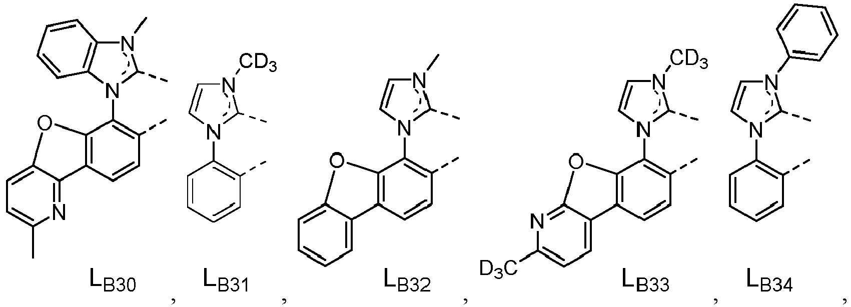

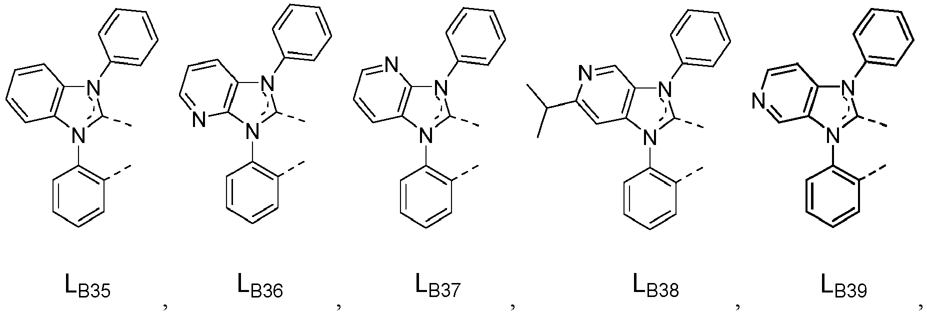

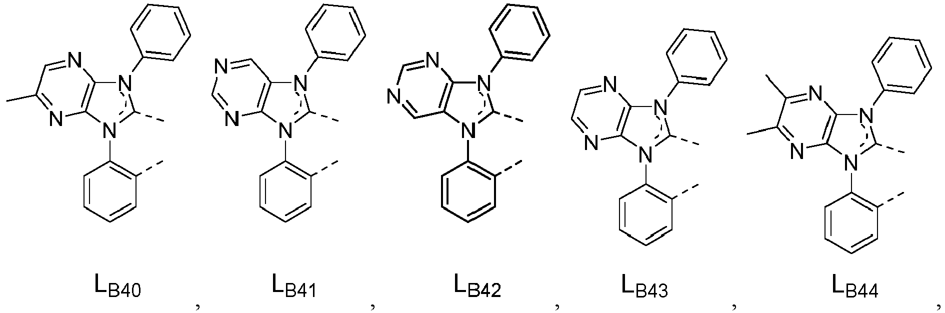

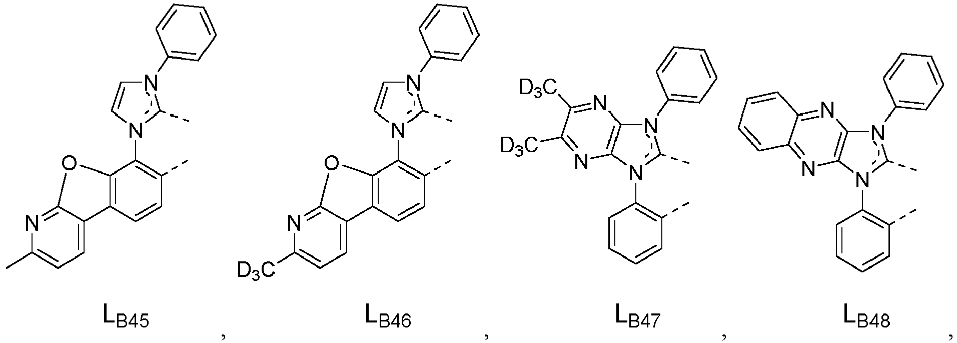

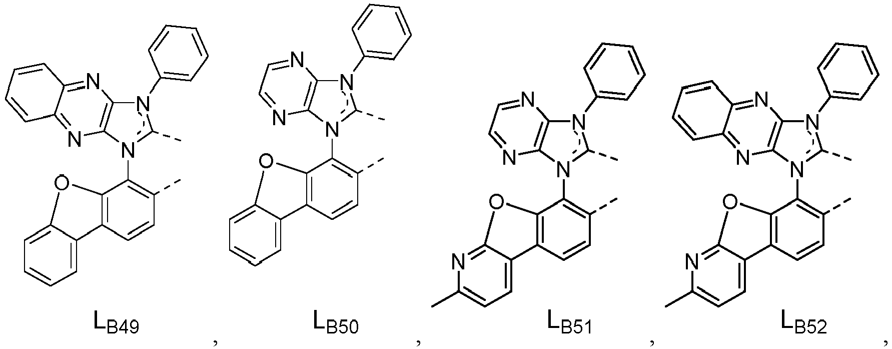

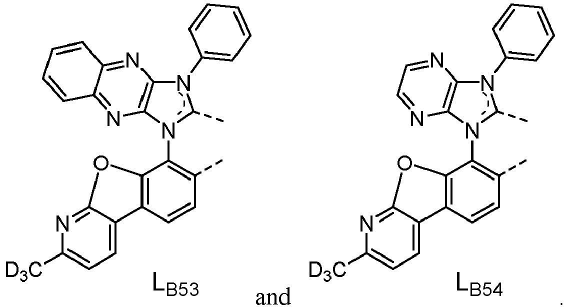

In embodiments where the ligand L_{B} is selected from the group consisting of L_{B1} to L_{B54}, the compound has the formula Ir(L_{B*j*})(L_{B*j*'})(L_{B*j"*});
wherein each of *j, j',* and *j*" is an integer from 1 to 54; and
wherein *j*, *j',* and *j*" are different.

According to another aspect of the present disclosure, an OLED is disclosed, the OLED comprises: an anode; a cathode; and an organic layer, disposed between the anode and the cathode, comprising a compound having the formula M(L_{A})ₓ(L_{B})_{y}(L_{C})_{z}:
wherein the ligand L_{A} is 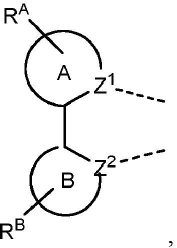 the ligand L_{B} is 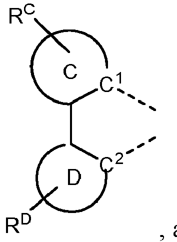 and the ligand L_{C} is 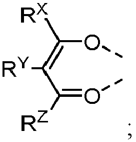
wherein M is a metal having an atomic number greater than 40;
wherein x is 0, 1, or 2;
wherein y is 1, 2, or 3;
wherein z is 0, 1, or 2;
wherein x+y+z is the oxidation state of the metal M;
wherein L_{A} is different from L_{B}, and when x, y, or z is larger than 1, each plurality of L_{A}, L_{B}, or L_{C} are also different;
wherein rings A, B, C, and D are each independently a 5 or 6-membered carbocyclic or heterocyclic ring;
wherein R^{A}, R^{B}, R^{C}, and R^{D} each independently represent mono substitution up to the maximum possible number of substitutions, or no substitution;
wherein Z¹ and Z² are each independently selected from the group consisting of carbon or nitrogen;
wherein C¹ is an anionic donor carbon atom, C² is a neutral carbene carbon atom;
wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any adjacent substituents are optionally joined or fused into a ring.

In some embodiments of the OLED, the organic layer further comprises a host, wherein the host comprises a triphenylene containing benzo-fused thiophene or benzo-fused furan;
wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, and CₙH₂ₙ-Ar₁, or the host has no substitutions;
wherein n is from 1 to 10; and
wherein Ar₁ and Ar₂ are independently selected from the group consisting of benzene, biphenyl, naphthalene, triphenylene, carbazole, and heteroaromatic analogs thereof.

In some embodiments of the OLED, the organic layer further comprises a host, wherein host comprises at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene.

In some embodiments of the OLED, the organic layer further comprises a host, wherein the host is selected from the group consisting of: 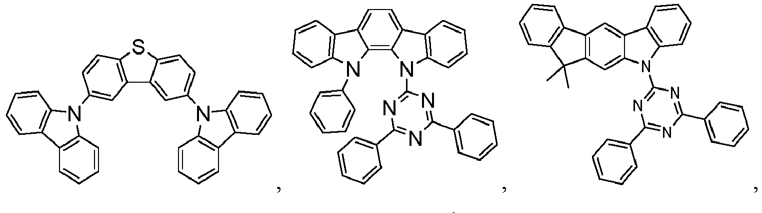 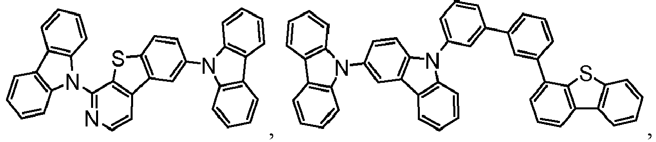 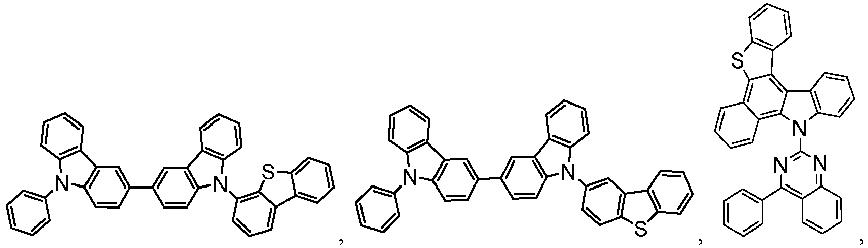 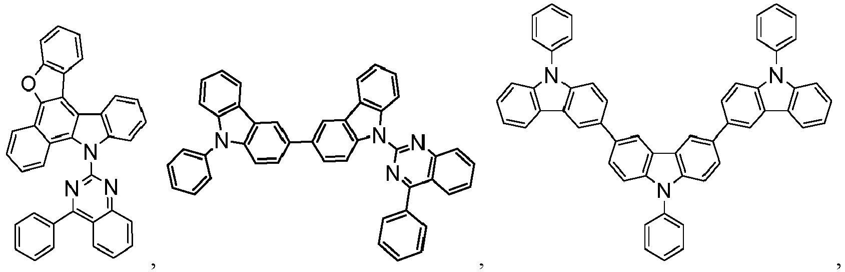 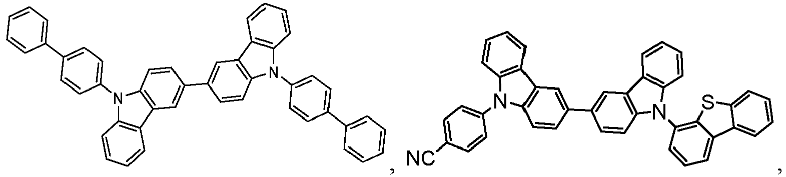 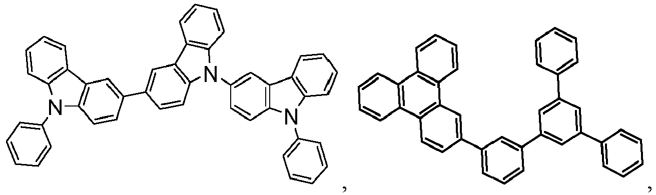 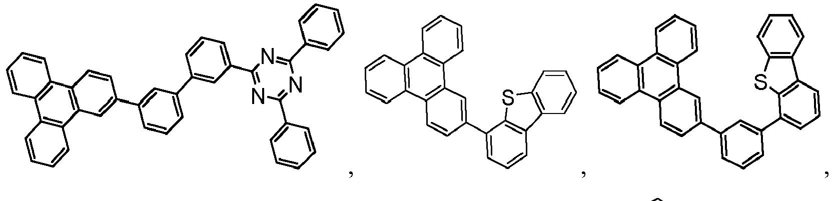 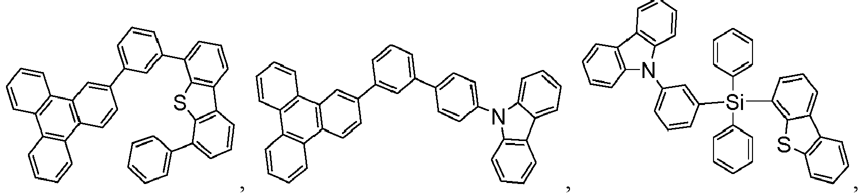 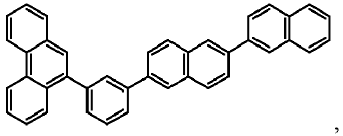 and combinations thereof.

In some embodiments of the OLED, the organic layer further comprises a host, wherein the host comprises a metal complex.

According to another aspect, a formulation comprising a compound having the formula M(L_{A})ₓ(L_{B})_{y}(L_{C})_{z} is disclosed, wherein the ligand L_{A} is 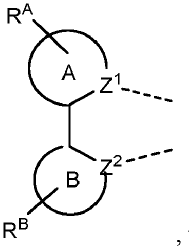 the ligand L_{B} is 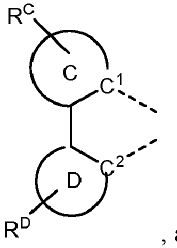 and the ligand L_{C} is 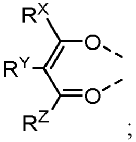
wherein M is a metal having an atomic number greater than 40;
wherein x is 0, 1, or 2;
wherein y is 1, 2, or 3;
wherein z is 0, 1, or 2;
wherein x+y+z is the oxidation state of the metal M;
wherein L_{A} is different from L_{B}, and when x, y, or z is larger than 1, each plurality of L_{A}, L_{B}, or L_{C} are also different;
wherein rings A, B, C, and D are each independently a 5 or 6-membered carbocyclic or heterocyclic ring;
wherein R^{A}, R^{B}, R^{C}, and R^{D} each independently represent mono substitution up to the maximum possible number of substitutions, or no substitution;
wherein Z¹ and Z² are each independently selected from the group consisting of carbon or nitrogen;
wherein C¹ is an anionic donor carbon atom, C² is a neutral carbene carbon atom; wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any adjacent substituents are optionally joined or fused into a ring.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be a triphenylene containing benzo-fused thiophene or benzo-fused furan. Any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, and CₙH₂ₙ-Ar₁, or the host has no substitution. In the preceding substituents n can range from 1 to 10; and Ar₁ and Ar₂ can be independently selected from the group consisting of benzene, biphenyl, naphthalene, triphenylene, carbazole, and heteroaromatic analogs thereof. The host can be an inorganic compound. For example a Zn containing inorganic material e.g. ZnS.

The host can be a compound comprising at least one chemical group selected from the group consisting of triphenylene, carbazole, dibenzothiophene, dibenzofuran, dibenzoselenophene, azatriphenylene, azacarbazole, aza-dibenzothiophene, aza-dibenzofuran, and aza-dibenzoselenophene. The host can include a metal complex. The host can be, but is not limited to, a specific compound selected from the group consisting of: 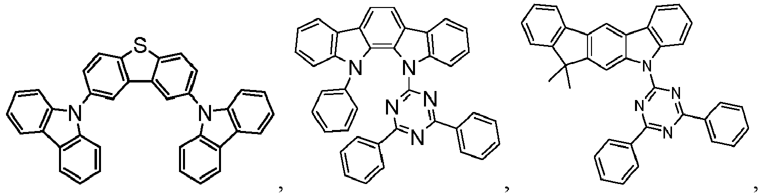 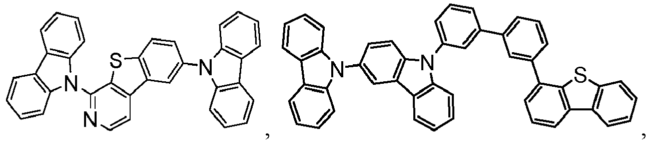 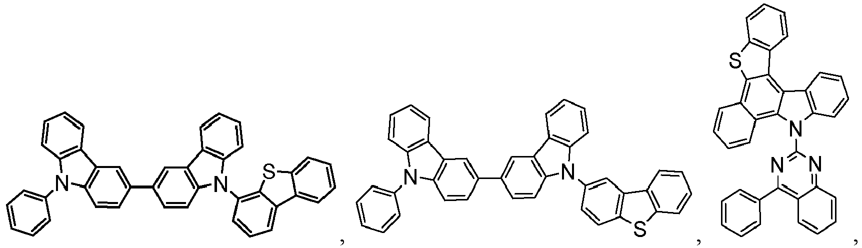 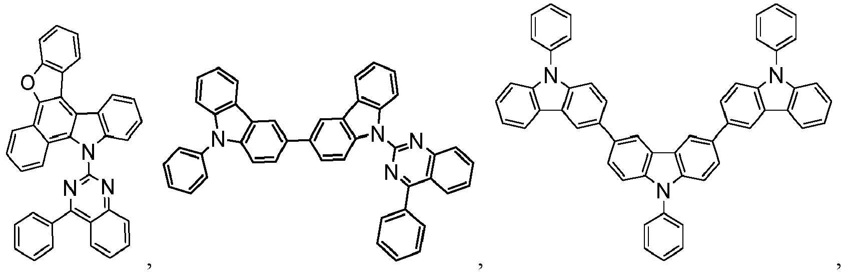 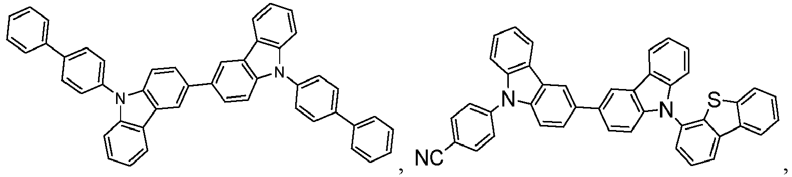 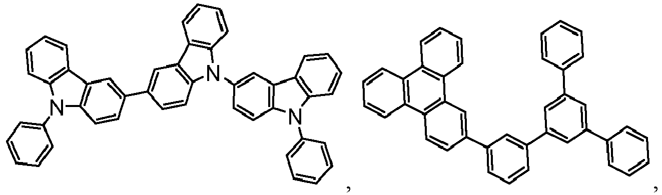 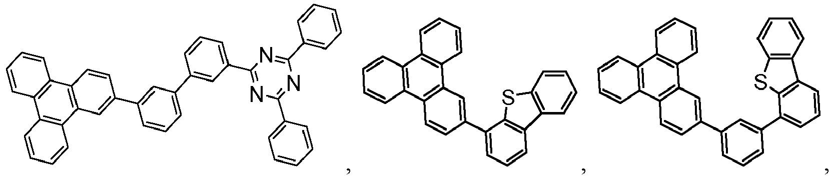 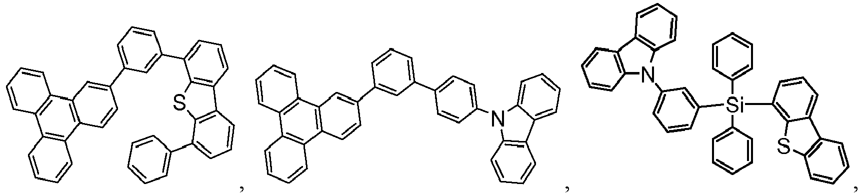 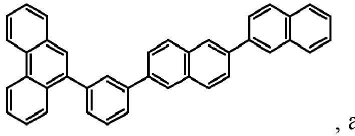 and combinations thereof.

Additional information on possible hosts is provided below.

The formulation can include one or more components selected from the group consisting of a solvent, a host, a hole injection material, hole transport material, and an electron transport layer material, disclosed herein.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804 and US2012146012.

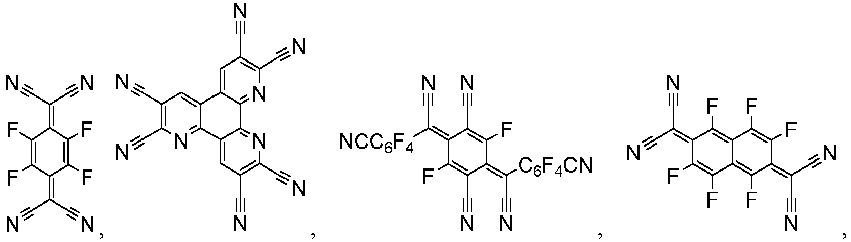

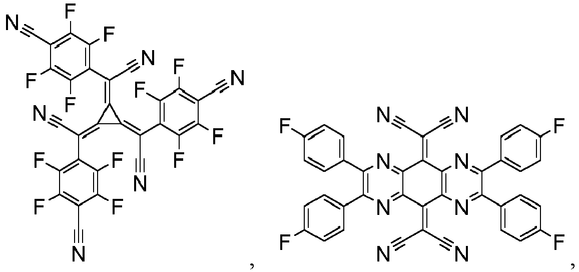

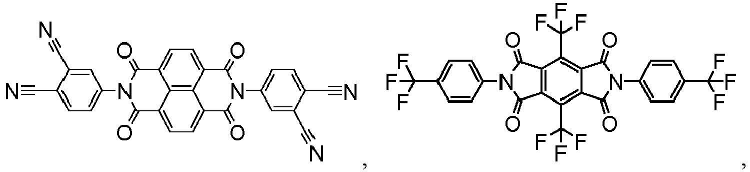

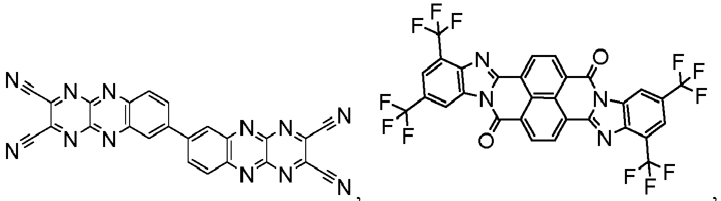

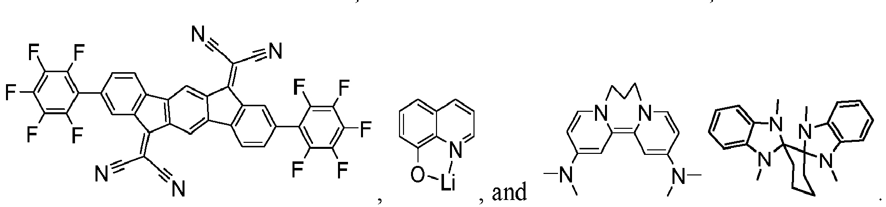

### HIL/HTL:

A hole injecting/transporting material to be used in the present invention is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

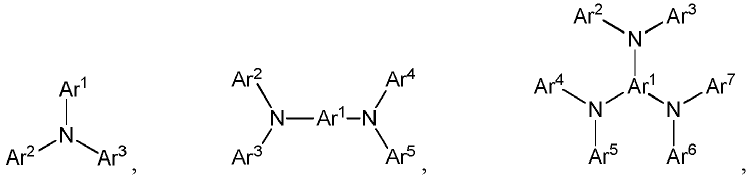

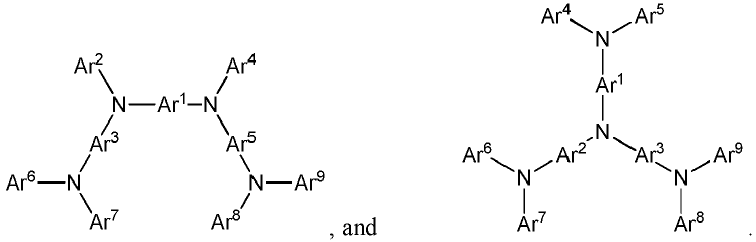

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 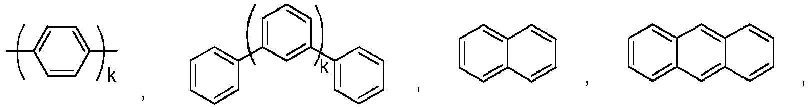 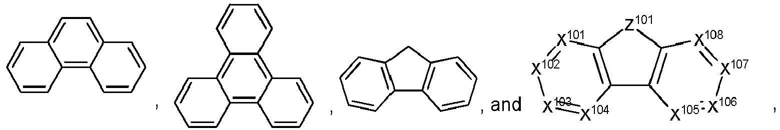 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 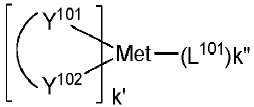 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 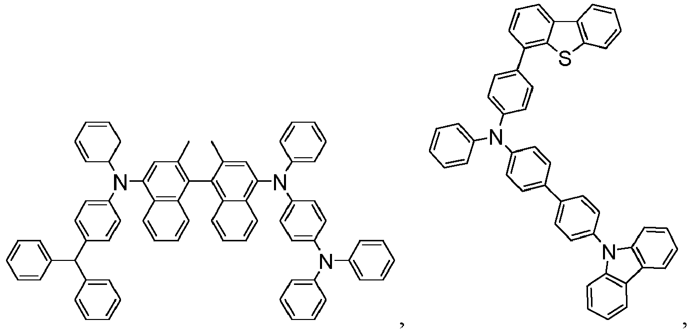 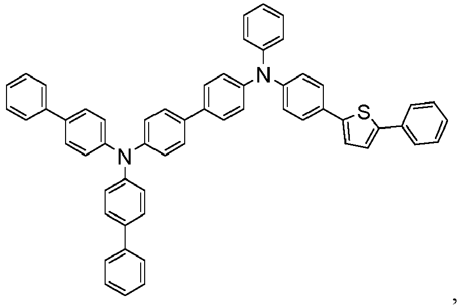 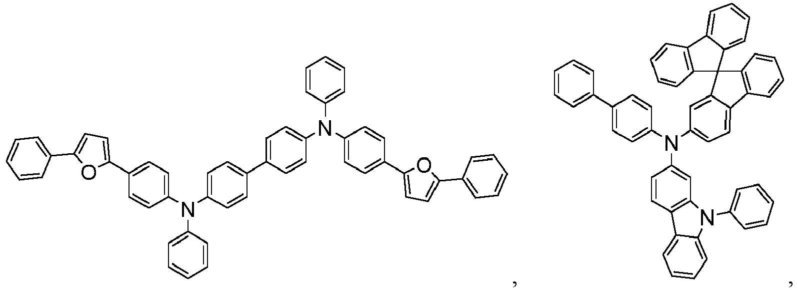 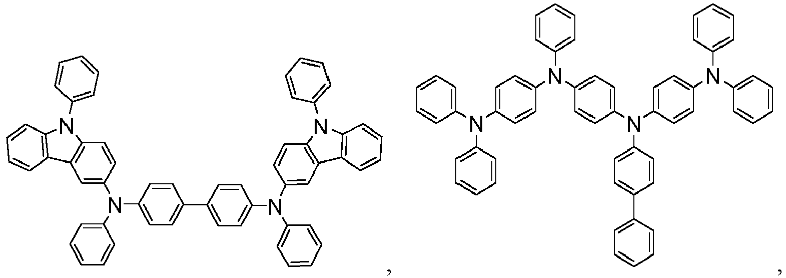 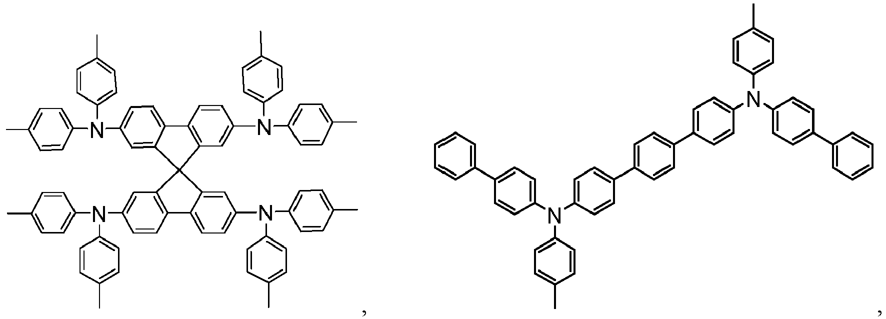 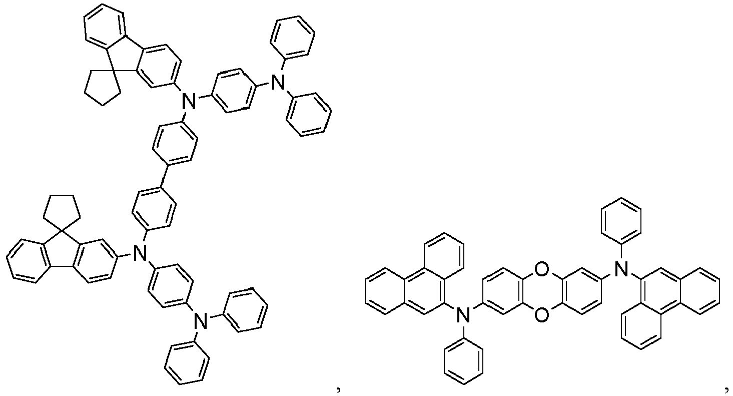 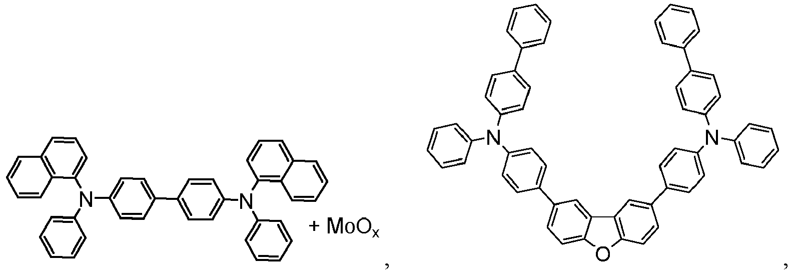 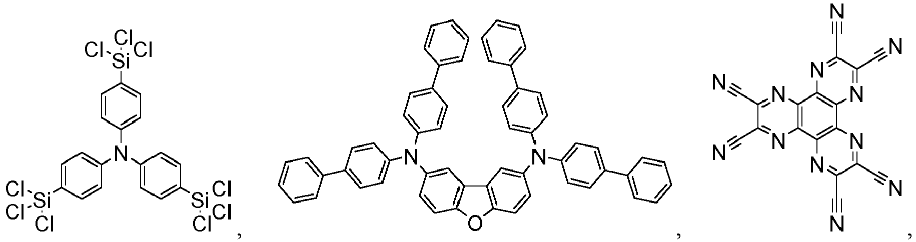 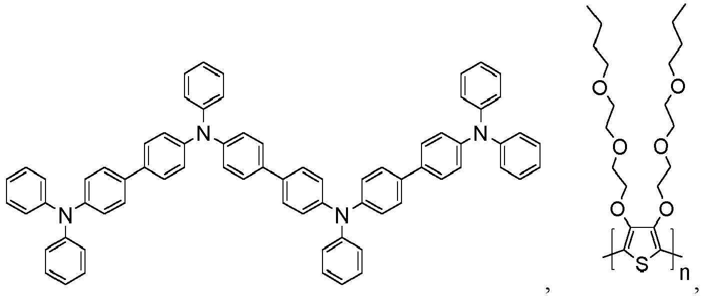 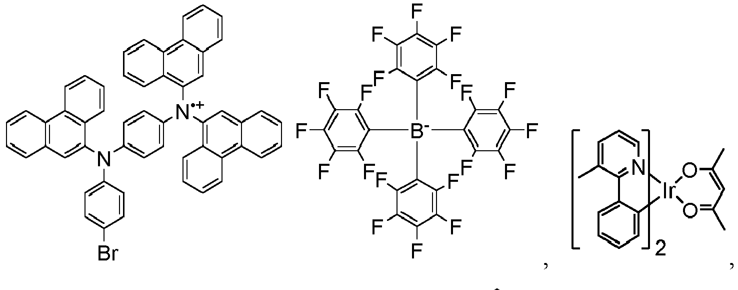 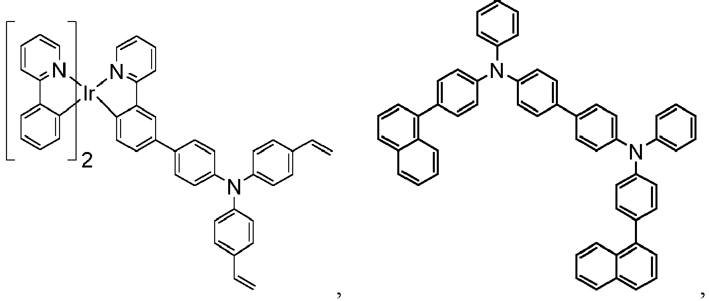 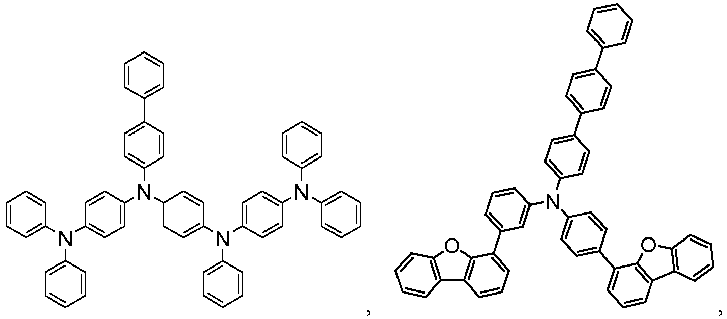 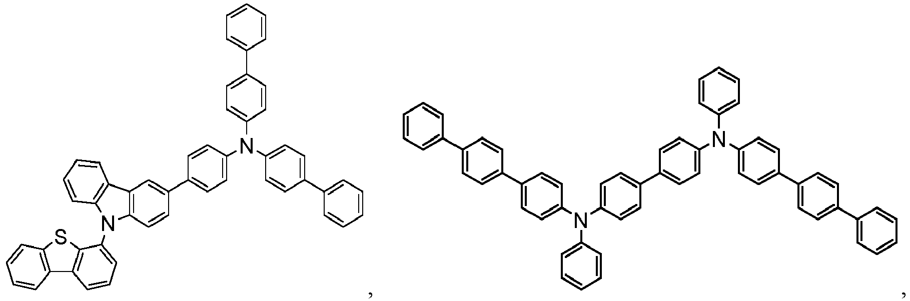 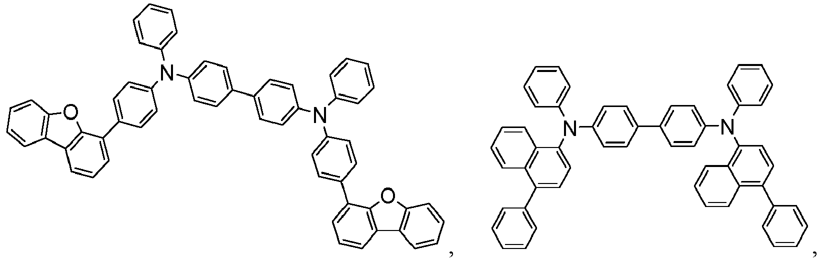 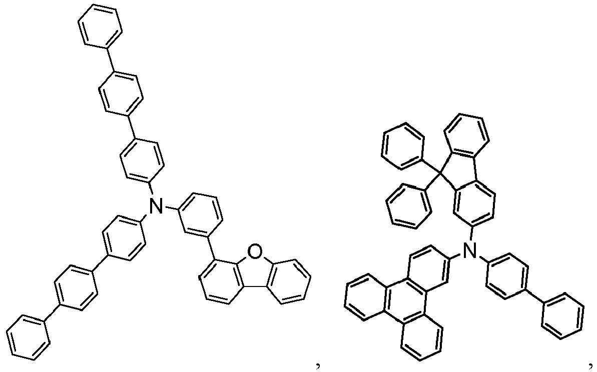 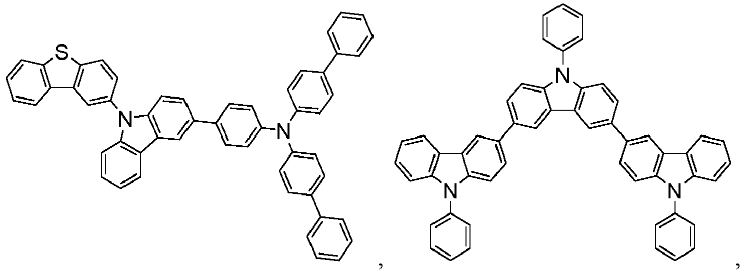 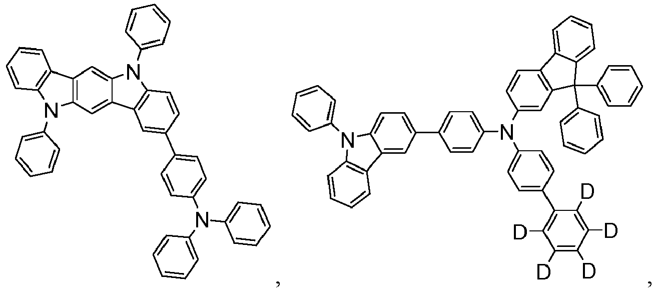 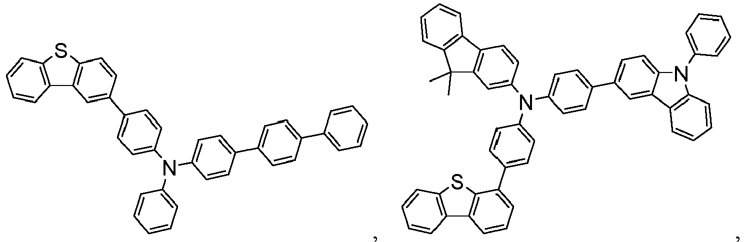 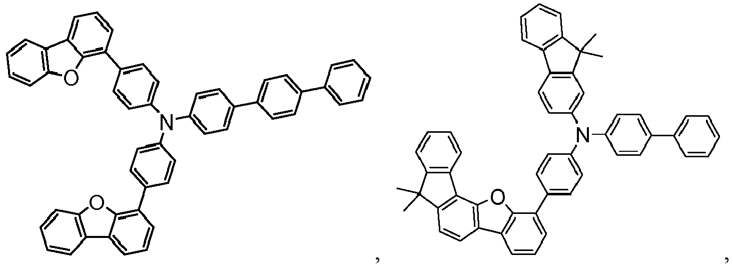 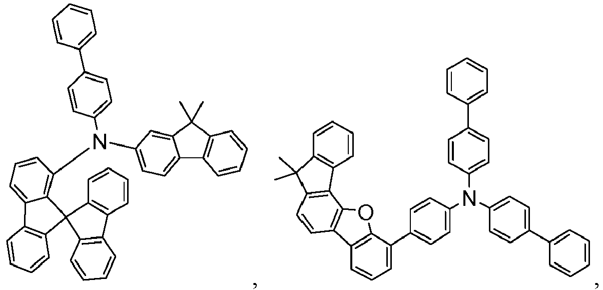 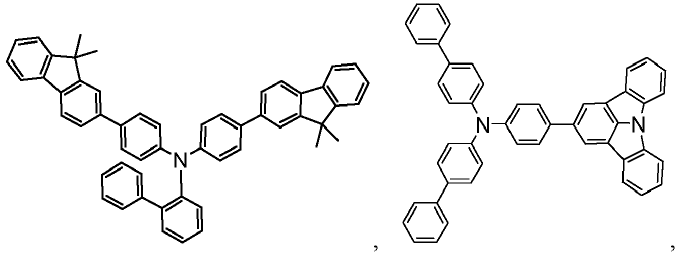 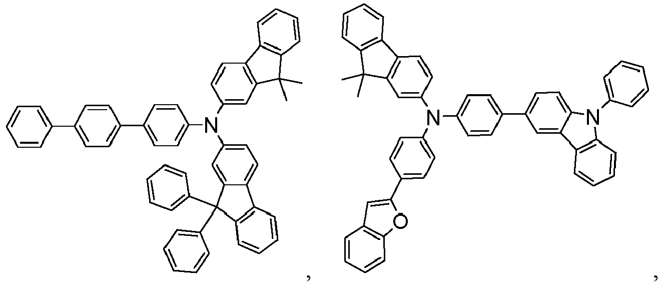 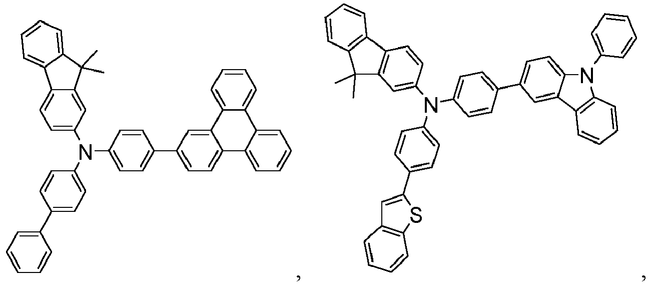 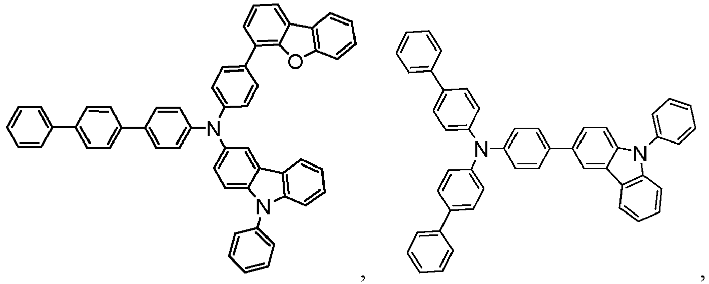 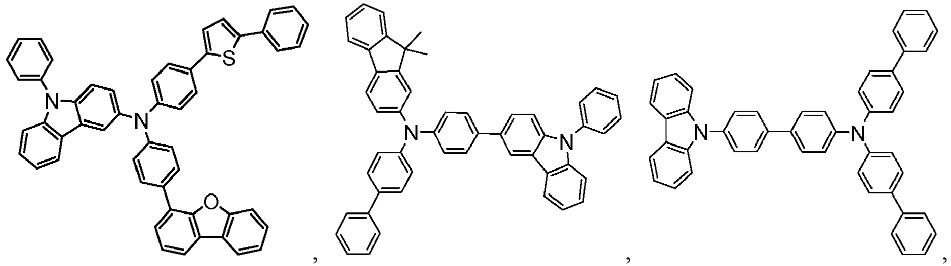 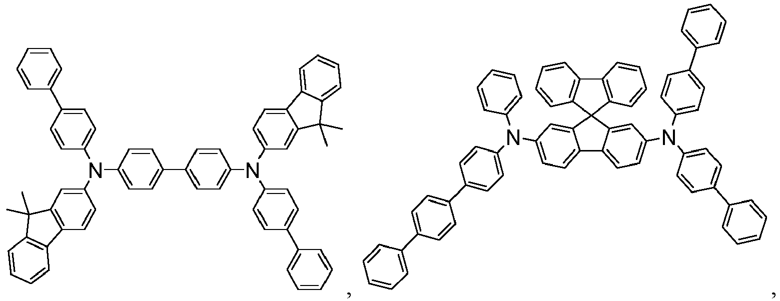 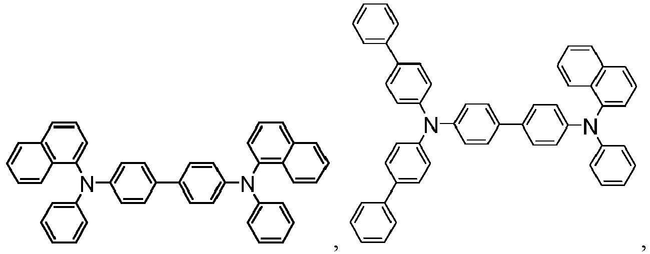 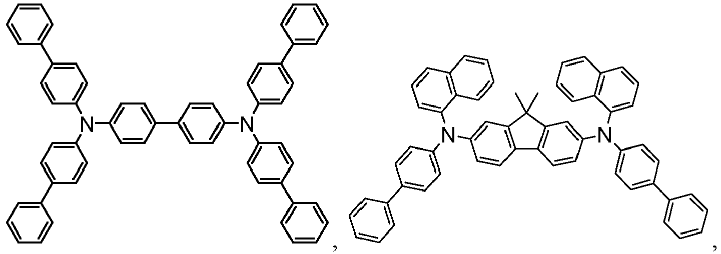 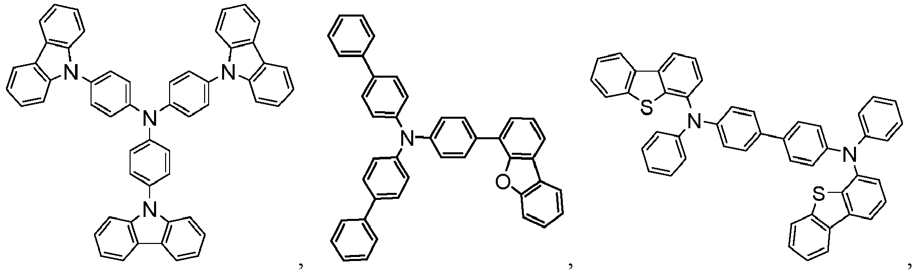 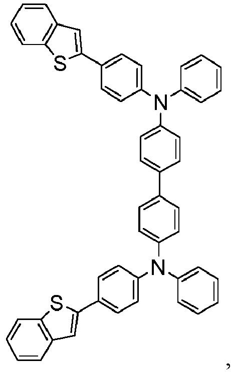 and

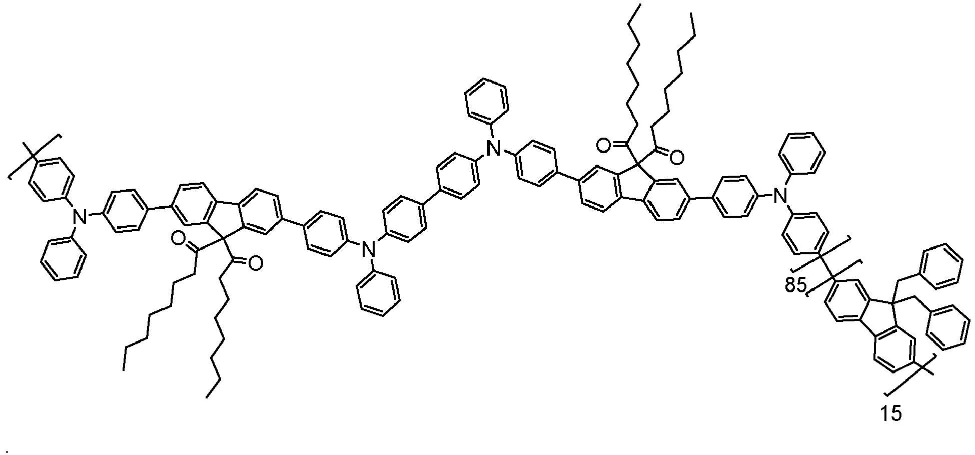

### EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 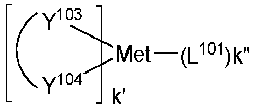 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 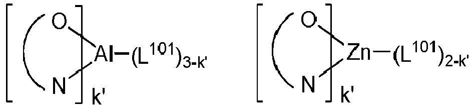 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of other organic compounds used as host are selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, the host compound contains at least one of the following groups in the molecule: 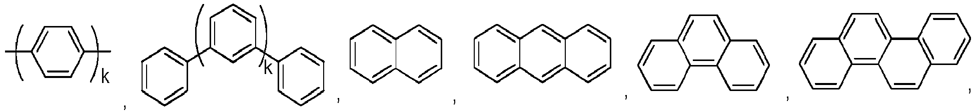 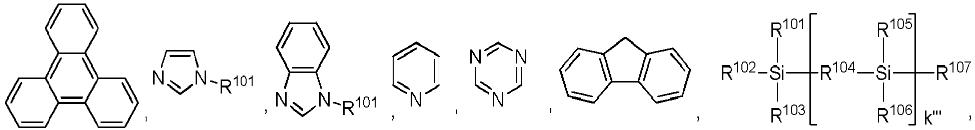 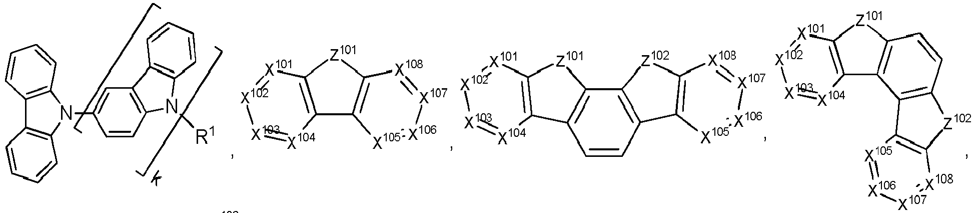 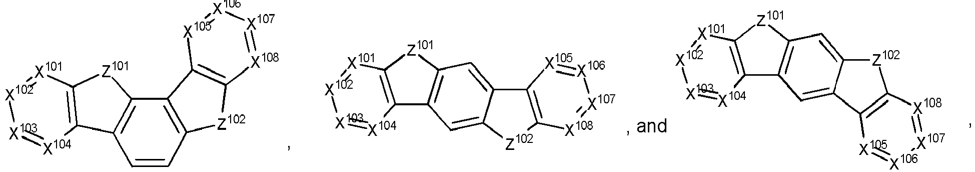
wherein each of R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N.
Z¹⁰¹ and Z¹⁰² is selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472,

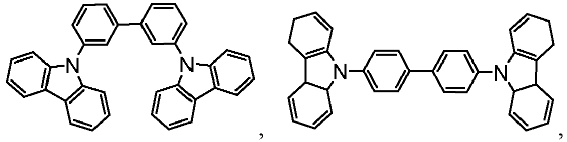

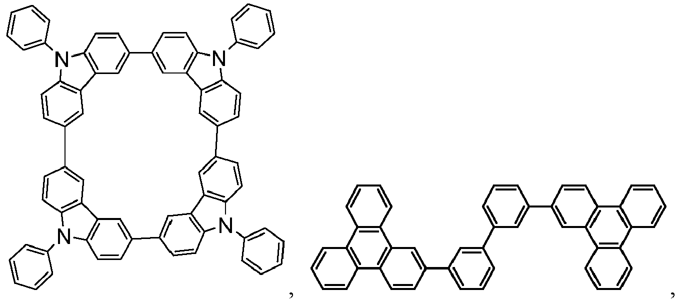

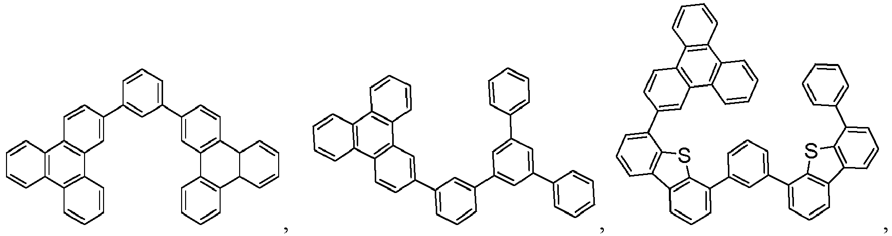

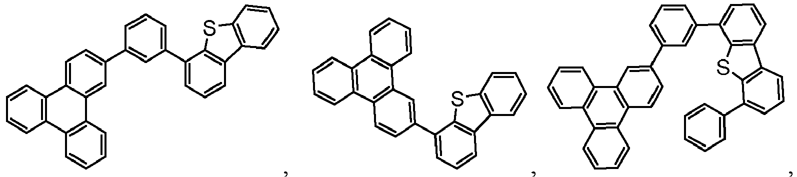

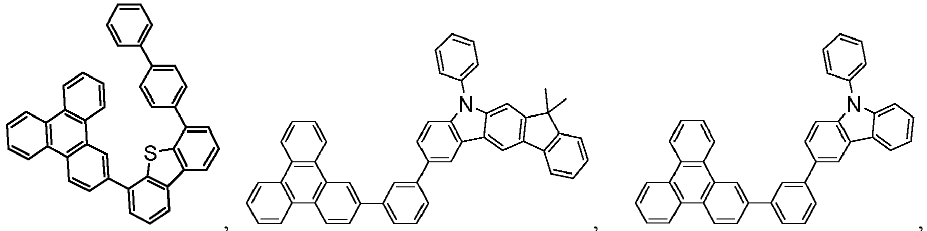

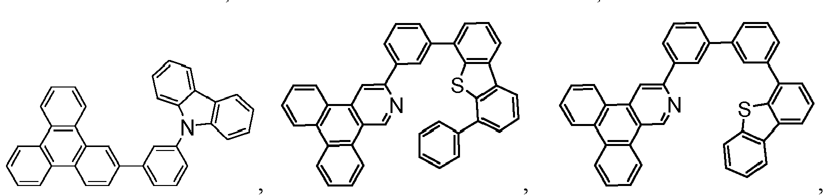

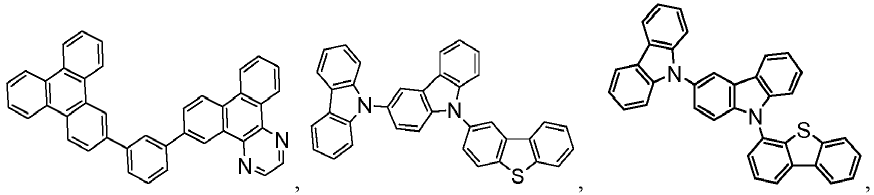

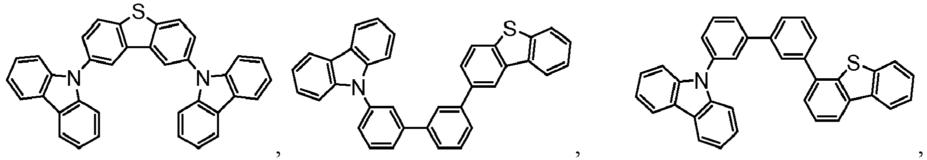

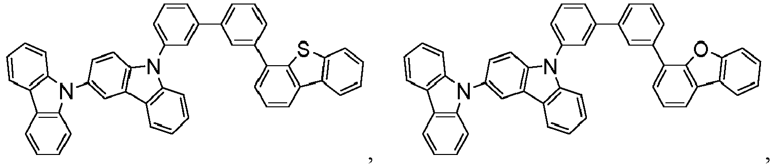

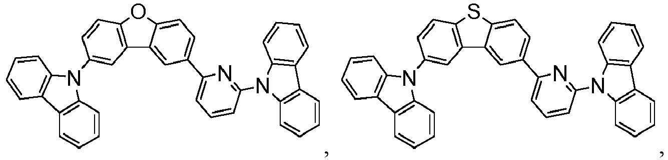

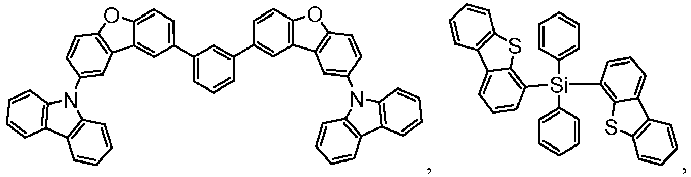

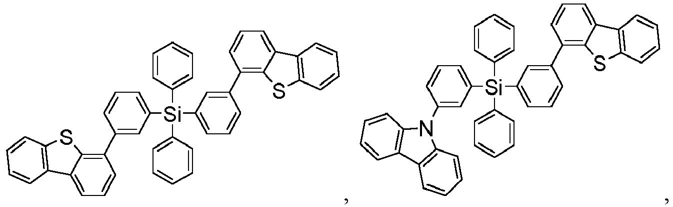

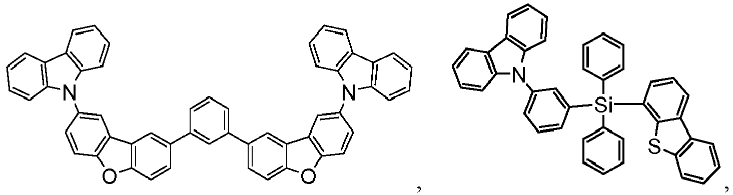

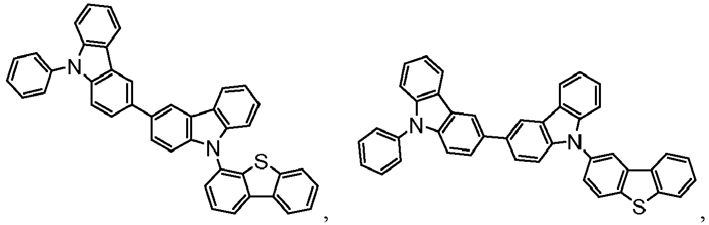

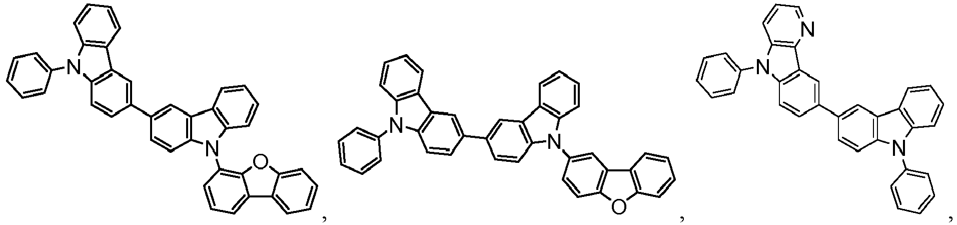

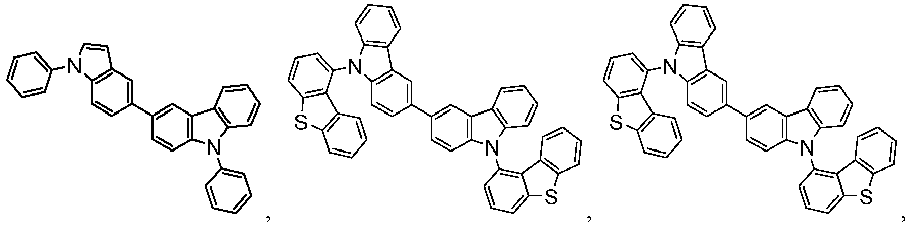

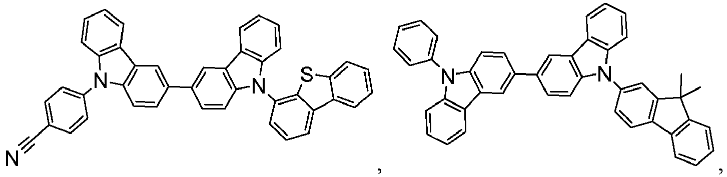

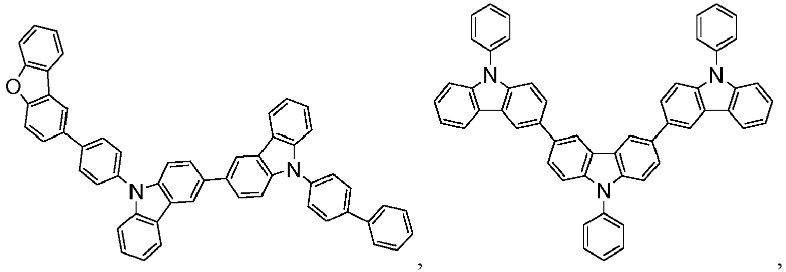

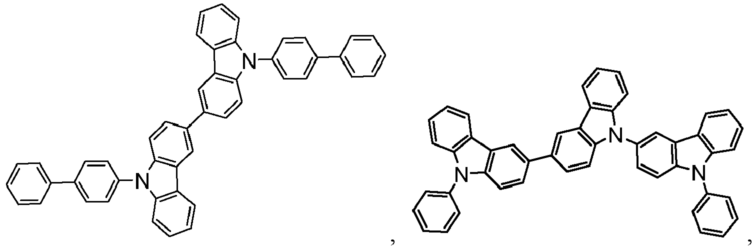

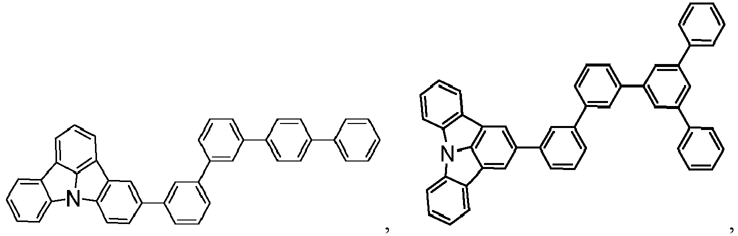

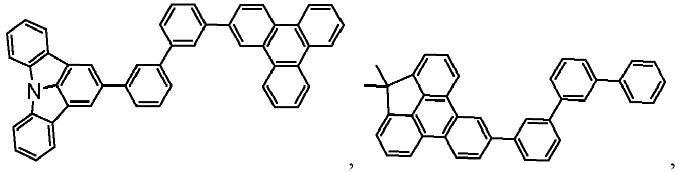

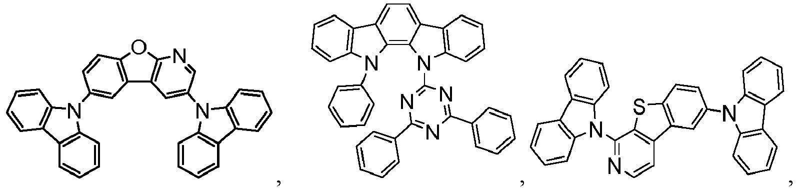

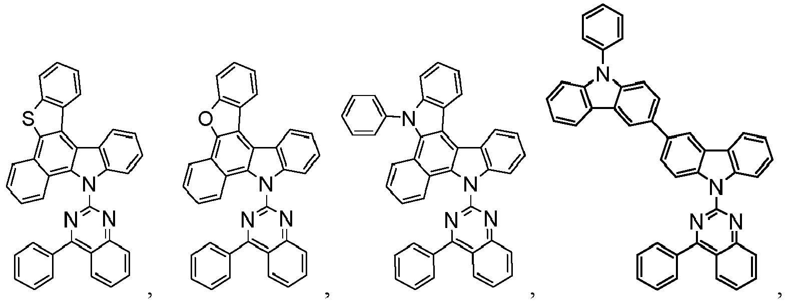

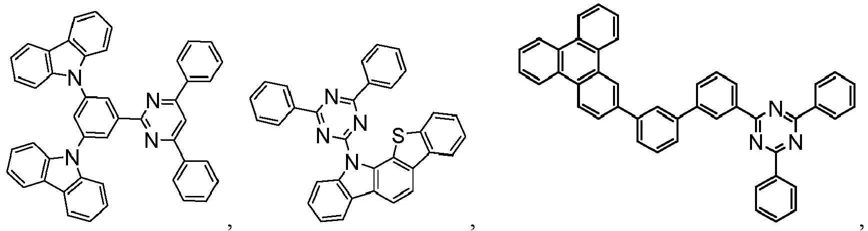

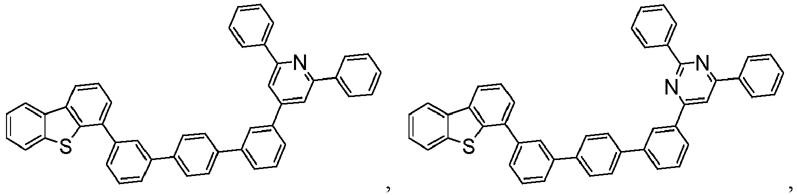

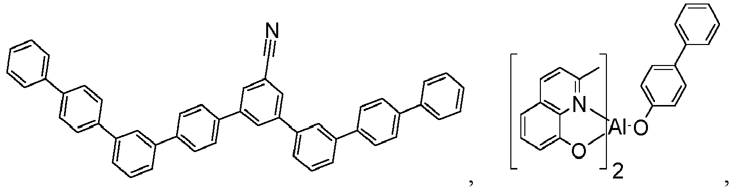

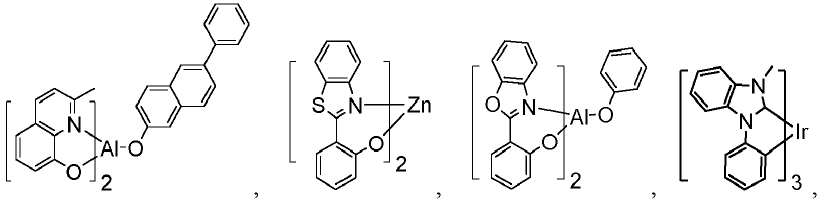

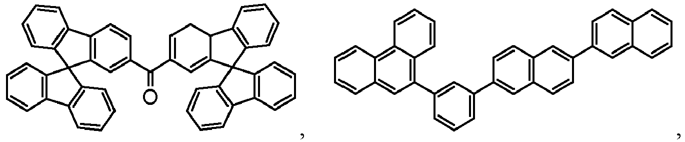

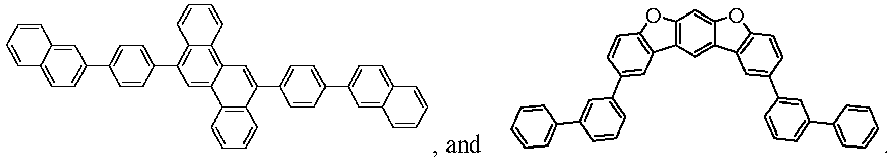

### Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450. 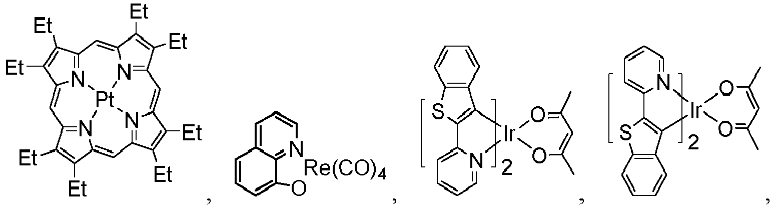 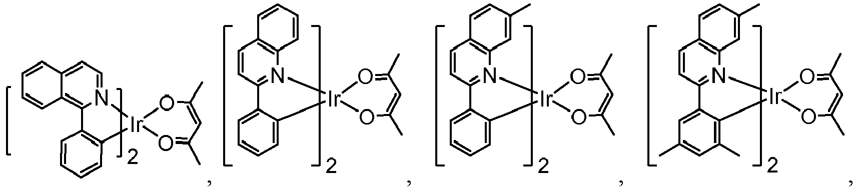 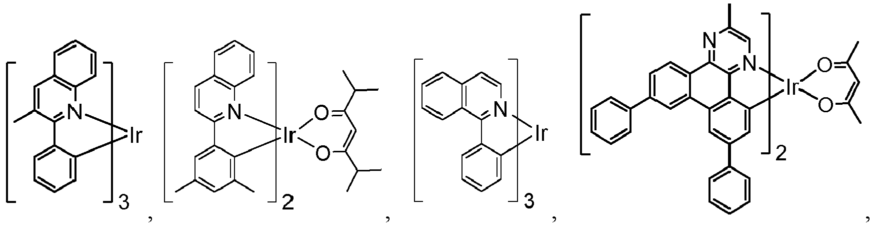 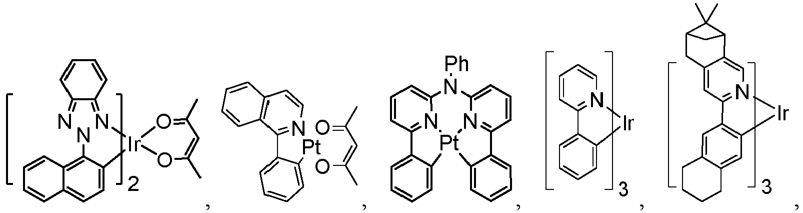 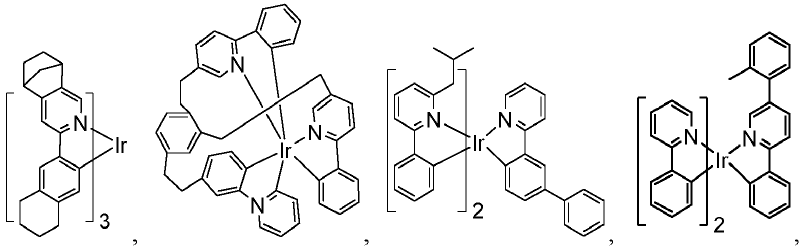 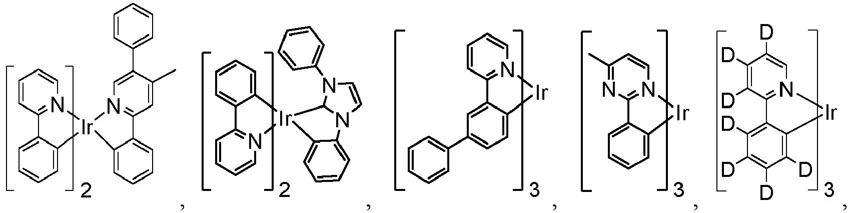 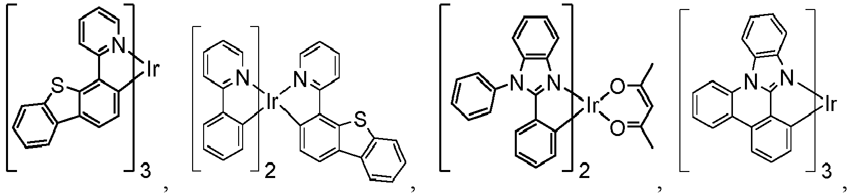 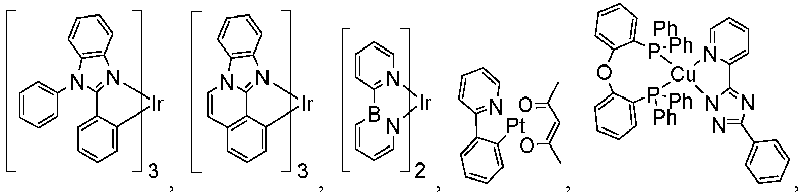 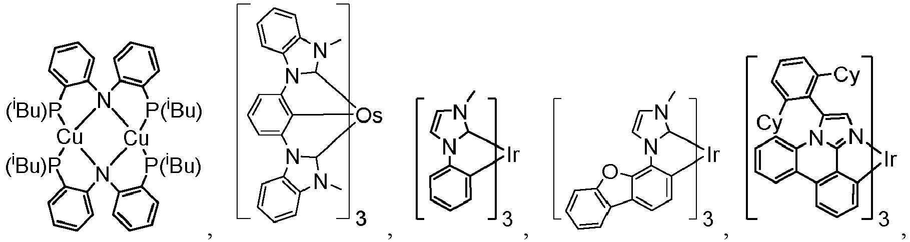 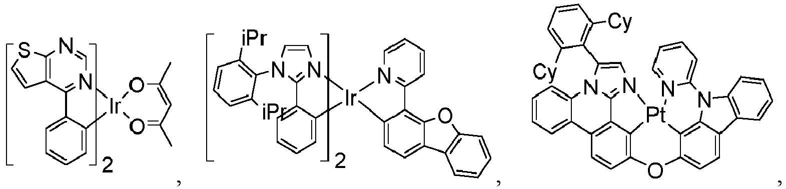 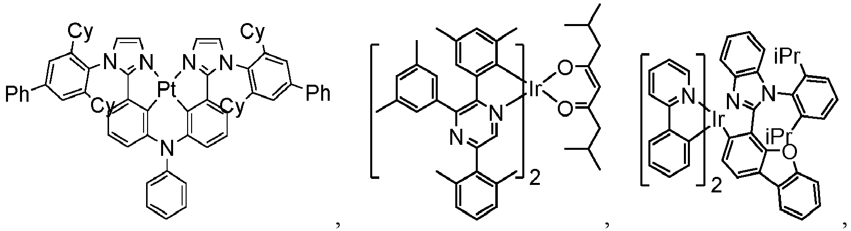 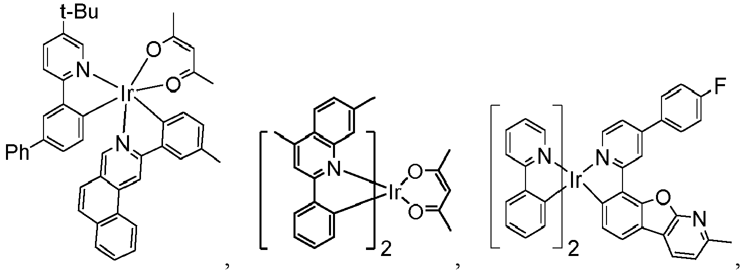 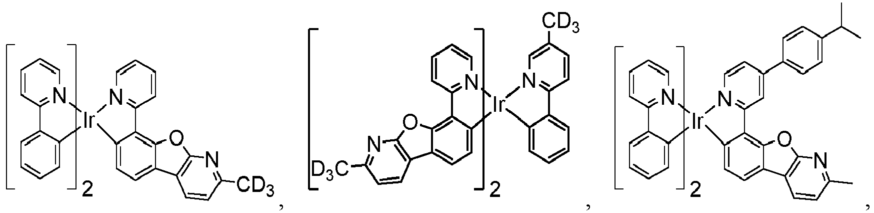 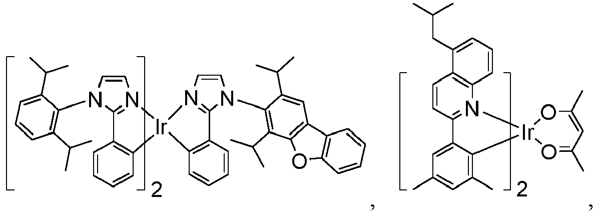 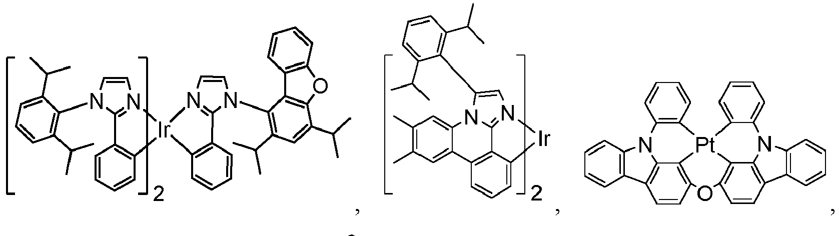 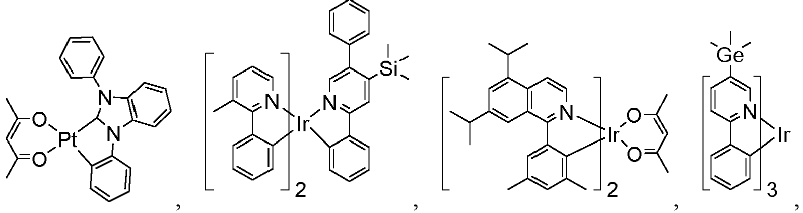 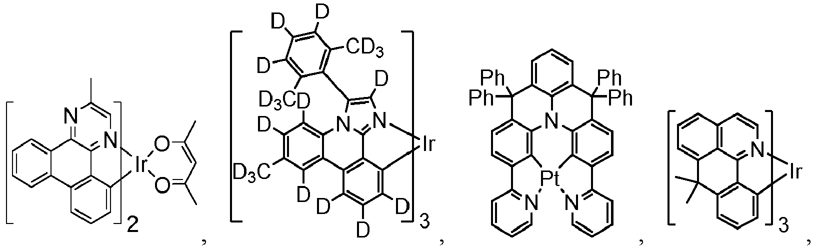 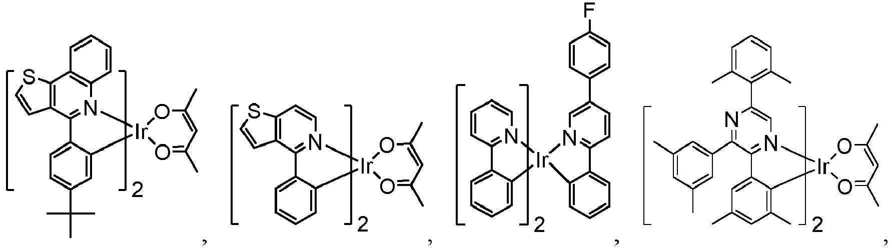 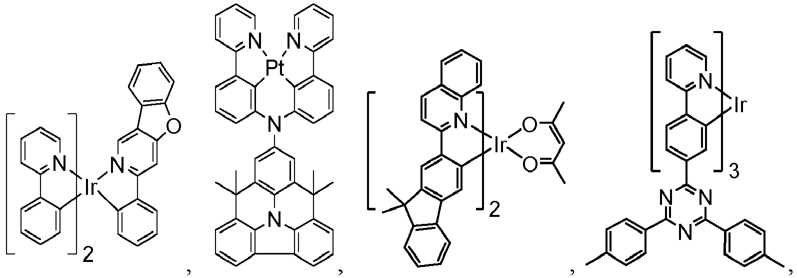 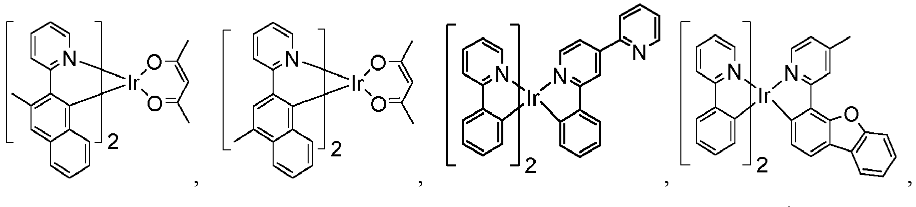 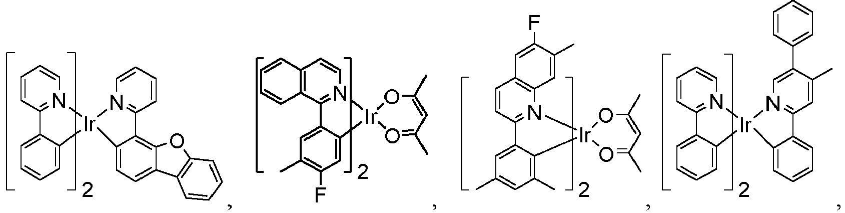 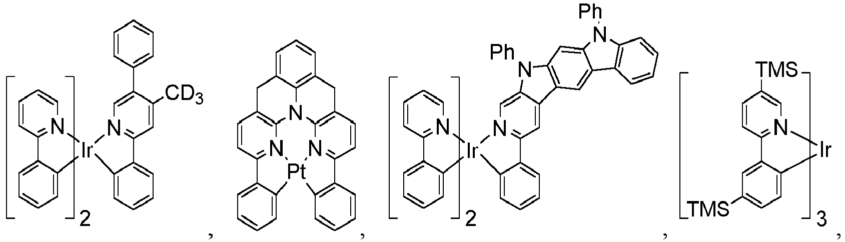 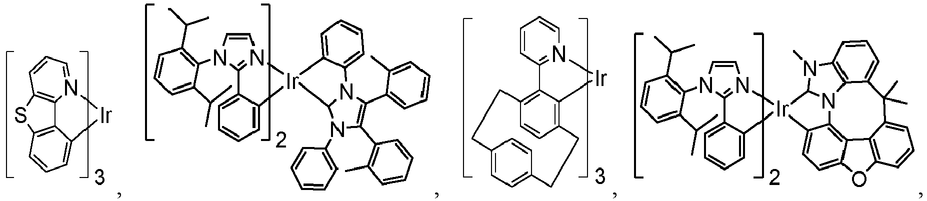 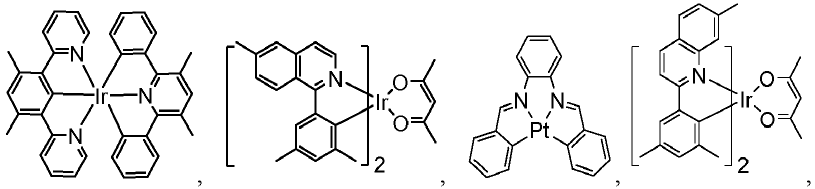 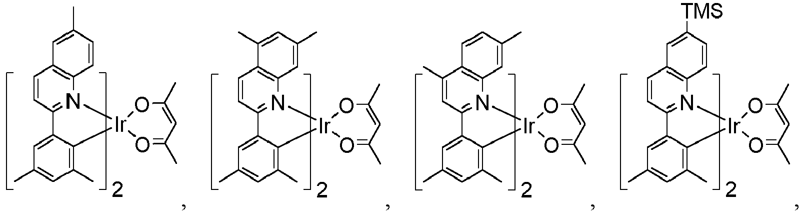 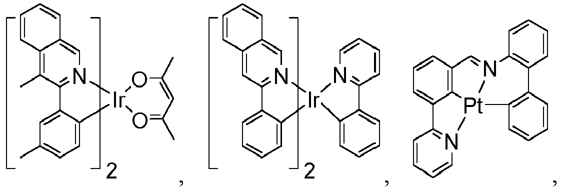 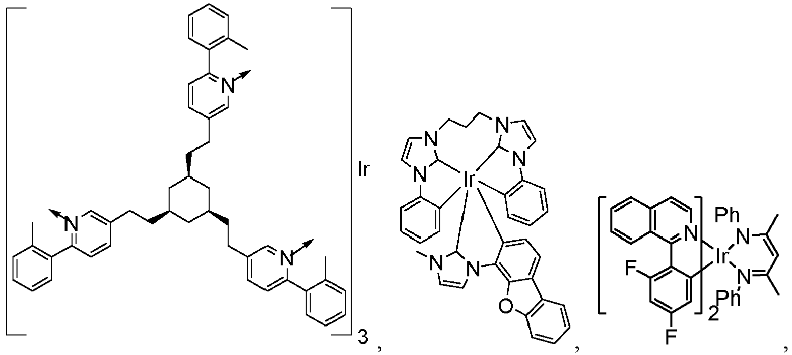 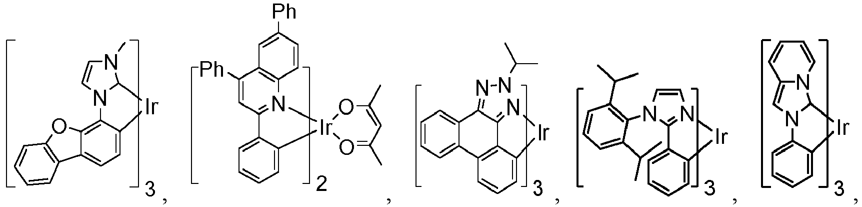 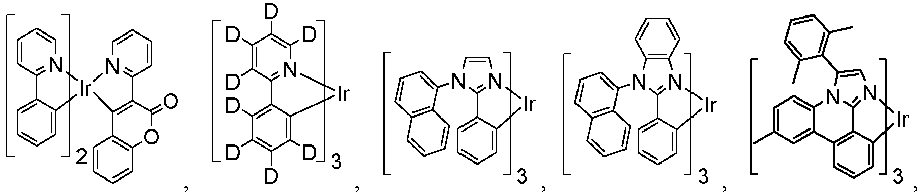 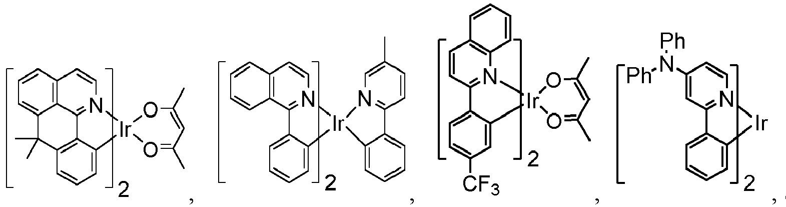 and

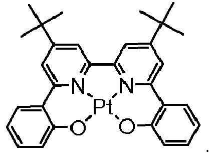

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 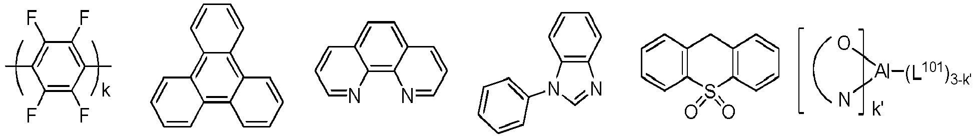 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 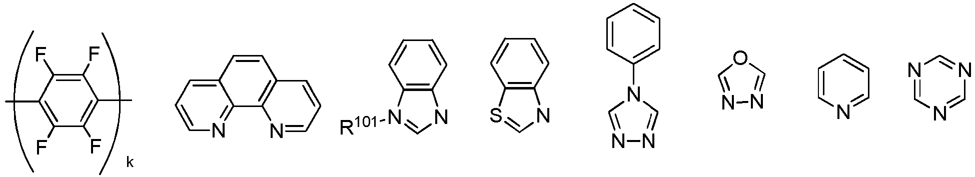 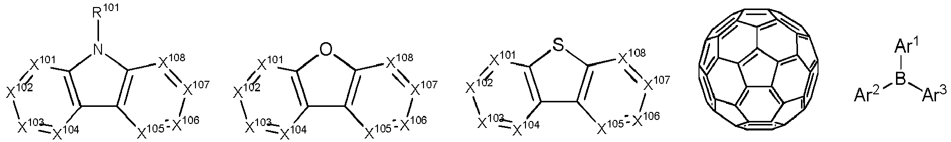 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 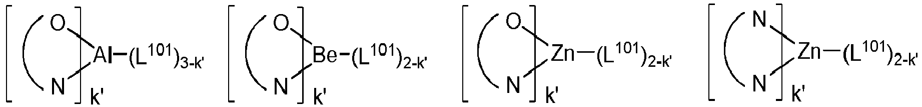 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

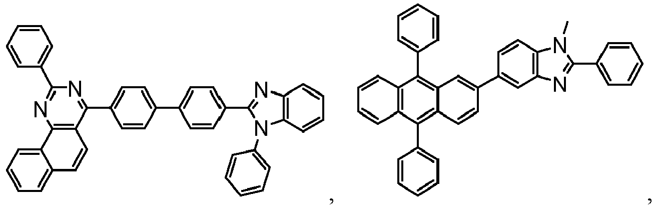

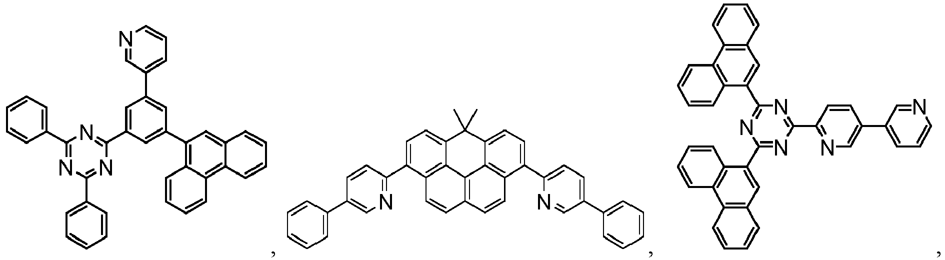

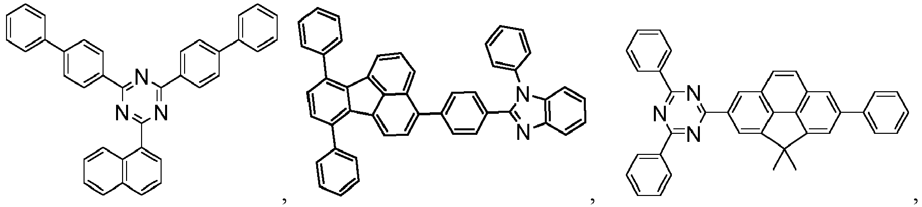

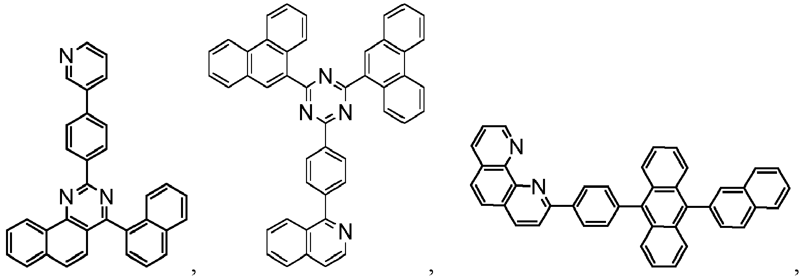

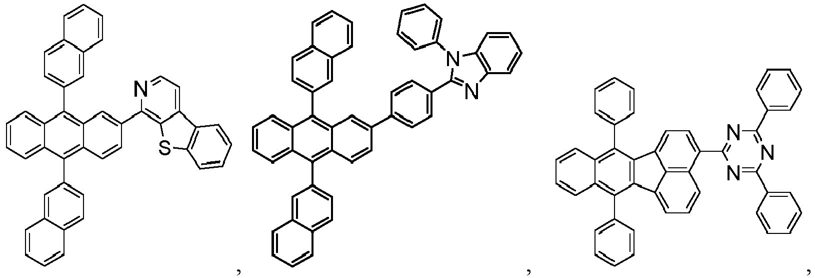

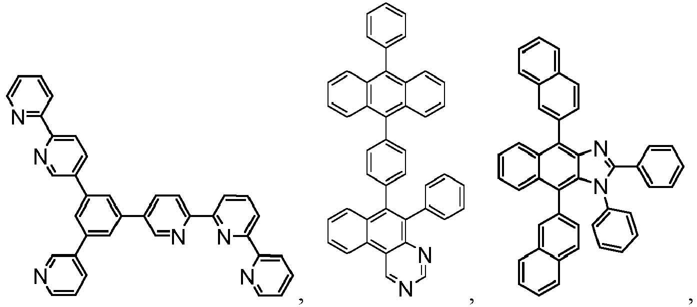

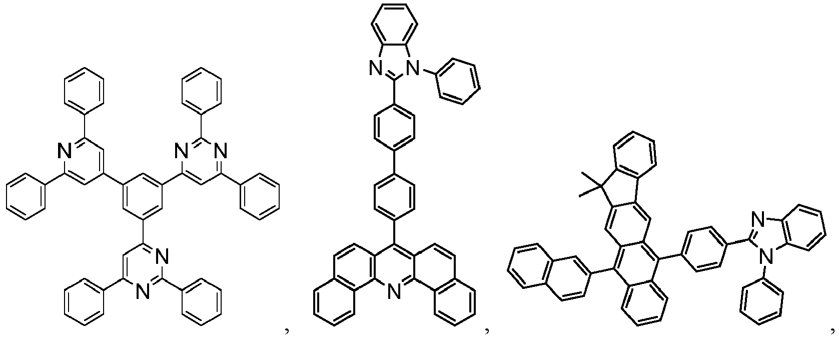

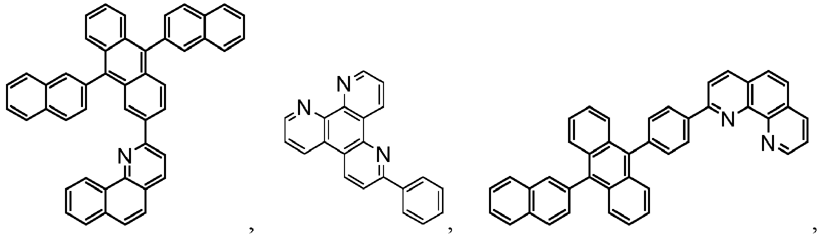

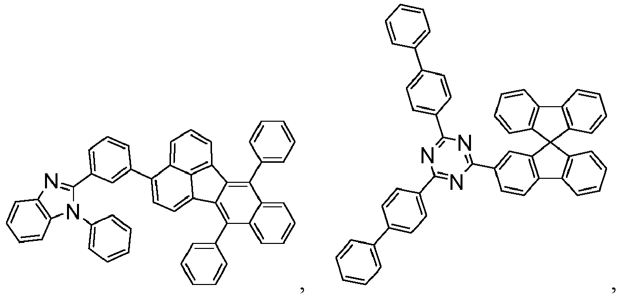

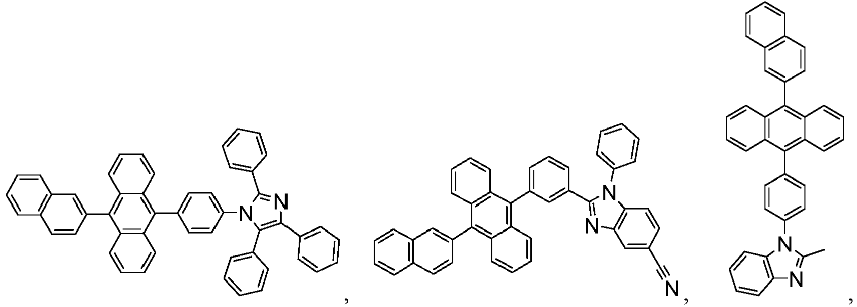

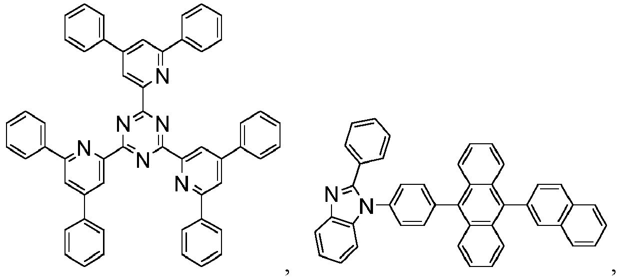

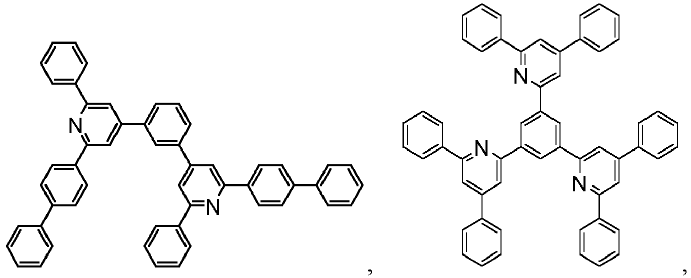

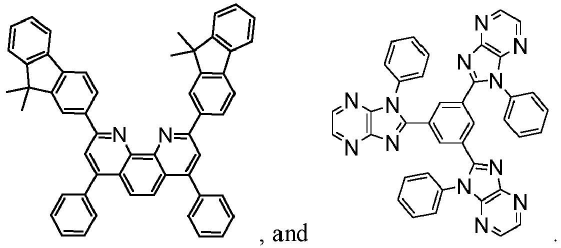

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

### Synthesis

All reactions were carried out with rigorous exclusion of air using Schlenk-tube techniques. Solvents (except MeOH which was dried and distilled under argon) were obtained oxygen- and water-free from an MBraun solvent purification apparatus. ¹H, ¹⁹F and ¹³C{¹H} NMR spectra were recorded on Bruker 300 ARX, Bruker Avance 300 MHz, Bruker Avance 400 MHz or Bruker Avance 500 MHz instruments. Chemical shifts (expressed in parts per million) are referenced to residual solvent peaks (¹H, ¹³C{¹H}), or external CFCl₃ (¹⁹F). Coupling constants J are given in hertz. Attenuated total reflection infrared spectra (ATR-IR) of solid samples were run on a Perkin-Elmer Spectrum 100 FT-IR spectrometer. C, H, and N analyses were carried out in a Perkin-Elmer 2400 CHNS/O analyzer. High-resolution electrospray mass spectra were acquired using a MicroTOF-Q hybrid quadrupole time-of-flight spectrometer (Bruker Daltonics, Bremen, Germany). [IrCl(COD)]₂ (**1**) was prepared by the method published in A. van der Ent & A. L. Onderdelinden, Inorg. Synth. 1997, 28, 90.

**Preparation of IrCl(PhMeIm)(COD) (2).** A modification of the procedure described in A. R. Chianese, et Al., Organometallics 2004, 23, 2461-2468 was used. This procedure is referred to as the Scheme 1. A black suspension of silver oxide (139.5 mg, 0.596 mmol) and 1-phenyl-3-methyl-1H-imidazole iodide [PhMeHIm]I (340.8 mg, 1.19 mmol) in CH₂Cl₂ (15 mL) was stirred for two hours in the presence of 4 Å molecular sieves (400 mg). The mixture evolved to a beige suspension and [IrCl(COD)]₂ (**1**, 400 mg, 0.596 mmol) was added resulting in a yellow suspension. The yellow solution was extracted from the silver salts and concentrated in *vacuo* to ca ∼ 0.5 mL. Pentane (10 mL) was added and a yellow solid precipitated. The solid was washed with pentane (3x4 mL). The obtained yellow powder was identified by ¹H NMR as IrCl(PhMeIm)(COD) (**2**).Yield: 543.5 mg (92 %).

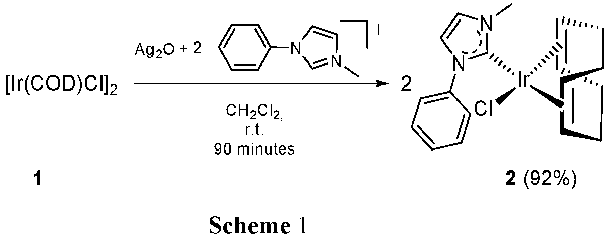

**Preparation of [Ir(µ-Cl)(*κ*²-*C*_{aryl},*C*_{NHC})(ppy)]₂ (3a and 3b).** Phenylpyridine (236 µL, 1.622 mmol) was added to a suspension of IrCl(PhMeIm)(COD) (**2**) (800 mg, 1.622 mmol) in methanol (15 mL) and the resulting yellow suspension was refluxed for 3 days. The resulting pale yellow suspension was decanted from the orange solution and washed with MeOH (3x4 mL) yielding a mixture of two isomers in a 1.8/1.0 ratio (Scheme 2). Yield: 690.4 mg (86 %). Spectroscopic data of isomer **3a**: ¹H NMR (500.13 MHz, CD₂Cl₂, 298 K): δ 9.6-9.5 (m, 1H, CH), 8.1-7.9 (m, 2H, CH), 7.7-7.5 (m, 2H, CH), 7.3-7.2 (m, 1H, CH), 7.1-6.9 (m, 2H, CH), 6.9-6.7 (m, 2H, CH), 6.7-6.6 (m, 1H, CH), 6.5-6.3 (d, 1H, CH), 6.2-6.1 (m, 1H, CH), 5.9-5.8 (m, 1H, CH), 3.47 (s, 3H, NCH₃). ¹³C{¹H} + HMBC + HSQC NMR (125.76 MHz, CD₂Cl₂, 298 K): δ 166.3 (s, Cq), 163.1 (s, NCN), 149.8 (s, CH), 147.3 (s, Cq), 146.0 (s, Cq), 143.8 (s, Cq), 137.9 (s, CH), 136.5 (s, CH), 132.1 (s, CH), 130.6 (s, Cq), 130.1 (s, CH), 124.5 (s, CH), 124.3 (s, CH), 122.4 (s, CH), 122.1 (s, CH), 122.1 (s, CH), 121.4 (s, CH), 119.3 (s, CH), 115.8 (s, CH), 110.8 (s, CH), 37.5 (s, NCH₃). Spectroscopic data of isomer **3b**: ¹H NMR (500.13 MHz, CD₂Cl₂, 298 K): δ 9.4-9.3 (m, 1H, CH), 8.1-7.9 (m, 1H, CH), 8.0-7.8 (m, 1H, CH), 7.7-7.5 (m, 2H, CH), 7.2-7.1 (m, 1H, CH), 7.1-6.9 (m, 2H, CH), 6.9-6.7 (m, 2H, CH), 6.7-6.6 (m, 1H, CH), 6.5-6.3 (m, 1H, CH), 6.2-6.1 (m, 1H, CH), 5.9-5.8 (m, 1H, CH), 3.79 (s, 3H, NCH₃). ¹³C{¹H} + HMBC + HSQC NMR (125.76 MHz, CD₂Cl₂, 298K) *δ* 166.1 (s, Cq), 163.6 (s, NCN), 151.1 (s, CH), 147.3 (s, Cq), 143.9 (s, Cq), 137.6 (s, CH), 136.1 (s, CH), 132.4 (s, CH), 130.7 (s, Cq), 130.0 (s, CH), 124.5 (s, CH), 124.4 (s, Cq), 123.0 (s, CH), 122.6 (s, CH), 122.1 (s, CH), 121.5 (s, CH), 119.3 (s, CH), 116.0 (s, CH), 111.0 (s, CH), 36.1 (s, NCH₃). Two Cq resonances are not observed, due to overlapping with other peaks.

**Preparation of [Ir(µ-Cl)(*κ*²-*C*_{aryl},*C*_{NHC})(dfppy)]₂ (4a and 4b).** Methanol (15 mL) was added to a mixture of IrCl(PhMeIm)(COD) (**2**) (500 mg, 1.01mmol) and 2,4-difluorophenylpyridine (dfppy) (160 µL, 1.01 mmol) and the resulting yellow suspension was refluxed for 3 days. The resulting pale yellow suspension was decanted from the orange solution and washed with MeOH (3x4 mL) yielding a mixture of two complexes in a 1.8/1.0 ratio (Scheme 2). Yield: 469.4 mg (95 %). Spectroscopic data of isomer **4a**: ¹H NMR (500.13 MHz, CD₂Cl₂, 298 K): δ 9.6-9.5 (m, 1 H, CH), 8.5-8.3 (m, 1H, CH), 8.1-7.9 (m, 1H, CH), 7.62 (d, ³*J*_{H-H} = 2.2, 1H, CH), 7.3-7.2 (m, 1H, CH), 7.1-7.0 (m, 2H, CH), 6.7-6.6 (m, 1H, CH), 6.5-6.4 (d, 1H, CH), 6.4-6.2 (m, 1H, CH), 5.9-5.8 (m, 1H, CH), 5.7-5.6 (m, 1H, CH), 3.45 (s, 3H, NCH₃). ¹³C{¹H} + HMBC + HSQC NMR (125.76 MHz, CD₂Cl₂, 298 K): δ 163.7 (d, ²*J*_{C-F} = 6.9, Cq), 163.2 (dd, ¹*J*_{C-F} = 253.3, ³*J*_{C-F} = 12.5, CF), 162.1 (s, NCN), 161.2 (dd, ¹*J*_{C-F} = 258.2, ³*J*_{C-F} = 13.1, CF), 150.4 (d, ³*J*_{C-F} = 7.1, Cq), 149.8 (s, CH), 147.0 (s, Cq), 138.5 (s, CH), 132.0 (s, CH), 129.4 (s, Cq), 129.1 (s, CH), 128.0 (br, Cq), 124.4 (s, CH), 123.4 (d, ⁴*J*_{C-F} = 21.4, CH), 122.7 (s, CH), 122.4 (s, CH), 118.3 (dd, d, ²*J*_{C-F} = 17.3, ⁴*J*_{C-F} = 2.8, CH), 116.2 (s, CH), 111.2 (s, CH), 97.6 (dd, ²*J*_{C-F} = 27.2, ²*J*_{C-F} = 27.2, CH), 37.4 (s, NCH₃). ¹⁹F{¹H} NMR (282.33 MHz, CD₂Cl₂, 298 K): δ -110.0 (d, ⁴*J*_{F-F} = 10.0, IF, CF), - 110.4 (d, ⁴*J*_{F-F} = 10.0, IF, CF). Spectroscopic data of isomer **4b**: ¹H NMR (500.13 MHz, CD₂Cl₂, 298 K): δ 9.4-9.3 (m, 1H, CH), 8.4-8.3 (m, 1H, CH), 8.0-7.9 (m, 1H, CH), 7.64 (d, ³*J*_{H-H} = 2.2, 1H, CH), 7.2-7.1 (m, 1H, CH), 7.1-7.0 (m, 2H, CH), 6.8-6.7 (m, 1H, CH), 6.5-6.4 (m, 1H, CH), 6.4-6.2 (m, 1H, CH), 5.9-5.8 (m, 1H, CH), 5.7-5.6 (m, 1H, CH), 3.77 (s, 3H, NCH₃). ¹³C{¹H} + HMBC + HSQC NMR (125.76 MHz, CD₂Cl₂, 298 K): δ 163.2 (d, ²*J*_{C-F} = 6.6, Cq), 162.5 (assigned indirectly through HSQC, CF), 162.5 (s, NCN), 160.5 (assigned indirectly through HSQC, CF), 151.0 (s, CH), 149.4 (d, ³*J*_{C-F} = 7.0, Cq), 147.0 (s, CH), 138.2 (s, CH), 132.3 (s, CH), 129.4 (s, Cq), 128.2 (s, CH), 128.1 (br, Cq), 123.4 (d, ⁴*J*_{C-F} = 21.5, CH), 122.8 (s, CH), 122.7 (s, CH), 118.1 (dd, d, ²*J*_{C-F} = 17.6, ⁴*J*_{C-F} = 2.7, CH), 116.3 (s, CH), 111.3 (s, CH), 97.6 (dd, ²*J*_{C-F} = 27.2, ²*J*_{C-F} = 27.2, CH), 36.1 (s, NCH₃). One resonance is not observed due to overlapping. ¹⁹F{¹H} NMR (282.33 MHz, CD₂Cl₂, 298 K): δ -110.1 (d, ⁴*J*_{H-H} = 9.9, 1F, CF), -110.7 (d, ⁴*J*_{H-H} = 9.9, 1F, CF).

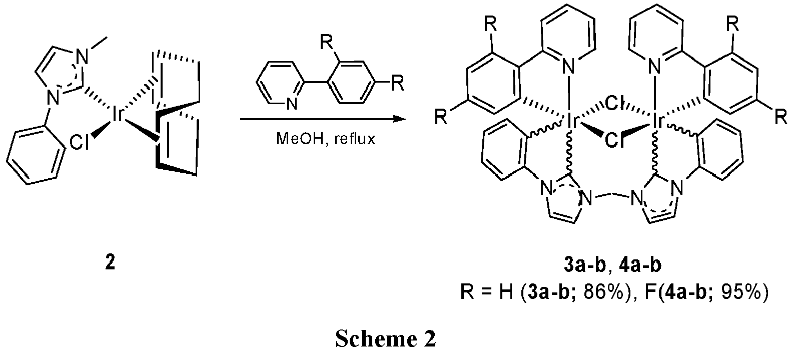

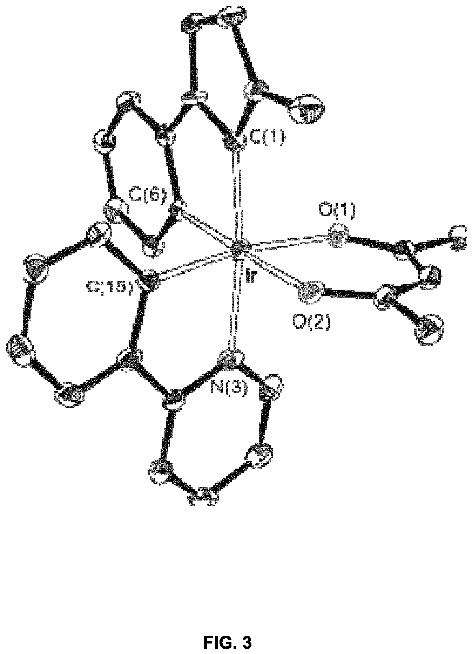

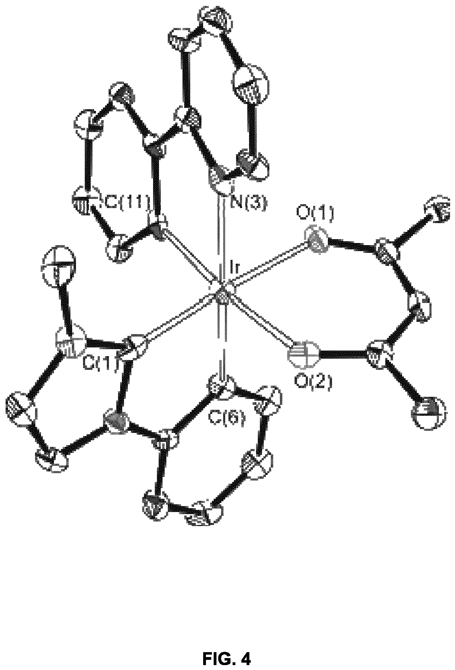

**Preparation of Ir(acac)(*κ*²-*C*_{aryl},*C*_{NHC})(ppy) (5a and 5b).** THF (15 mL) was added to a mixture of [Ir(µ-Cl)(*κ*²-*C*_{aryl},*C*_{NHC})(ppy)]₂ (**3a-b**) (400 mg, 0.37 mmol) and Kacac (112 mg, 0.81 mmol) and the yellow suspension was stirred for 90 minutes at 60 °C. The resulting yellow solution was concentrated to dryness. The resulting residue was dissolved in the minimal amount of dichloromethane and was purified by chromatography (silicagel 230-400 mesh, CH₂Cl₂/toluene 1/10 as eluent) yielding **5a** (yellow) and **5b** (yellow) (Scheme 3). 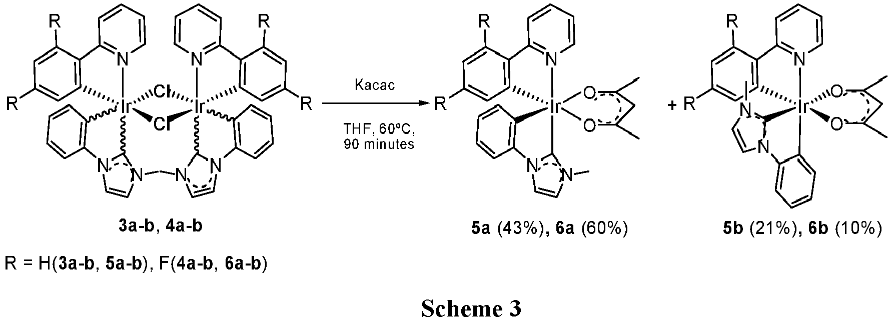
**5a**: Yield: 191.2 mg (43 %). X-ray quality crystals were grown by layering a solution of this complex in CH₂Cl₂ with pentane (Figure 1). Anal. Calcd. for C₂₆H₂₄IrN₃O₂: C, 51.81; H, 4.01; N, 6.97. Found: C, 51.63; H, 3.78; N, 6.95. ¹H NMR (400.13 MHz, CD₂Cl₂, 298 K): δ 8.5-8.4 (m, 1 H, CH), 8.0-7.9 (m, 1H, CH), 7.9-7.8 (m, 1H, CH), 7.6-7.5 (m, 1H, CH), 7.47 (m, 1H, CH), 7.4-7.2 (m, 1H, CH), 7.1-7.0 (m, 2H, CH), 6.9-6.7 (m, 2H, CH), 6.7-6.6 (d, 1H, CH), 6.6-6.4 (d, 1H, CH), 6.3-6.2 (m, 1H, CH), 6.3-6.2 (m, 1H, CH), 5.30 (s, 3H, CH acac), 3.80 (s, 3H, NCH₃), 1.84 (m, 3H, CH₃ acac), 1.68 (m, 3H, CH₃ acac). ¹³C{¹H} + HMBC + HSQC NMR (100.61 MHz, CD₂Cl₂, 298K): δ 185.5 (s, CO acac), 185.2 (s, CO acac), 166.4 (s, Cq), 164.8 (s, NCN), 148.8 (s, Cq), 147.5 (s, Cq), 147.1 (s, CH), 146.1 (s, Cq), 138.2 (s, CH), 138.0 (s, CH), 134.6 (s, CH), 131.5 (s, Cq), 129.6 (s, CH), 124.4 (s, CH), 124.2 (s, CH), 122.5 (s, CH), 121.6 (s, CH), 121.5 (s, CH), 121.0 (s, CH), 119.2 (s, CH), 115.2 (s, CH), 110.6 (s, CH), 101.4 (s, CH acac), 35.6 (s, NCH₃), 28.8 and 28.4 (both s, both CH₃ acac). **FIG. 3** shows ORTEP diagram of complex **5a** (50% probability ellipsoids). Hydrogen atoms are omitted for clarity. Selected bond lengths (Å) and angles (deg): Ir-C(1) = 1.990(5), Ir-C(6) = 2.018 (5), Ir-C(15) = 1.989(5), Ir-N(3) = 2.097(4), Ir-O(2) = 2.139(3), Ir-O(1) = 2.155(3), C(1)-Ir-C(6) = 79.7(2), C(15)-Ir-N(3) = 80.4(19), O(2)-Ir-O(1) = 88.18(13).
**5b**: Yield: 93.0 mg (21 %). X-ray quality crystals were grown by layering a solution of this complex in CH₂Cl₂ with pentane (Figure 2). Anal. Calcd. for C₂₆H₂₄IrN₃O₂: C, 51.81; H, 4.01; N, 6.97. Found: C, 51.95; H, 4.15; N, 6.81. HRMS (electrospray, *m*/*z*) calcd for C₂₆H₂₄IrN₃O₂[M]⁺: 603.1498; found: 603.1493. ¹H NMR (400.13 MHz, CD₂Cl₂, 298 K): δ 8.6-8.5 (m, 1H, CH), 8.0-7.9 (m, 1H, CH), 7.9-7.8 (m, 1H, CH), 7.7-7.6 (m, 1H, CH), 7.4-7.3 (m, 2H, CH), 7.4-7.3 (m, 1H, CH), 7.3-7.2 (m, 1H, CH), 7.2-7.1 (m, 1H, CH), 7.1-6.9 (m, 1H, CH), 6.9-6.8 (m, 2H, CH), 6.7-6.6 (d, 2H, CH), 6.5-6.4 (m, ¹H, CH), 5.25 (s, 3H, CH acac), 2.96 (s, 3H, NCH₃), 1.79 (m, 3H, CH₃ acac), 1.73 (m, 3H, CH₃ acac). ¹³C{¹H} + HMBC + HSQC NMR (100.61 MHz, CD₂Cl₂, 298 K): δ 184.0 (s, CO acac), 183.9 (s, CO acac), 166.4 (s, Cq), 154.0 (s, NCN), 148.0 (s, Cq), 147.8 (s, CH), 145.7 (s, Cq), 144.7(s, Cq), 143.4 (s, Cq), 138.5 (s, CH), 138.0 (s, CH), 134.1 (s, CH), 129.1 (s, Cq), 124.8 (s, CH), 124.2 (s, CH), 122.4 (s, 2CH), 121.7 (s, CH), 121.4 (s, CH),119.5 (s, CH), 114.8 (s, CH), 110.7 (s, CH), 101.0 (s, CH acac), 35.4 (s, NCH₃), 28.7 and 28.4 (both s, CH₃ acac). **FIG. 4** shows. ORTEP diagram of complex **5b** (50% probability ellipsoids). Hydrogen atoms are omitted for clarity. Selected bond lengths (Å) and angles (deg): Ir-C(1) = 1.938(10), Ir-C(6) = 2.074 (9), Ir-C(11) = 1.991(9), Ir-N(3) = 2.125(8), Ir-O(2) = 2.197(6), Ir-O(1) = 2.114(6), C(1)-Ir-C(6) = 79.4(4), C(11)-Ir-N(3) = 79.4(3), O(2)-Ir-O(1) = 88.8(2).

**Preparation of Ir(acac)(*κ*²-*C*_{aryl},*C*_{NHC})(dfppy) (6a and 6b).** THF (15 mL) was added to a mixture of [IrCl(*κ*²-*C*_{aryl},*C*_{NHC})(dfppy)]₂ (**4a-b**) (400 mg, 0.35 mmol) and Kacac (105.8 mg, 0.77 mmol) and the resulting yellow suspension was stirred at 60°C for 90 minutes. The resulting yellow solution was concentrated to dryness. The resulting residue was dissolved in the minimal amount of dichloromethane and was purified by chromatography (silicagel 230-400 mesh, CH₂Cl₂/toluene 1/10 as eluent) yielding **6a** (yellow) and **6b** (yellow). **6a**: Yield: 268.5 mg (60 %). Anal. Calcd. for C₂₆H₂₂F₂IrN₃O₂: C, 48.89; H, 3.47; N, 6.58. Found: C, 48.67; H, 3.24; N, 6.55. ¹H NMR (400.13 MHz, CD₂Cl₂, 298 K): δ 8.5-8.4 (m, 1H, CH), 8.3-8.2 (m, 1H, CH), 7.9-7.8 (m, 1H, CH), 7.48 (d, ³*J*_{H-H} = 2.1, 1H, CH), 7.4-7.3 (m, 1H, CH), 7.4-7.2 (m, 1H, CH), 7.1-7.0 (m, 2H, CH), 6.9-6.7 (m, 2H, CH), 6.6-6.5 (m, 1H, CH), 6.4-6.2 (m, 1H, CH), 6.2-6.1 (m, 1H, CH), 5.9-5.7 (m, 1H, CH), 5.31 (s, 1H, CH acac), 3.80 (s, 3H, NCH₃), 1.83 (m, 3H, CH₃ acac), 1.69 (m, 3H, CH₃ acac). ¹³C{¹H} + HMBC + HSQC NMR (100.61 MHz, CD₂Cl₂, 298K): δ 185.6 (s, CO acac), 185.4 (s, CO acac), 163.8 (s, NCN), 163.3 (d, ²*J*_{C-F} = 6.6, Cq), 163.2 (dd, ¹*J*_{C-F} = 254.8, ³*J*_{C-F} = 13.6, CF), 161.3 (dd, ¹*J*_{C-F} = 254.8, ³*J*_{C-F} = 13.6, CF), 153.1 (d, ²*J*_{C-F} = 6.7, Cq), 148.6 (s, Cq), 147.1 (s, CH), 138.6 (s, CH), 134.6 (s, CH), 130.4 (s, Cq), 129.0 (dd, ³*J*_{C-F} = 3.1, ³*J*_{C-F} = 3.1, Cq), 124.4 (s, CH), 123.3 (d, ⁴*J*_{C-F} = 20.5, CH), 122.5 (s, CH), 122.0(s, CH), 121.9 (s, CH), 119.8(dd, d, ²*J*_{C-F} = 16.3, ⁴*J*_{C-F} = 2.8, CH), 115.4 (s, CH), 110.9 (s, CH), 101.5 (s, CH acac), 97.0 (dd, ²*J*_{C-F} = 27.2, ²*J*_{C-F} = 27.2, CH), 35.6 (s, NCH₃), 28.7 and 28.4 (both s, CH₃ acac). ¹⁹F{¹H} NMR (282.33 MHz, CD₂Cl₂, 298 K): δ -110.9 (d, ⁴*J*_{F-F} = 9.8, IF, CF), -111.2 (d, ⁴*J*_{F-F} = 9.8, IF, CF). **6b**: Yield: 45.2 mg (10 %). Anal. Calcd. for C₂₆H₂₂F₂IrN₃O₂: C, 48.89; H, 3.47; N, 6.58. Found: C, 48.57; H, 3.52; N, 6.89. ¹H NMR (300.13 MHz, CD₂Cl₂, 298 K): δ 8.6-8.5 (m, 1H, CH), 8.4-8.2 (m, 1 H, CH), 7.9-7.8 (m, 1H, CH), 7.38 (m, ³*J*_{H-H} = 2.1, 1H, CH), 7.4-7.2 (m, 2H, CH), 7.3-7.1 (d, ³*J*_{H-H} =2.1, 1H, CH), 7.2-7.0 (m, 1H, CH), 7.0-6.9 (m, 1H, CH), 6.68 (d, ³*J*_{H-H} = 2.1, 1H, CH), 6.32 (ddd, ³*J*_{H-F} = 13.1, ³*J*_{H-F} = 9.2, ⁴*J*_{H-H} = 2.4, 1H, CH), 5.90 (dd, ³*J*_{H-F} = 9.3, ⁴*J*_{H-H} = 2.4, 1H, CH), 5.26 (s, 1H, CH acac), 2.98 (s, 3H, NCH₃), 1.78 (m, 3H, CH₃ acac), 1.74 (m, 3H, CH₃ acac). ¹³C{¹H} + HMBC + HSQC NMR (75.47 MHz, CD₂Cl₂, 298 K): δ 184.2 (s, CO acac), 184.2 (s, CO acac), 163.4 (d, ²*J*_{C-F} = 6.5, Cq), 152.9 (s, NCN), 150.8 (d, ²*J*_{C-F} = 7.2, Cq), 147.8 (s, CH), 142.6 (s,Cq) 138.5 (s, CH), 134.1 (s, CH), 129.6 (br, Cq), 125.6 (s, Cq), 125.1 (s, CH), 123.6 (d, ⁴*J*_{C-F} = 20.9, CH), 122.5 (s, CH), 122.3 (s, CH), 121.6 (s, CH), 120.1 (dd, d, ²*J*_{C-F} = 16.4, ⁴*J*_{C-F} = 2.8, CH), 115.0 (s, CH), 111.1 (s, CH), 101.1 (s, CH acac), 97.2 (dd, ²*J*_{C-F} = 27.3, ²*J*_{C-F} = 27.3, CH), 35.5 (s, NCH₃), 28.6 and 28.4 (both s, CH₃ acac).A CF resonance is not observed due to low solubility of the complex. ¹⁹F{¹H} NMR (282.33 MHz, CD₂Cl₂, 298 K): δ -111.0 (d, ⁴*J*_{F-F} = 9.7, IF, CF), - 111.4 (d, ⁴*J*_{F-F} = 9.7, 1F, CF).

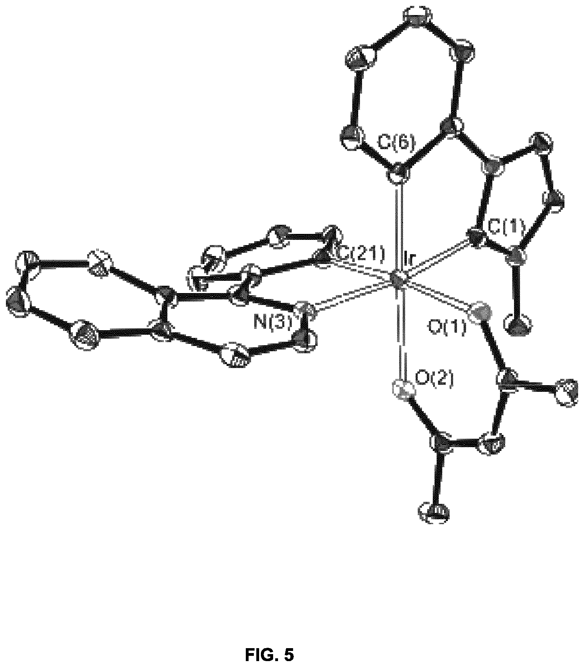

**Preparation of Ir(acac)(*κ*²-*C*_{aryl},*C*_{NHC})(2-phenylisoquinolinate) (7a and 7b).** A yellow suspension of IrCl(PhMeIm)(COD) (**1**) (500 mg, 1.01 mmol) and 2-phenylisoquinoline (207.3 mg, 1.01 mmol) in methanol (12 mL) was refluxed for five days in MeOH. The suspension became red and the resulting solid was decanted and washed with MeOH (3x2 mL) and 357.0 mg of the red solid were obtained. The ¹H NMR spectrum of the red solid shows an undefined mixture of at least four compounds. Further purification was not possible. From this point, two different methods were followed. **Method a (Scheme 4):** A red suspension of the red solid in THF (12 mL) in the presence of Kacac (92.2 mg, 0.666 mmol) was stirred at 60 °C for 90 minutes. The resulting red solution was concentrated to dryness and purified by column chromatography (silicagel 230-400 mesh column with toluene with a gradual increase of the polarity with CH₂Cl₂) yielding **7a** (red) and **7b** (orange). Yield: **7a:** 93.4 mg (14.2 %), **7b:** 43.7 (7 %). **Method b:** THF (8 mL) and a Kacac solution in MeOH (3.46 mL, 0.258 M) were added to the resulting red solid. The red suspension was stirred for 90 minutes at 60 °C and then it was concentrated to dryness. The resulting residue was dissolved in the minimal amount of dichloromethane and purified by chromatography column (silicagel 230-400 mesh column with toluene with a gradual increase of the polarity with CH₂Cl₂). **7a:** Yield: 260 mg (40 %). 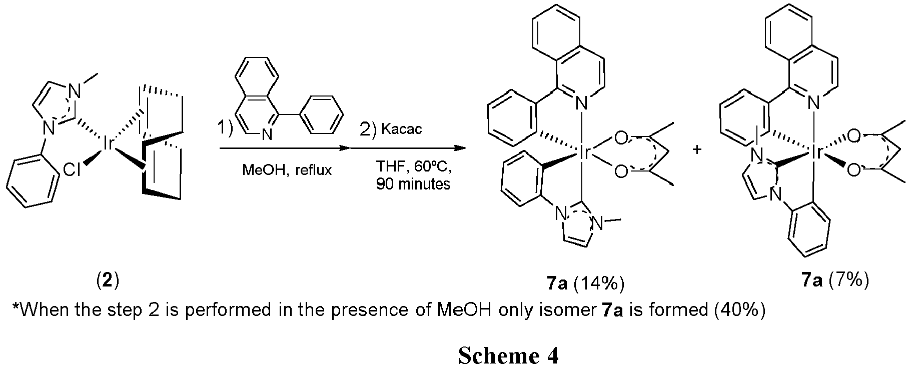
**7a:** X-ray quality crystals were grown by layering a solution of this complex in CH₂Cl₂ with pentane (Figure 3). Anal. Calcd. for C₃₀H₂₆IrN₃O₂: C, 55.20; H, 4.02; N, 6.44. Found: C, 54.87; H, 3.66; N, 6.46. HRMS (electrospray, *m*/*z*) calcd for C₃₀H₂₆IrN₃O₂ [M]⁺: 653.1650; found: 653.1652. ¹H NMR (300.13 MHz, CD₂Cl₂, 298 K): δ 9.0-8.9 (m, 1 H, CH), 8.4-8.3 (m, 1H, CH), 8.2-8.1 (m, 1H, CH), 8.0-7.9 (m, 1H, CH), 7.8-7.6 (m, 3H, CH), 7.49 (d,³*J*_{H-H} = 2.1, 1H, CH), 7.06 (d, ³*J*_{H-H} = 2.1, 1H, CH), 7.1-7.0 (m, 1H, CH), 7.0-6.8 (m, 1H, CH), 6.8-6.6 (m, 2H, CH), 6.5-6.4 (m, 2H, CH), 6.2-6.1 (m, 1H, CH), 5.3 (s, 3H, CH acac), 3.83 (s, 3H, NCH₃), 1.86 (m, 3H, CH₃ acac), 1.65 (m, 3H, CH₃ acac). ¹³C{¹H} + HMBC + HSQC NMR (75.47 MHz, CD₂Cl₂, 298 K): δ 185.6 (s, CO acac), 185.3 (s, CO acac), 167.4 (s, Cq), 165.4 (s, NCN), 151.6 (s, Cq), 148.8 (s, Cq), 146.7 (s, Cq), 139.4 (s, CH), 138.5 (s, CH), 138.2 (s, Cq), 135.0 (s, CH), 131.6 (s, Cq), 131.2 (s, CH), 130.5 (s, CH), 129.6 (s, CH), 128.2 (s, CH), 127.9 (s, CH), 127.8 (s, CH), 126.8 (s, Cq), 124.2 (s, CH), 121.8 (s, CH), 121.6 (s, CH), 120.7 (s, CH), 120.6 (s, CH), 115.2 (s, CH), 110.7 (s, CH), 101.5 (s, CH acac), 35.7 (s, NCH₃), 28.9 and 28.4 (both s, both CH₃acac).**FIG. 5** shows ORTEP diagram of complex **7a** (50% probability ellipsoids). Hydrogen atoms are omitted for clarity. Selected bond lengths (Å) and angles (deg): Ir-C(1) = 1.982(3), Ir-C(21) = 1.985(3), Ir-C(6) = 2.013(3), Ir-N(3) = 2.101(2), Ir-O(2) = 2.149(2), Ir-O(1) = 2.155(2), C(1)-Ir-C(6) = 79.49(12), C(21)-Ir-N(3) = 79.83(11), O(2)-Ir-O(1) = 87.82(8).
**7b:** Anal. Calcd. for C₃₀H₂₆IrN₃O₂: C, 55.20; H, 4.02; N, 6.44. Found: C, 54.94; H, 3.69; N, 6.14. ¹H NMR (300.13 MHz, CD₂Cl₂, 298 K): δ 9.0-8.9 (m, 1 H, CH), 8.5-8.4 (m, 1H, CH), 8.2-8.1 (m, 1H, CH), 8.0-7.9 (m, 1H, CH), 7.8-7.7 (m, 2H, CH), 7.7-7.6 (m, 1H, CH), 7.39 (d, ³*J*_{H-H} = 2.1, 1H, CH), 7.4-7.3 (m, 1H, CH), 7.3-7.2 (m, 1H, CH), 7.1-7.0 (m, 1H, CH), 7.0-6.8 (m, 2H, CH), 6.7-6.6 (m, 2H, CH), 6.6-6.4 (m, 1H, CH), 5.19 (s, 1H, CH acac), 2.98 (s, 3H, NCH₃), 1.80 (m, 3H, CH₃ acac), 1.64 (m, 3H, CH₃ acac). ¹³C{¹H} + HMBC + HSQC NMR (75.47 MHz, CD₂Cl₂, 298 K): δ 184.1 (s, CO acac), 184.0 (s, CO acac), 167.2 (s, Cq), 154.6 (s, NCN), 148.1 (s, Cq), 147.7 (s, Cq), 147.3 (s, Cq), 144.0 (s, Cq), 140.0 (s, CH), 138.7 (s, CH), 138.1 (s, Cq), 134.2 (s, CH), 131.1 (s, CH), 130.2 (s, CH), 128.8 (s, CH), 128.2 (s, CH), 127.9 (s, CH), 127.9 (s, CH), 127.0 (s, Cq), 124.8 (s, CH), 121.9 (s, CH), 121.3 (s, CH), 120.9 (s, CH), 120.4 (s, CH), 114.9 (s, CH), 110.9 (s, CH), 100.9 (s, CH acac), 35.6 (s, NCH₃), 28.7 and 28.3 (both s, both CH₃ acac). 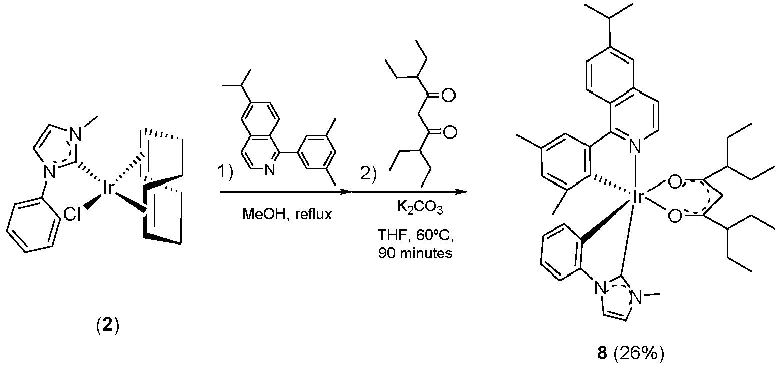
Ir Carbene COD **(2)** (3.50 g, 7.07 mmol) was solubilized in MeOH (88 ml) and then 1-(3,5-dimethylphenyl)-6-isopropylisoquinoline (1.95 g, 7.07 mmol) was added and the reaction was stirred at reflux for 5 days. The solvents were distilled off and 15mL of MeOH was added. The precipitate was filtered and the product was used as is. The Ir(III) Dimer (2.50 g, 3.24 mmol) was solubilized in THF (50 mL). In a separate flask 3,7-diethylnonane-4,6-dione (1.38 g, 6.49 mmol) in MeOH (24 mL) was treated with K₂CO₃ (1.00 g, 7.14 mmol). The Diketone salt solution was then added to the Dimer Mixture and heated to 60 °C overnight. An orange product crashed out overnight. Dichloromethane was added to the mixture and it was filtered over a pad of Celite. The solvent were distilled off, methanol was added and the precipitate was filtered off. The crude product was purified via column chromatography (silica treated with TEA) using Heptanes/DCM (90/10) as the solvent system. The target product **(8)** was afforded as an orange powder (0.70 g, 26%).

### Device Experimental Results

All example devices were fabricated by high vacuum (<10-7 Torr) thermal evaporation. The anode electrode was 1150 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H2O and O2) immediately after fabrication, and a moisture getter was incorporated inside the package. The organic stack of the device examples consisted of sequentially, from the ITO surface, 100Å of LG101 (purchased from LG chem) as the hole injection layer (HIL); 450 Å of HTM as a hole transporting layer (HTL); 400 Å of an emissive layer (EML) containing Compound H as a host (, a stability dopant (SD) (18%), and Comparative Compound 1 or Compound 7a as the emitter (3%); and 350 Å of Liq (8-hydroxyquinoline lithium) doped with 40% of ETM as the ETL. The emitter was selected to provide the desired color, efficiency and lifetime. A stability dopant (SD) was added to the electron-transporting host to help transport positive charge in the emissive layer. The Comparative Example device was fabricated similarly to the device examples except that Comparative Compound 1 was used as the emitter in the EML. **FIG. 1** shows the schematic device structure. Table 1 shows the device layer thickness and materials.

The chemical structures of the materials used in the device are shown below.

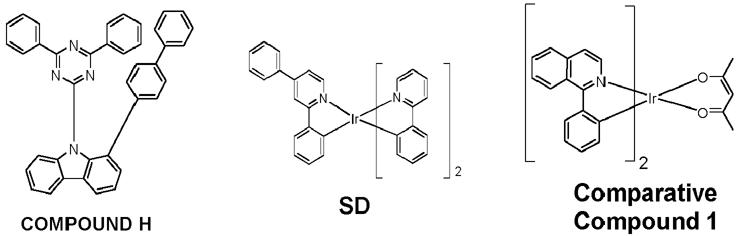

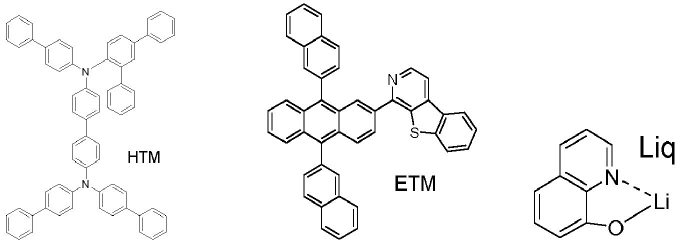

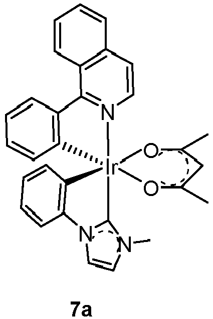

The device performance data are summarized in Table 2. At 1000 nits; compound 7a has lower voltage than comparative example 1; compound 7a also has higher luminance efficiency (24.2 cd/A *vs* 15.1 cd/A) and power efficiency (22.1 lm/w *vs* 13 lm/w) than comparative example 1. By introducing NHC carbene as an ancillary ligand; it show higher luminance efficiency and power efficiency. Moreover; the sublimation temperature of compound 7a is much lower than comparative example 1; it demonstrate the potential for this IrL1L2L3 approach to increase manufacturability.

**Table 1. Device layer materials and thicknesses**

| Layer | Material | Thickness [Å] |
|---|---|---|
| Anode | ITO | 1200 |
| HIL | LG101 (LG Chem) | 100 |
| HTL | HTM | 450 |
| EML | Compound H: SD 18%:Emitter 3% | 400 |
| ETL | Liq: ETM 40% | 350 |
| EIL | Liq | 10 |
| Cathode | A1 | 1000 |

**Table 2. Performance of the devices with examples of red emitters.**

| | 1931 CIE | | | | at 1,000 nits | | | |
|---|---|---|---|---|---|---|---|---|
| Compound 3% | X | y | λ max [nm] | FWHM [nm] | Voltage [V] | LE [cd/A] | EQE [%] | PE [lm/W] |
| 7a | 0.616 | 0.382 | 608 | 90 | 3.4 | 24.2 | 17.5 | 22.1 |
| Comparative Compound 1 | 0.665 | 0.334 | 626 | 80 | 3.6 | 15.1 | 17.6 | 13.0 |

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

**Further preferred embodiments are described below:**
1. A compound having a formula M(L_{A})ₓ(L_{B})_{y}(L_{C})_{z}:
   wherein the ligand L_{A} is 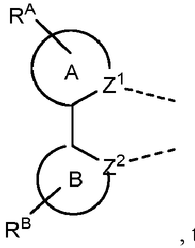 the ligand L_{B} is 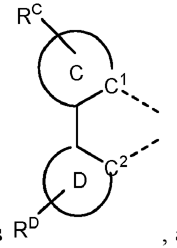 and the ligand Lc is 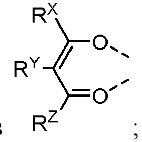
   wherein M is a metal having an atomic number greater than 40;
   wherein x is 0, 1, or 2;
   wherein y is 1, 2, or 3;
   wherein z is 0, 1, or 2;
   wherein x+y+z is the oxidation state of the metal M;
   wherein L_{A} is different from L_{B}, and when x, y, or z is larger than 1, each plurality of L_{A}, L_{B}, or L_{C} are also different;
   wherein rings A, B, C, and D are each independently a 5 or 6-membered carbocyclic or heterocyclic ring;
   wherein R^{A}, R^{B}, R^{C}, and R^{D} each independently represent mono substitution up to the maximum possible number of substitutions, or no substitution;
   wherein Z¹ and Z² are each independently selected from the group consisting of carbon or nitrogen;
   wherein C¹ is an anionic donor carbon atom, C² is a neutral carbene carbon atom;
   wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein any adjacent substituents are optionally joined or fused into a ring.
2. The compound of embodiment 1, wherein M is selected from the group consisting of Ir, Rh, Re, Ru, Os, Pt, Au, and Cu.
3. The compound of embodiment 1, wherein M is Ir or Pt.
4. The compound of embodiment 1, wherein Z¹ is a neutral donor nitrogen atom, Z² is an anionic donor carbon atom.
5. The compound of embodiment 1, wherein rings A, B, and C are 6-membered aromatic rings, and ring D is a 5-member aromatic rings.
6. The compound of embodiment 1, wherein Rings B and C are benzene.
7. The compound of embodiment 1, wherein the compound is selected from the group consisting of: Ir(L_{A})(L_{B})(L_{C}), Ir(L_{A})(L_{B})₂, Ir(L_{A})₂(L_{B}), Pt(L_{A})(L_{B}), and Pt(L_{B})₂.
8. The compound of embodiment 1, wherein the ligand L_{A} is selected from the group consisting of: 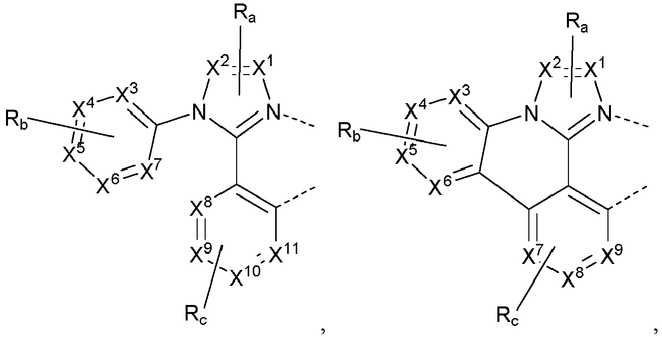 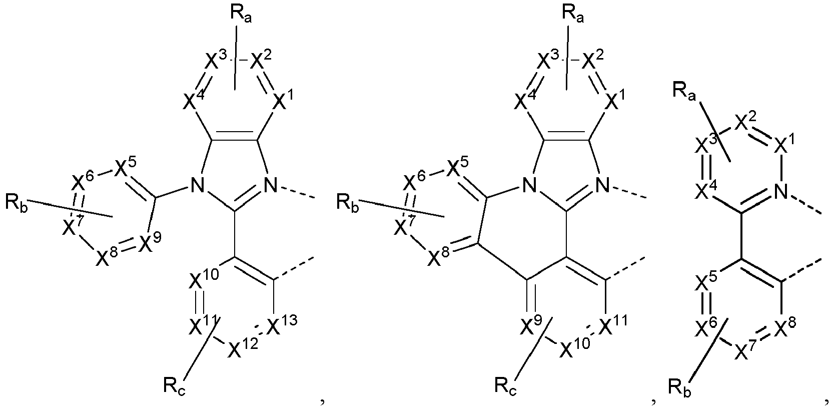 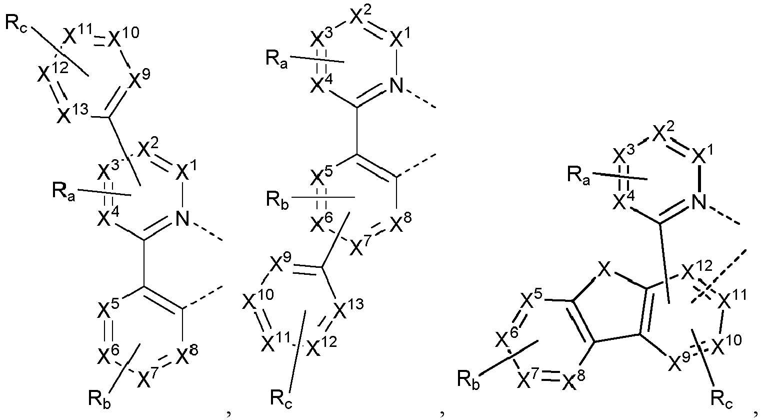 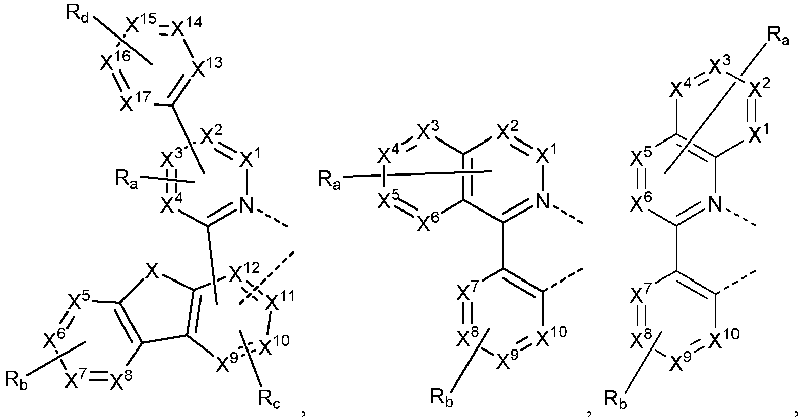 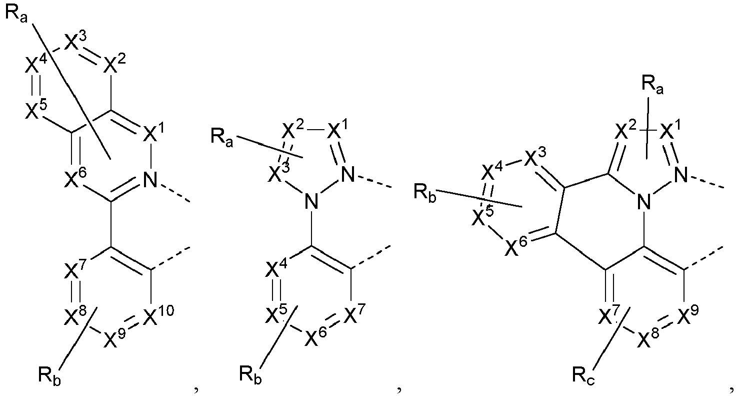 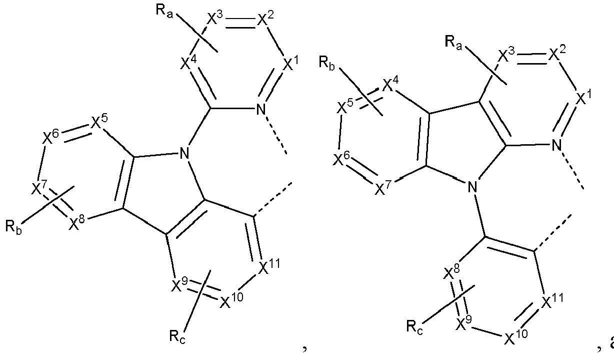 and 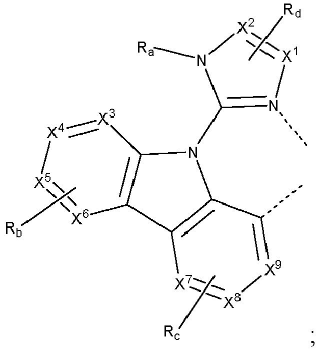
   wherein each X¹ to X¹⁷ are independently selected from the group consisting of carbon and nitrogen;
   wherein X is selected from the group consisting of BR', NR', PR', O, S, Se, C=O, S=O, SO₂, CR'R", SiR'R", and GeR'R";
   wherein R' and R" are optionally fused or joined to form a ring;
   wherein each Rₐ, R_{b}, R_{c}, and R_{d} may represent from mono substitution up to the maximum possible number of substitutions, or no substitution;
   wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein any two adjacent substituents of Rₐ, R_{b}, R_{c}, and R_{d} are optionally fused or joined to form a ring or form a multidentate ligand.
9. The compound of embodiment 1, wherein the ligand L_{B} is selected from the group consisting of: 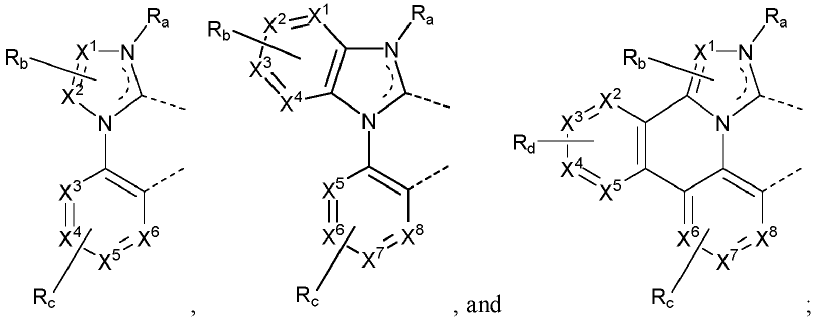
   wherein each X¹ to X⁸ are independently selected from the group consisting of carbon and nitrogen;
   wherein X is selected from the group consisting of BR', NR', PR', O, S, Se, C=O, S=O, SO₂, CR'R", SiR'R", and GeR'R";
   wherein R' and R" are optionally fused or joined to form a ring;
   wherein each Rₐ, R_{b}, R_{c}, and R_{d} may represent from mono substitution up to the maximum possible number of substitutions, or no substitution;
   wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein any two adjacent substituents of Rₐ, R_{b}, R_{c}, and R_{d} are optionally fused or joined to form a ring or form a multidentate ligand.
10. The compound of embodiment 1, wherein the ligand Lc has the formula: 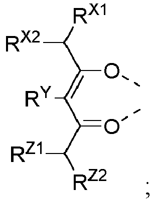
   wherein R^{X1}, R^{X2}, R^{Z1}, and R^{Z2} are independently selected from group consisting of alkyl, cycloalkyl, aryl, and heteroaryl;
   wherein at least one of R^{X1}, R^{X2}, R^{Z1}, and R^{Z2} has at least two carbon atoms.
11. The compound of embodiment 1, wherein the ligand L_{A} is selected from the group consisting of: 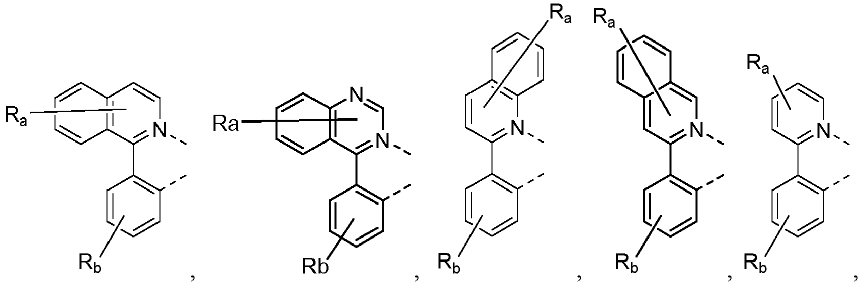 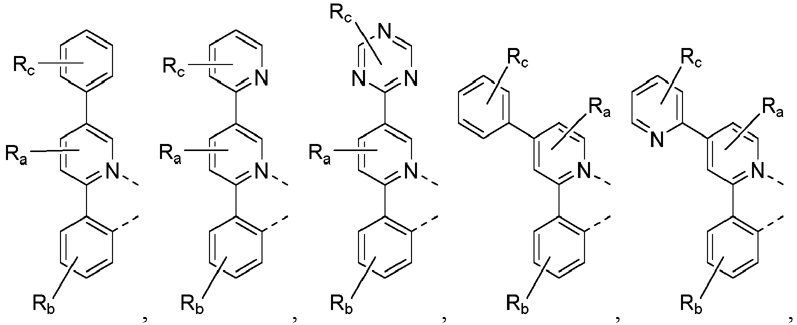 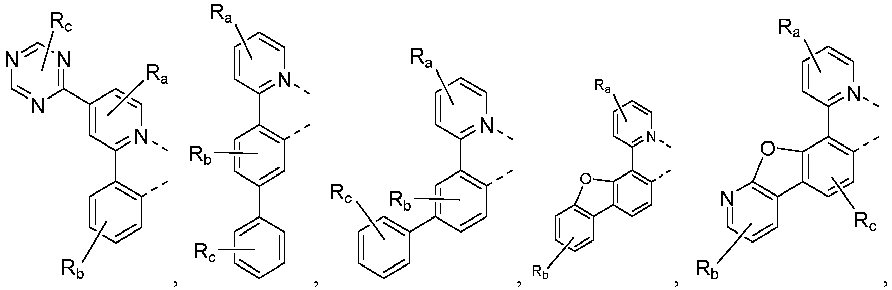 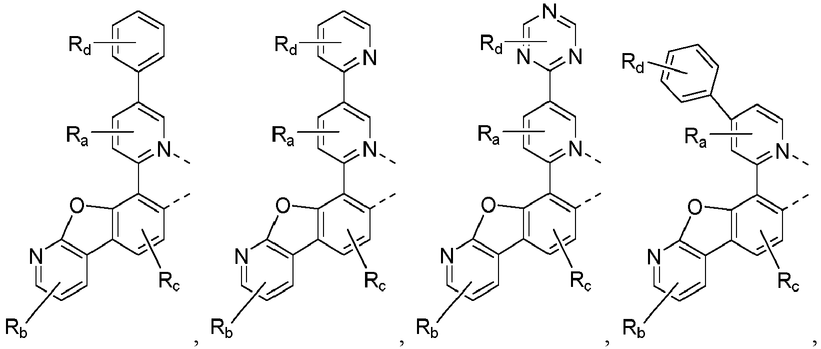 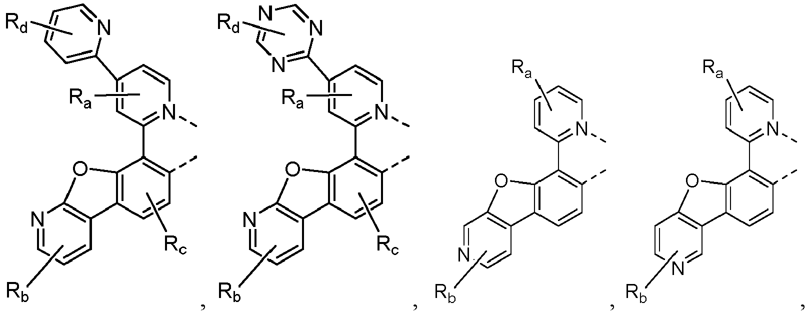 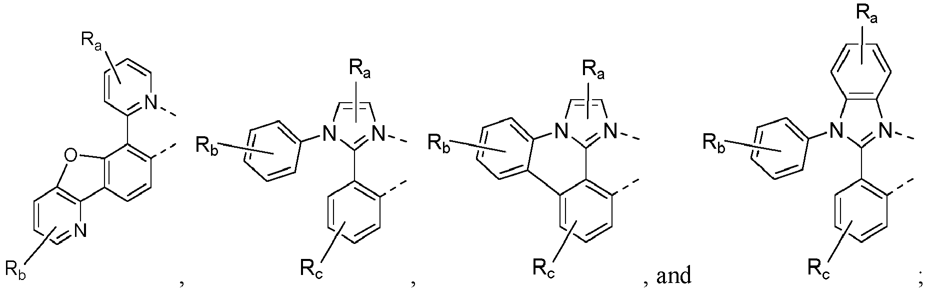
   wherein each Rₐ, R_{b}, R_{c}, and R_{d} may represent from mono substitution up to the maximum possible number of substitutions, or no substitution;
   wherein Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any two adjacent substituents of Rₐ, R_{b}, R_{c}, and R_{d} are optionally fused or joined to form a ring or form a multidentate ligand.
12. The compound of embodiment 1, wherein the ligand L_{A} is selected from the group consisting of L_{A1} to L_{A200} as described hereinbefore.
13. The compound of embodiment 1, wherein the ligand L_{B} is selected from the group consisting of: 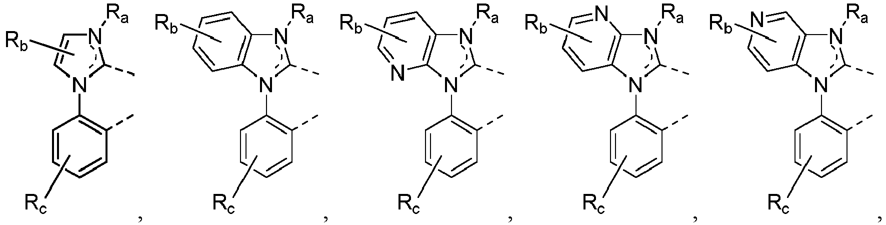 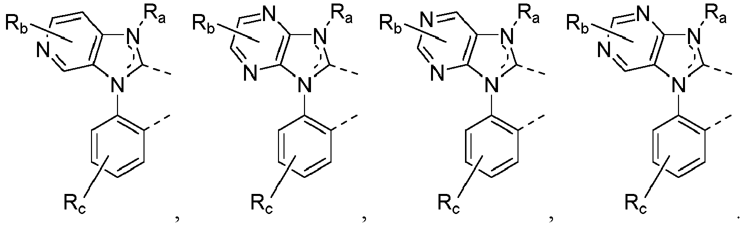 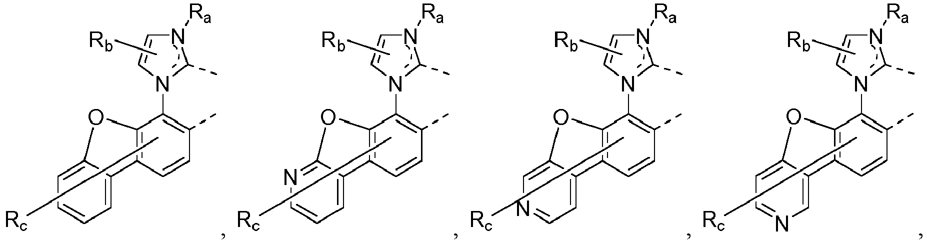 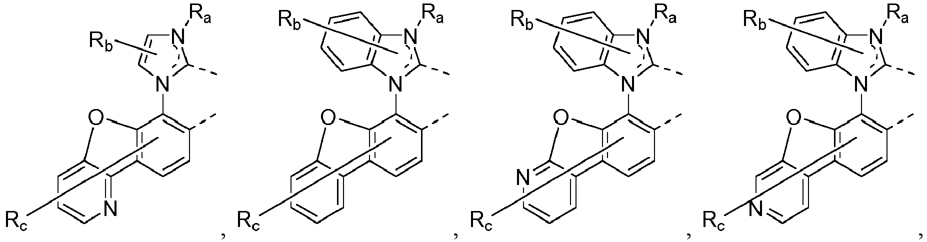 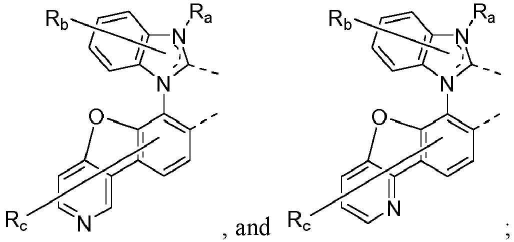
   wherein each Rₐ, R_{b}, R_{c}, and R_{d} may represent from mono substitution up to the maximum possible number of substitutions, or no substitution;
   wherein Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any two adjacent substituents of Rₐ, R_{b}, R_{c}, and R_{d} are optionally fused or joined to form a ring or form a multidentate ligand.
14. The compound of embodiment 1, wherein the ligand L_{B} is selected from the group consisting of L_{B1} to L_{B54} as described hereinbefore.
15. The compound of embodiment 1, wherein the ligand Lc is selected from the group consisting of: 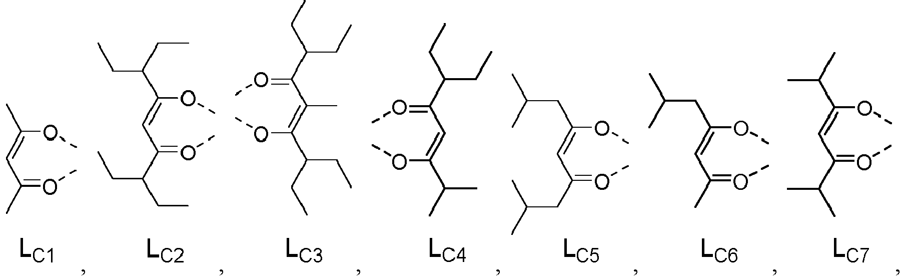 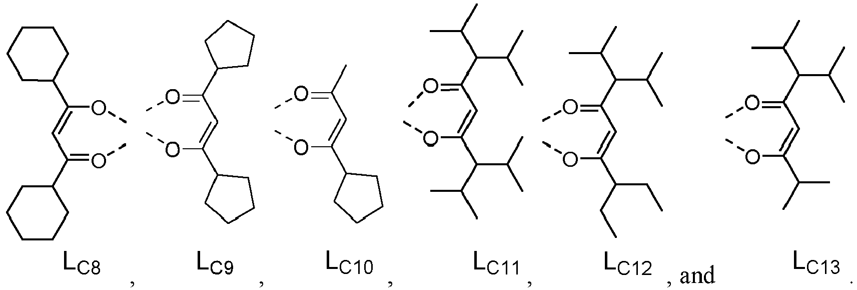
16. The compound of embodiment 12, wherein the compound is selected from the group consisting of Compound A-1 through Compound A-140,400;
   where each Compound A-x has the formula Ir(L_{A*i*})(L_{B*j*})(L_{C*k*});
   wherein x = 10,800(*k*-1)+200(*j*-1)+*i*, *i* is an integer from 1 to 200, *j* is an integer from 1 to 54; and *k* is an integer from 1 to 13;
   wherein L_{B*j*} has the structure L_{B1} to L_{B54} as described hereinbefore;
   wherein L_{C*k*} has the structure L_{C1} to L_{C13} as described hereinbefore.
17. The compound of embodiment 12, wherein the compound has the formula Ir(L_{A*i*})(L_{B*j*})(L_{B*j'*}), *j* is not equal to *j'*;
   wherein *i* is an integer from 1 to 200, *j* is an integer from 1 to 54; and *j'* is an integer from 1 to 54;
   wherein L_{B*j*} has the structure L_{B1} to L_{B54} as described hereinbefore.
18. The compound of embodiment 14, the compound has the formula Ir(L_{B*j*})(L_{B*j*'})(L_{B*j*"});
   wherein each of *j, j',* and *j*" is an integer from 1 to 54; and
   wherein *j*, *j*', and *j*" are different.
19. An organic light-emitting device (OLED) comprising:
   an anode;
   a cathode; and
   an organic layer, disposed between the anode and the cathode, comprising a compound having a formula M(L_{A})ₓ(L_{B})_{y}(L_{C})_{z}:
   wherein the ligand L_{A} is 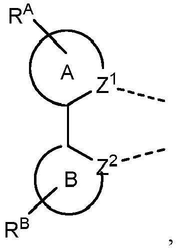 the ligand L_{B} is 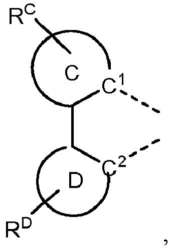 and the ligand L_{C} is 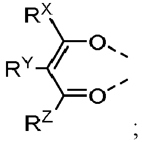
   wherein M is a metal having an atomic number greater than 40;
   wherein x is 0, 1, or 2;
   wherein y is 1, 2, or 3;
   wherein z is 0, 1, or 2;
   wherein x+y+z is the oxidation state of the metal M;
   wherein L_{A} is different from L_{B}, and when x, y, or z is larger than 1, each plurality of L_{A}, L_{B}, or L_{C} are also different;
   wherein rings A, B, C, and D are each independently a 5 or 6-membered carbocyclic or heterocyclic ring;
   wherein R^{A}, R^{B}, R^{C}, and R^{D} each independently represent mono substitution up to the maximum possible number of substitutions, or no substitution;
   wherein Z¹ and Z² are each independently selected from the group consisting of carbon or nitrogen;
   wherein C¹ is an anionic donor carbon atom, C² is a neutral carbene carbon atom;
   wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
   wherein any adjacent substituents are optionally joined or fused into a ring.
20. The OLED of embodiment 19, wherein the OLED is incorporated into a device selected from the group consisting of a consumer product, an electronic component module, and a lighting panel.
21. The OLED of embodiment 19, wherein the organic layer is an emissive layer and the compound is an emissive dopant or a non-emissive dopant.
22. The OLED of embodiment 19, wherein the organic layer further comprises a host, wherein the host comprises a triphenylene containing benzo-fused thiophene or benzo-fused furan;
   wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, and CₙH₂ₙ-Ar₁, or the host has no substitutions;
   wherein n is from 1 to 10; and
   wherein Ar₁ and Ar₂ are independently selected from the group consisting of benzene, biphenyl, naphthalene, triphenylene, carbazole, and heteroaromatic analogs thereof.
23. The OLED of embodiment 19, wherein the organic layer further comprises a host, wherein host comprises at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene.
24. The OLED of embodiment 19, wherein the organic layer further comprises a host, wherein the host is selected from the group consisting of: 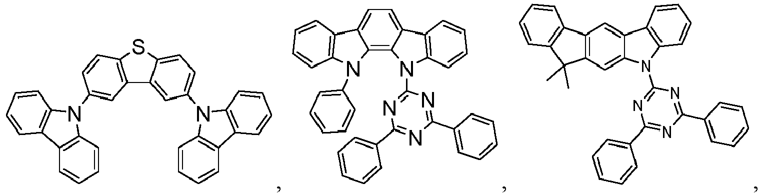 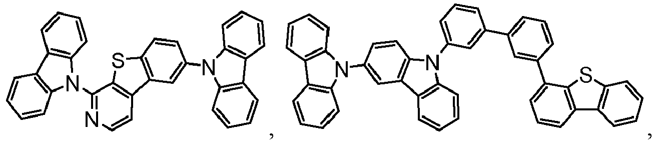 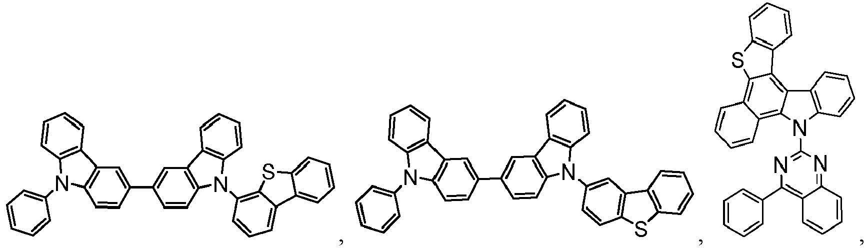 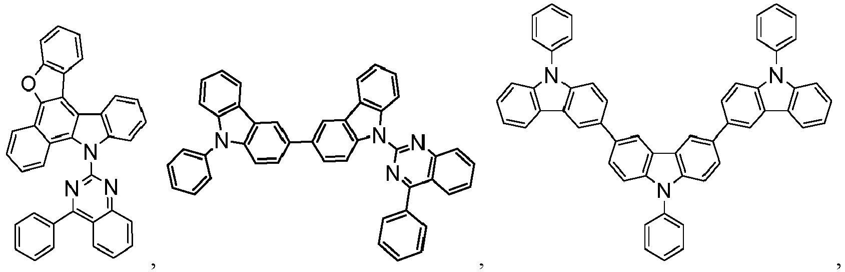 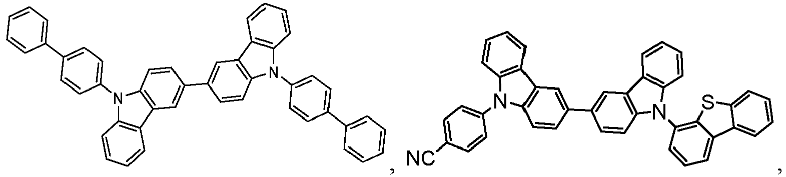 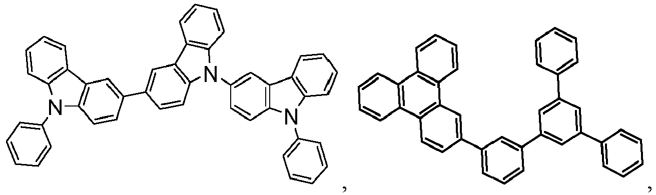 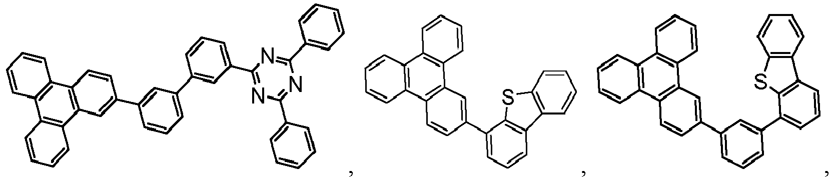 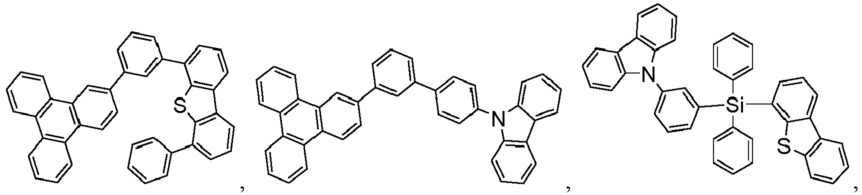 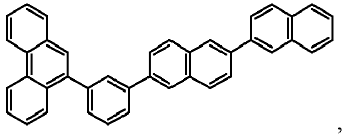 and combinations thereof.
25. The OLED of embodiment 19, wherein the organic layer further comprises a host, wherein the host comprises a metal complex.
26. A formulation comprising a compound having a formula M(L_{A})ₓ(L_{B})_{y}(L_{C})_{z}:
   wherein the ligand L_{A} is 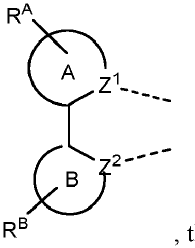 the ligand L_{B} is 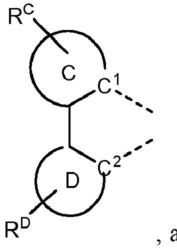 and the ligand L_{C} is 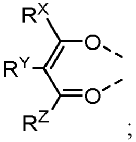
   wherein M is a metal having an atomic number greater than 40;
   wherein x is 0, 1, or 2;
   wherein y is 1, 2, or 3;
   wherein z is 0, 1, or 2;
   wherein x+y+z is the oxidation state of the metal M;
   wherein L_{A} is different from L_{B}, and when x, y, or z is larger than 1, each plurality of L_{A}, L_{B}, or L_{C} are also different;
   wherein rings A, B, C, and D are each independently a 5 or 6-membered carbocyclic or heterocyclic ring;
   wherein R^{A}, R^{B}, R^{C}, and R^{D} each independently represent mono substitution up to the maximum possible number of substitutions, or no substitution;
   wherein Z¹ and Z² are each independently selected from the group consisting of carbon or nitrogen;
   wherein C¹ is an anionic donor carbon atom, C² is a neutral carbene carbon atom;
   wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any adjacent substituents are optionally joined or fused into a ring.

## Claims

1. A phosphorescent emitter having a formula M(L_{A})ₓ(L_{B})_{y}(L_{C})_{z}:
wherein the ligand L_{A} is 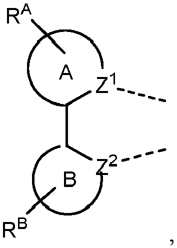 the ligand L_{B} is 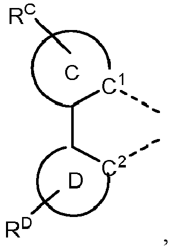 and the ligand L_{C} is 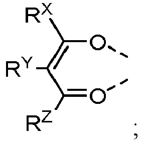
wherein M is a metal having an atomic number greater than 40;
wherein x is 0, 1, or 2;
wherein y is 1, 2, or 3;
wherein z is 0, 1, or 2;
wherein x+y+z is the oxidation state of the metal M;
wherein L_{A} is different from L_{B}, and when x, y, or z is larger than 1, each plurality of L_{A}, L_{B}, or L_{C} are also different;
wherein rings A, B, C, and D are each independently a 5 or 6-membered carbocyclic or heterocyclic ring;
wherein R^{A}, R^{B}, R^{C}, and R^{D} each independently represent mono substitution up to the maximum possible number of substitutions, or no substitution;
wherein Z¹ and Z² are each independently selected from the group consisting of carbon or nitrogen;
wherein C¹ is an anionic donor carbon atom, C² is a neutral carbene carbon atom;
wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any adjacent substituents are optionally joined or fused into a ring.

2. The phosphorescent emitter of claim 1, wherein M is selected from the group consisting of Ir, Rh, Re, Ru, Os, Pt, Au, and Cu, preferably Ir or Pt.

3. The phosphorescent emitter of claims 1 or 2, wherein the ligand L_{A} is selected from the group consisting of:

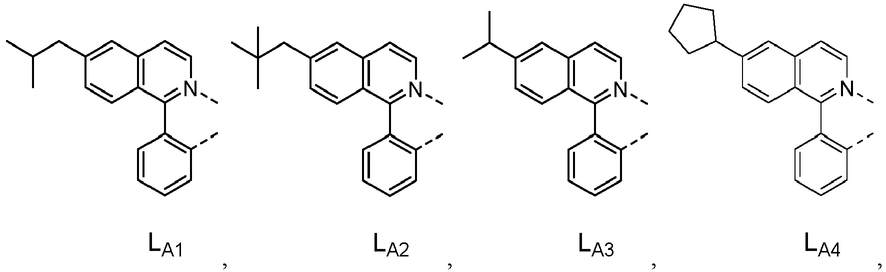

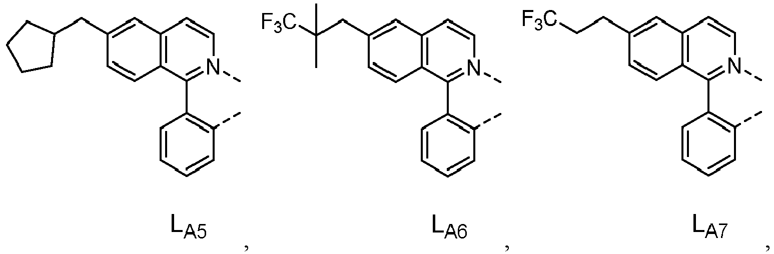

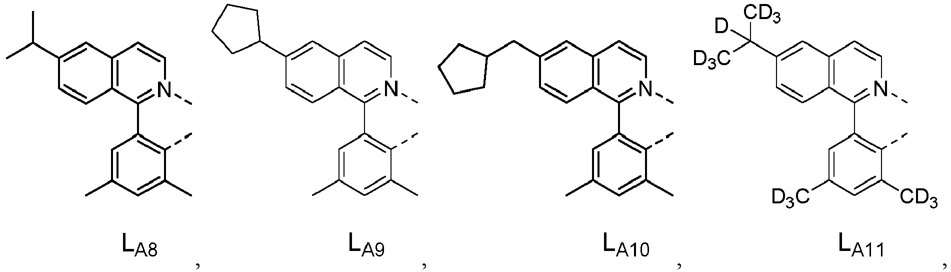

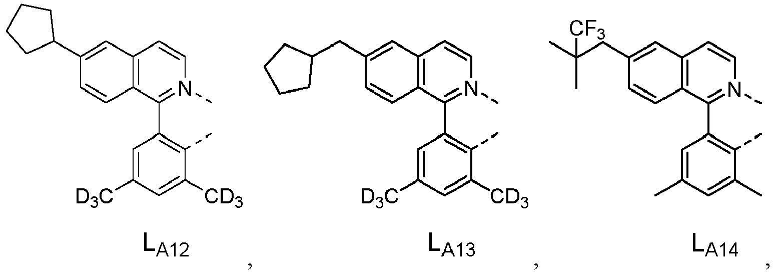

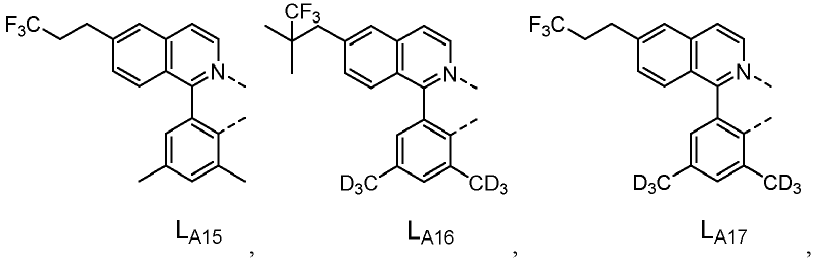

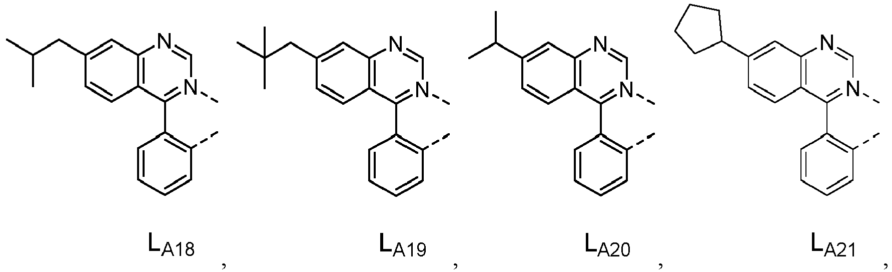

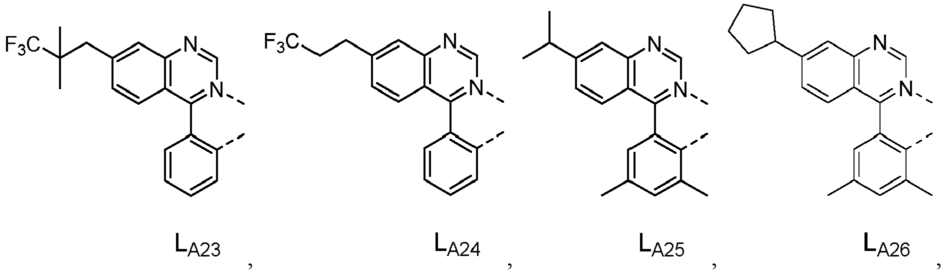

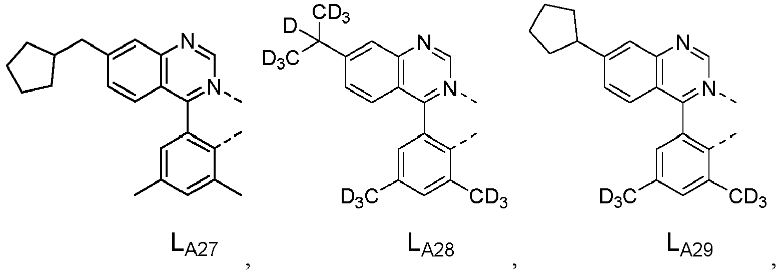

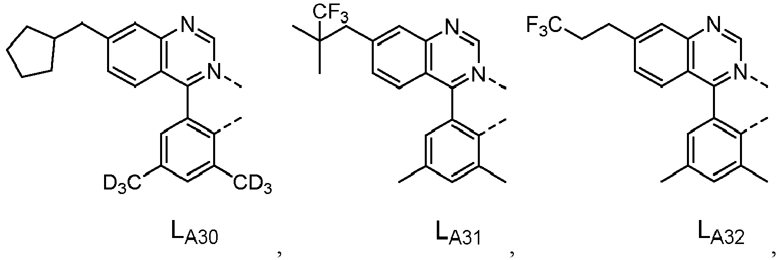

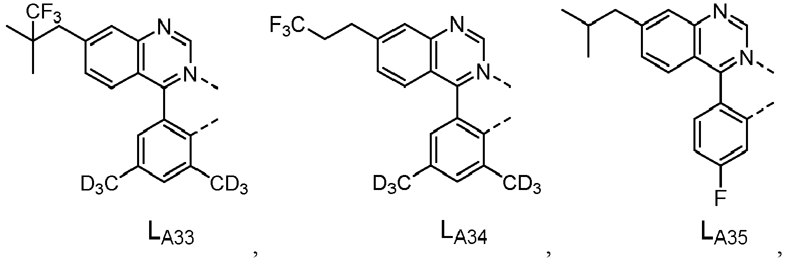

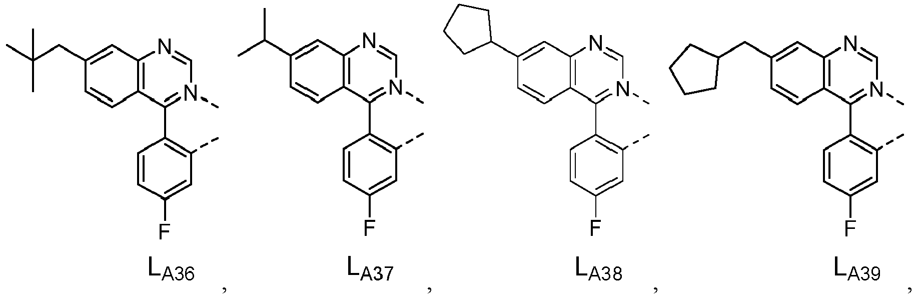

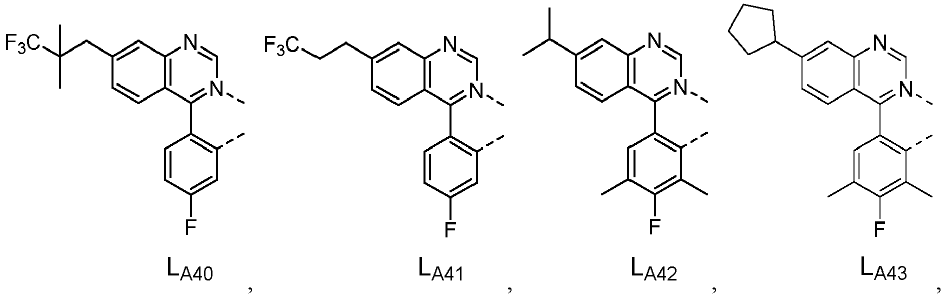

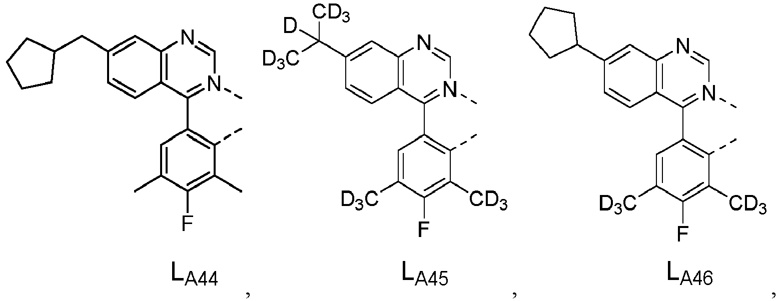

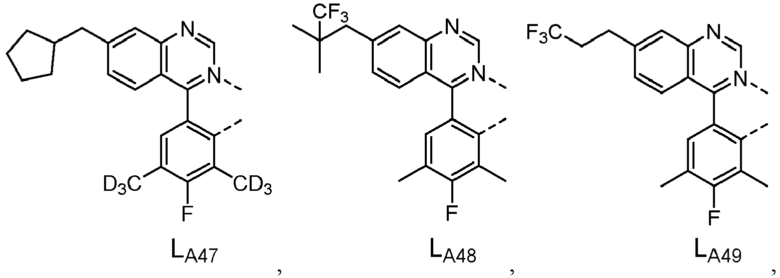

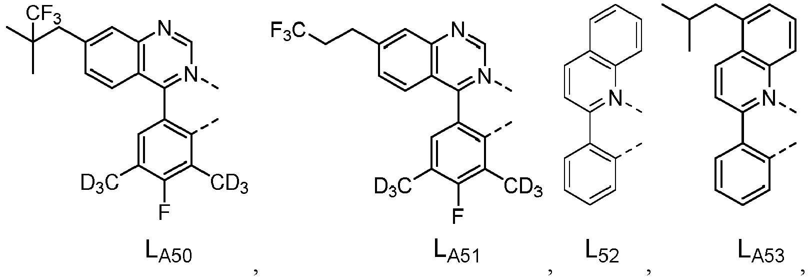

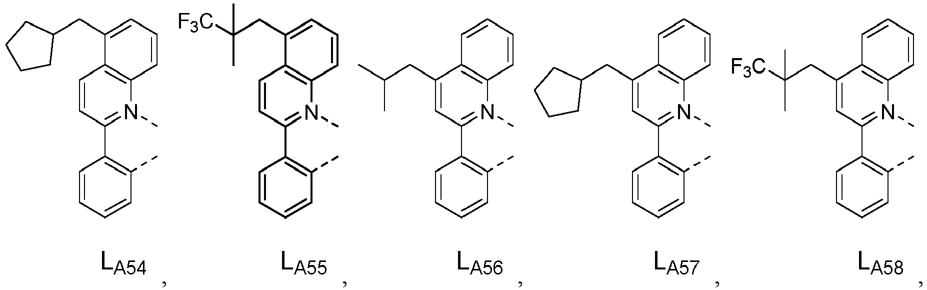

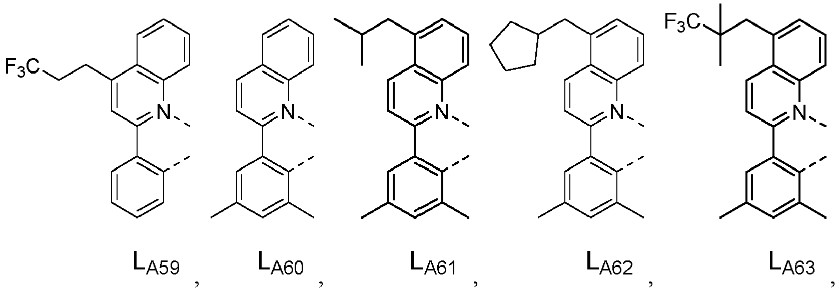

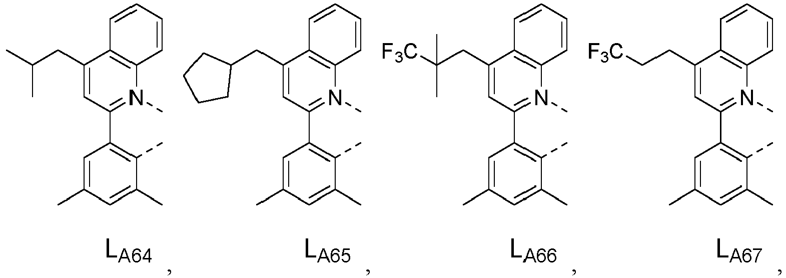

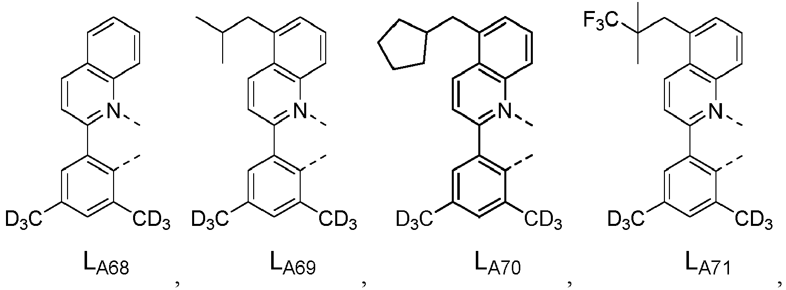

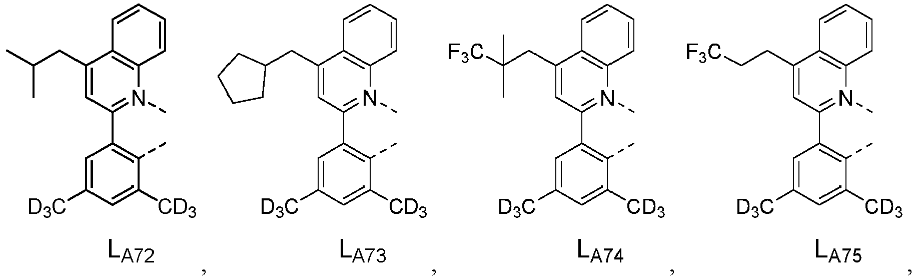

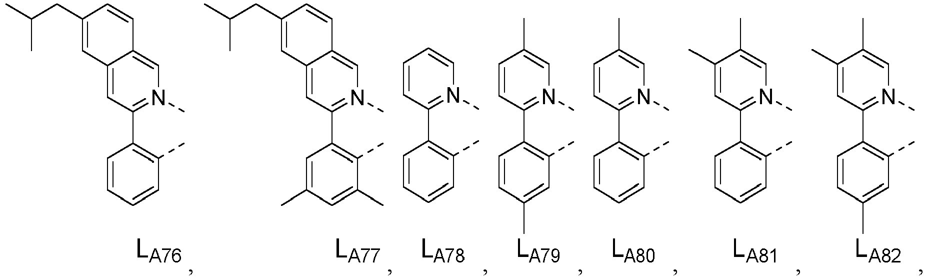

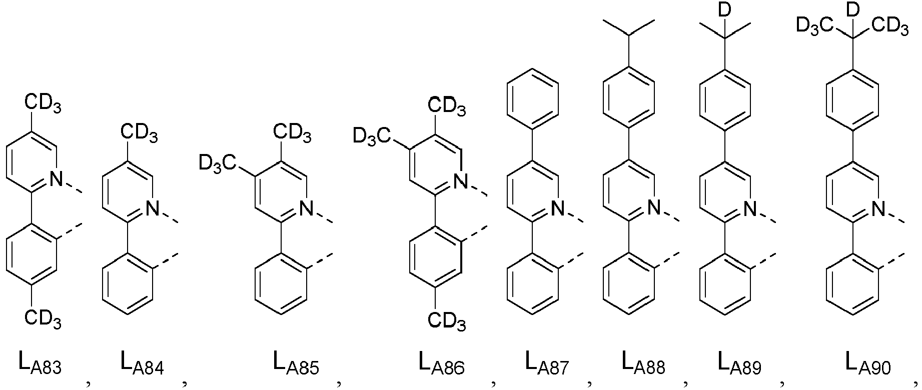

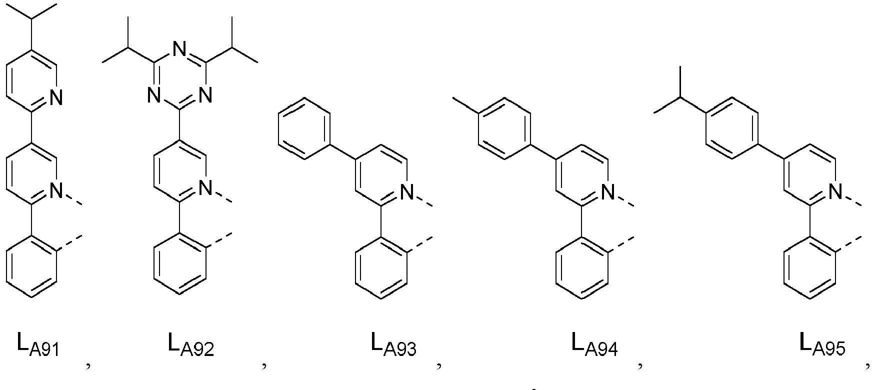

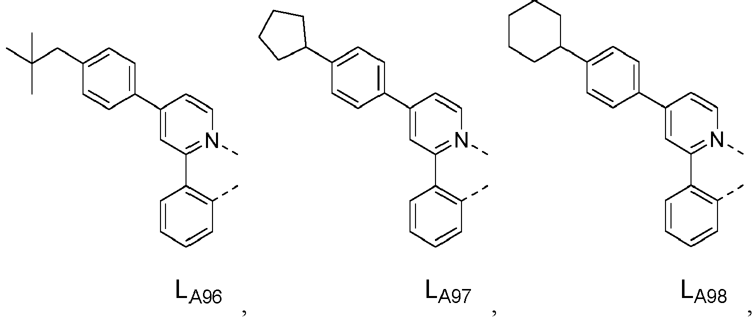

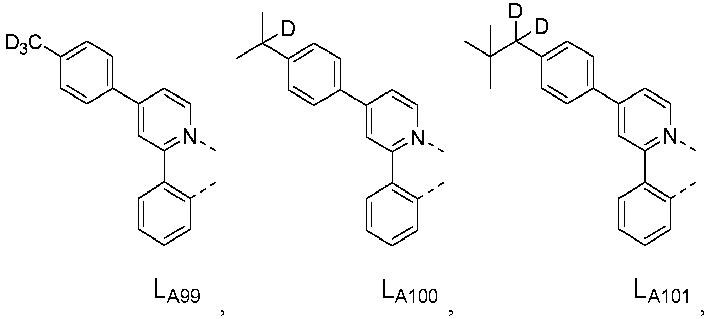

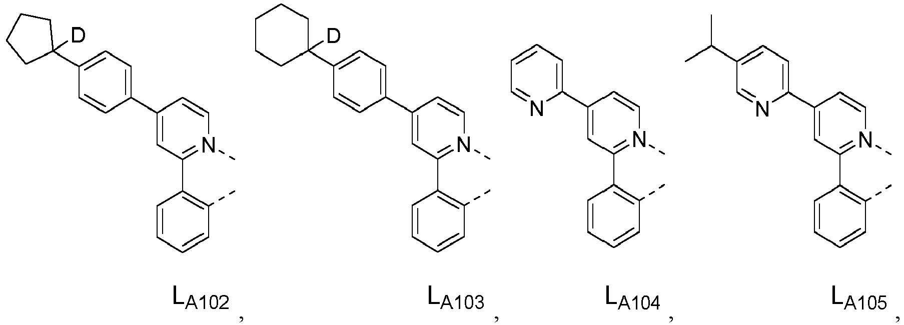

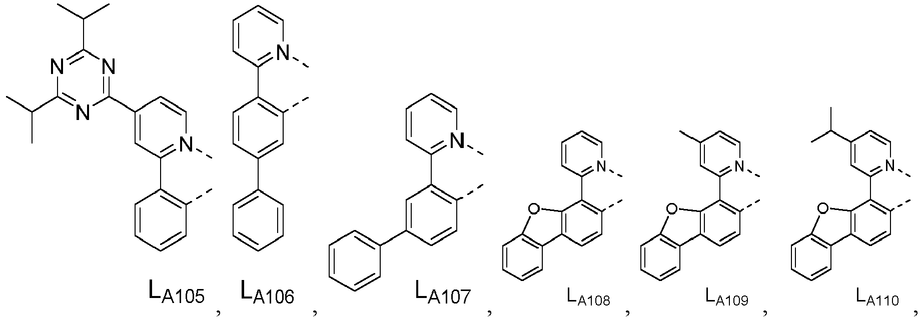

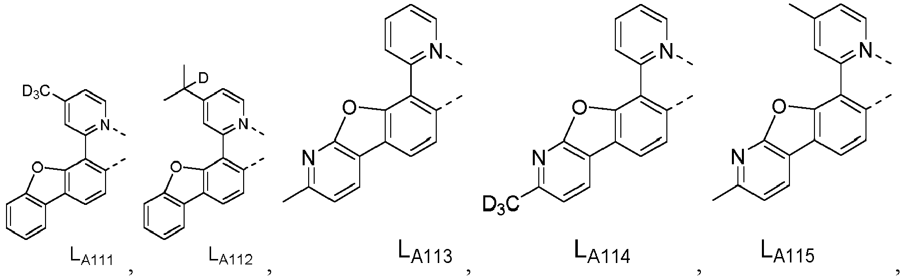

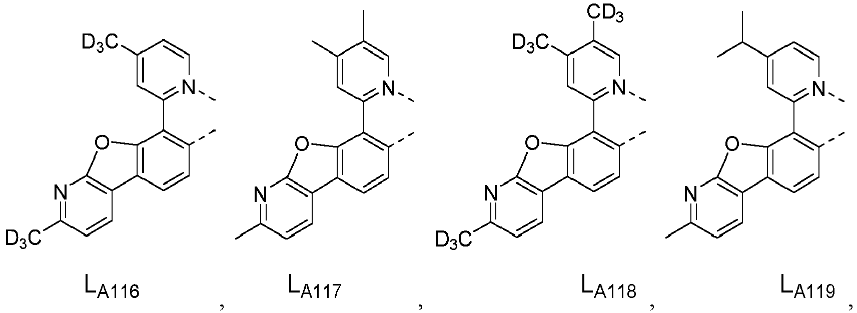

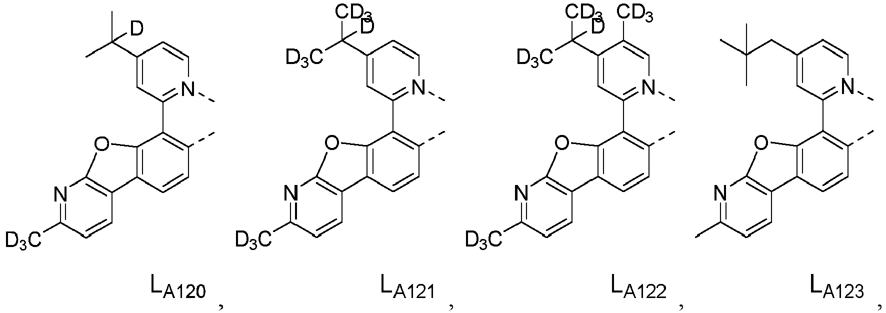

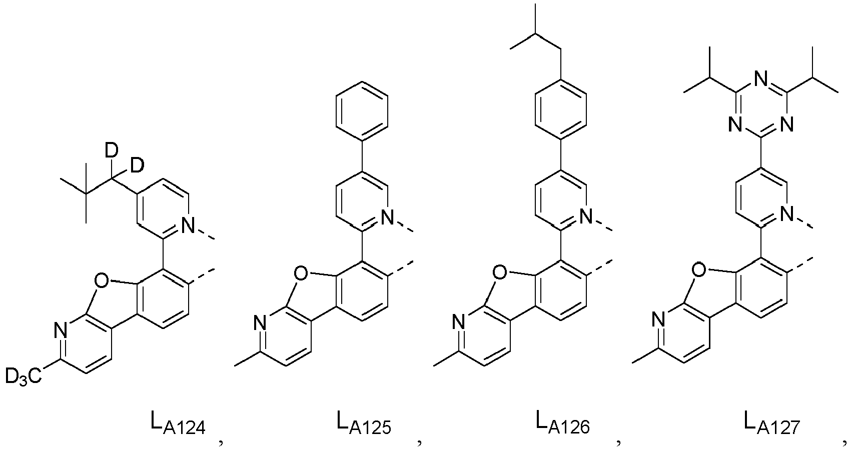

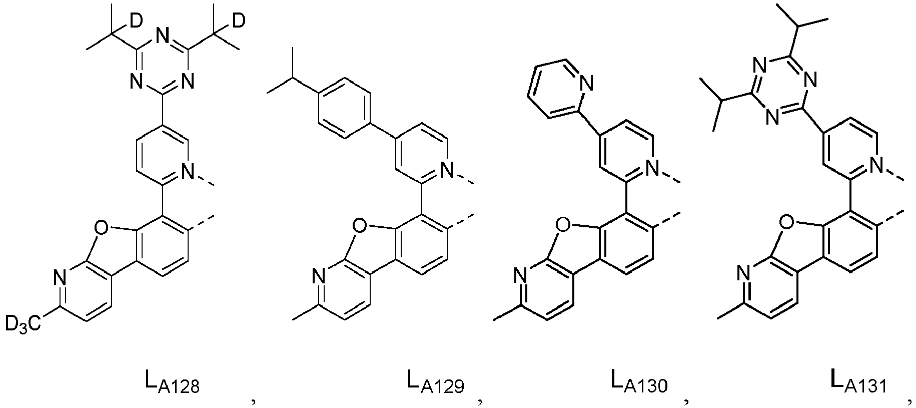

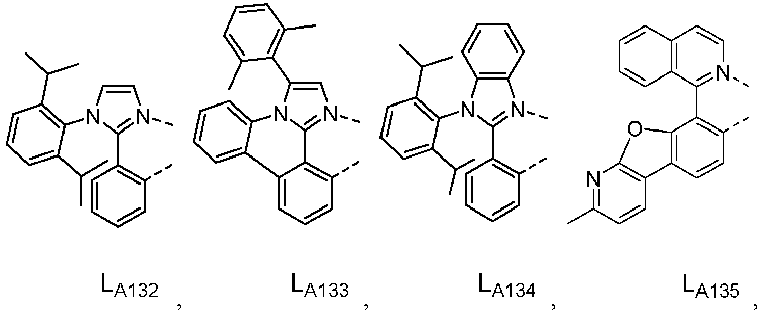

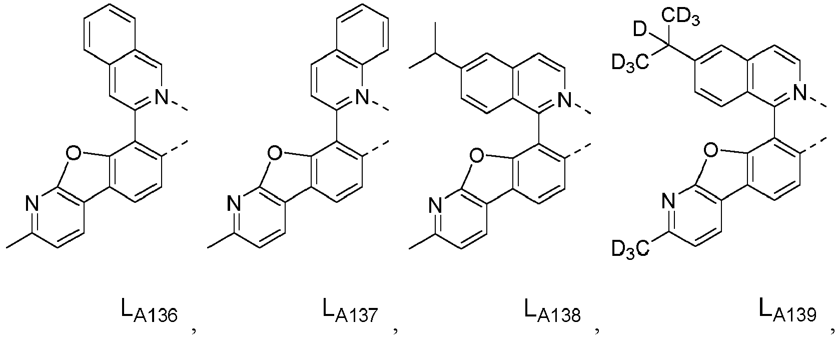

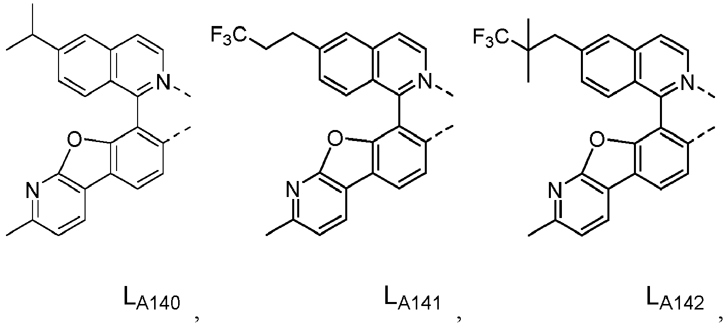

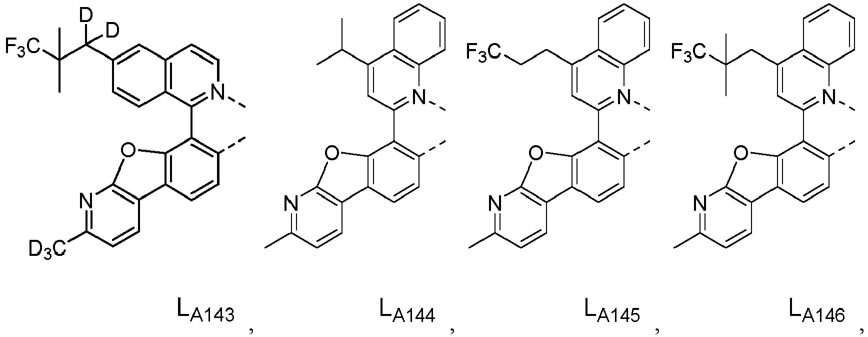

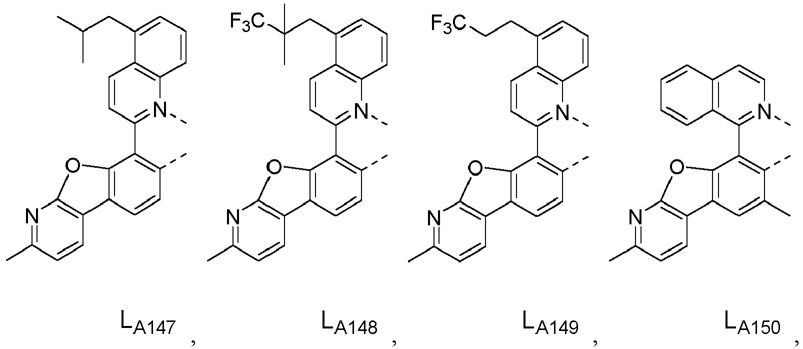

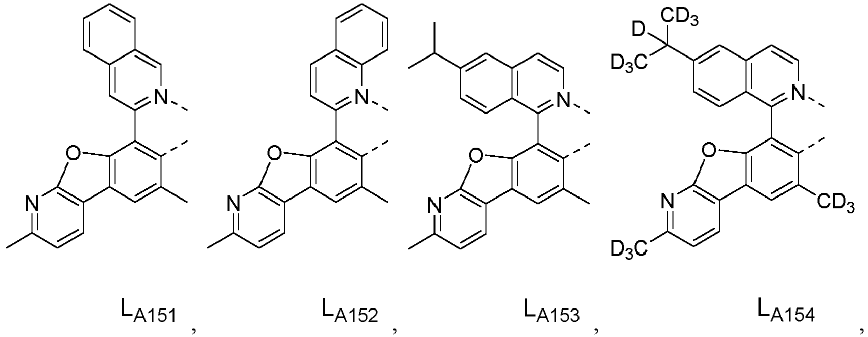

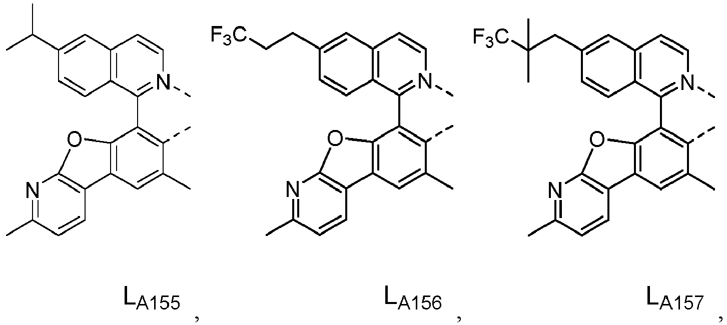

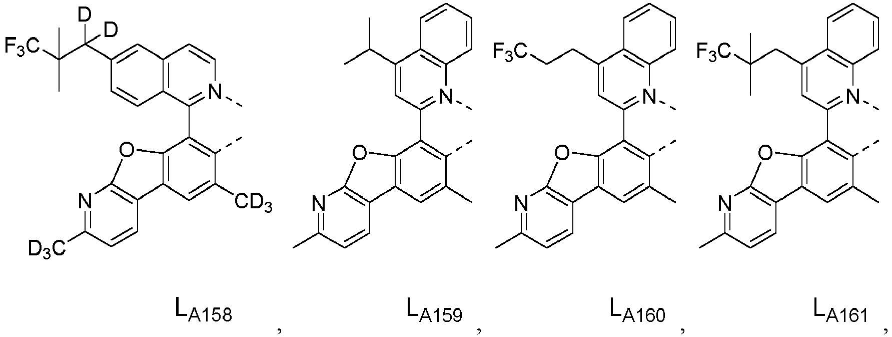

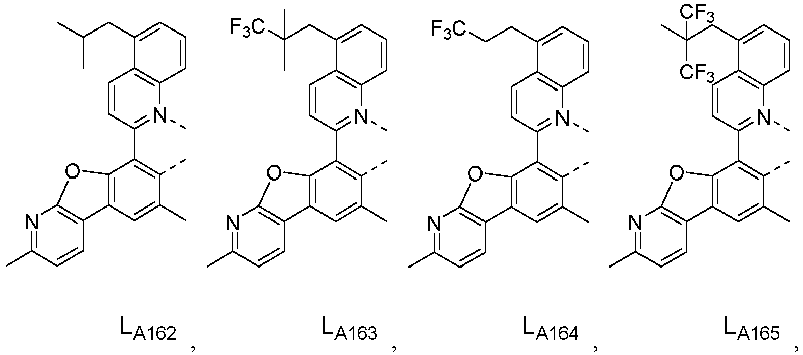

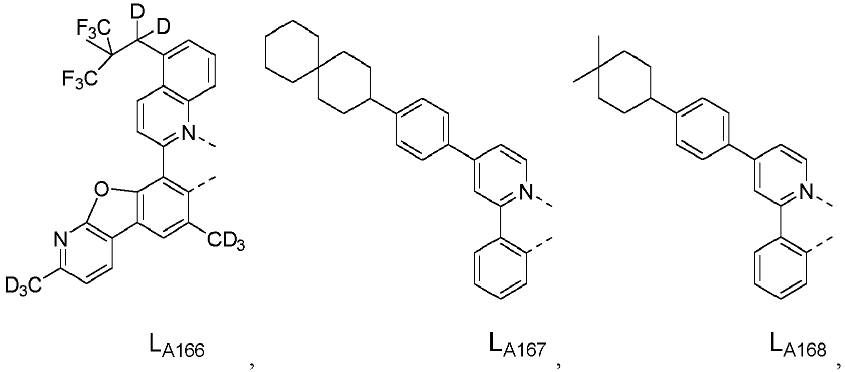

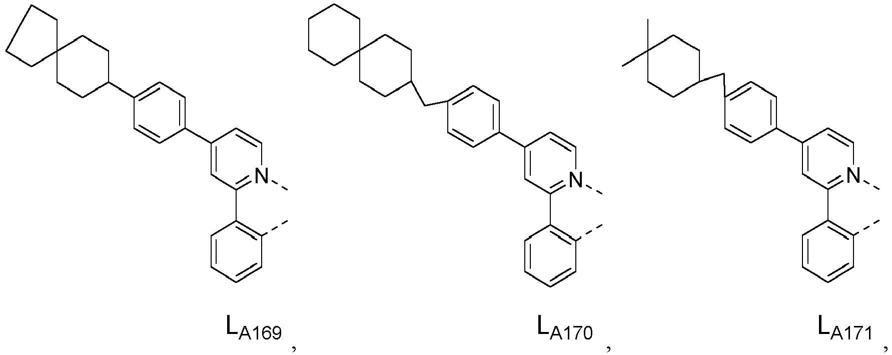

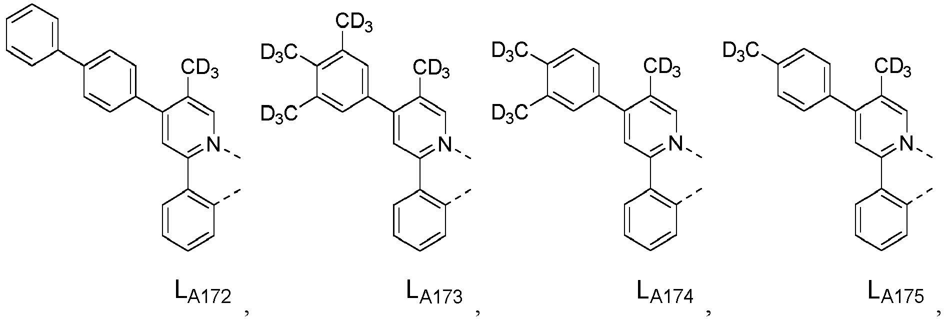

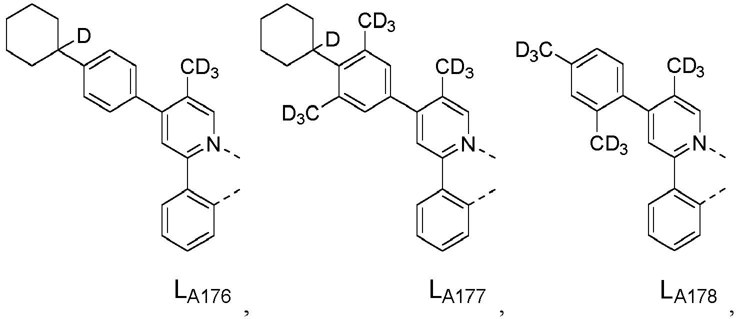

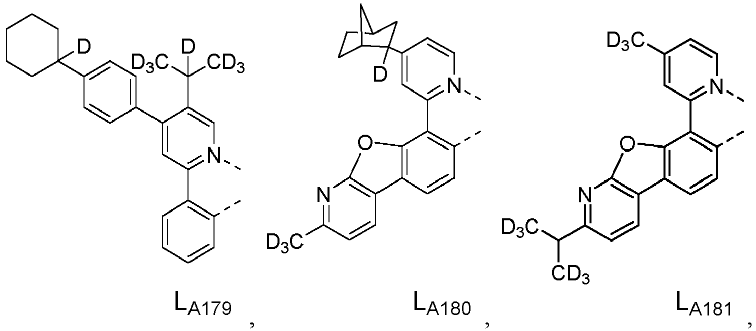

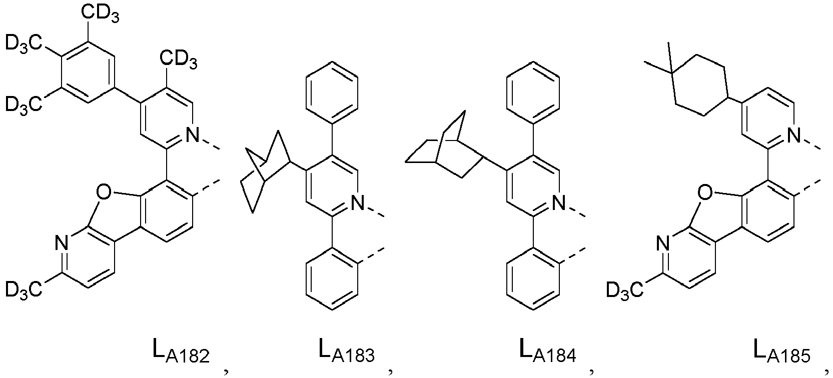

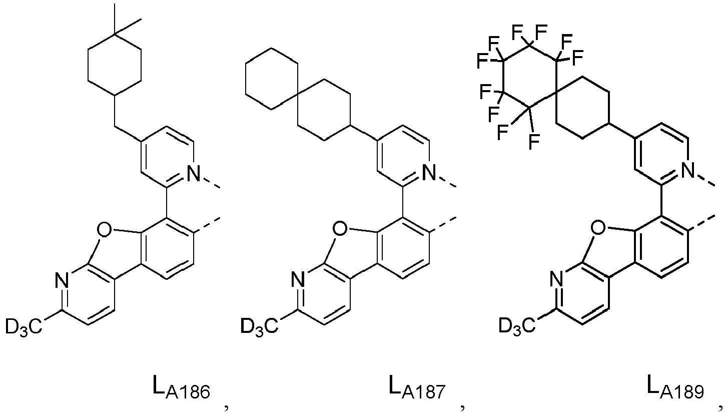

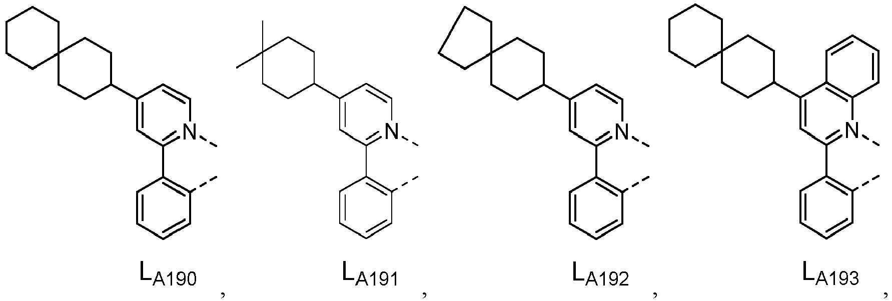

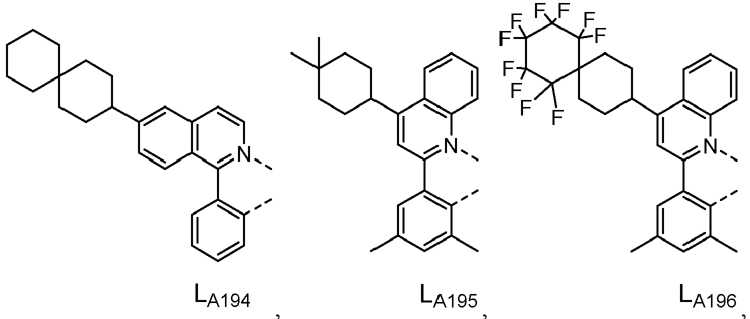

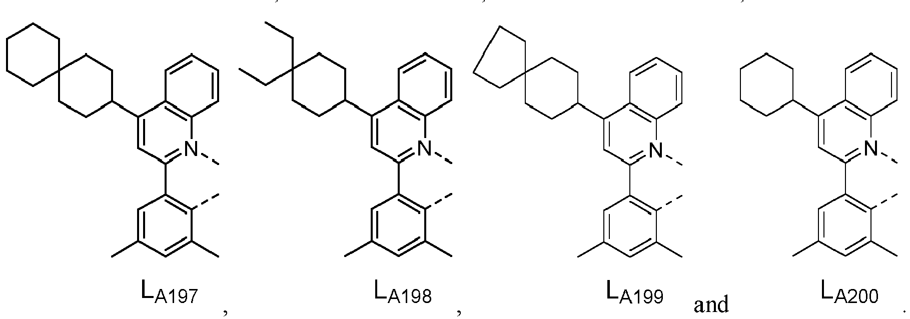

4. The phosphorescent emitter of any one of claims 1 to 3, wherein the ligand Lc is selected from the group consisting of:

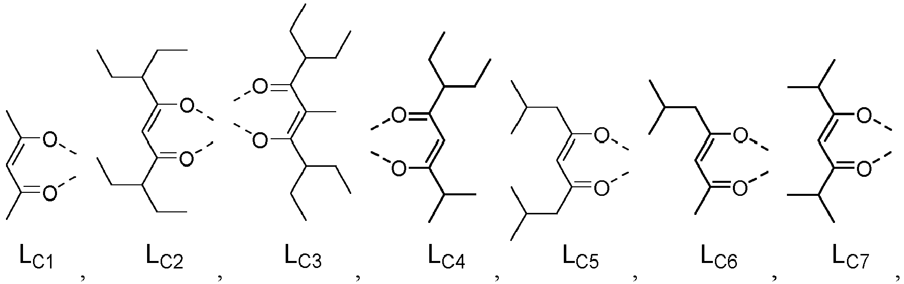

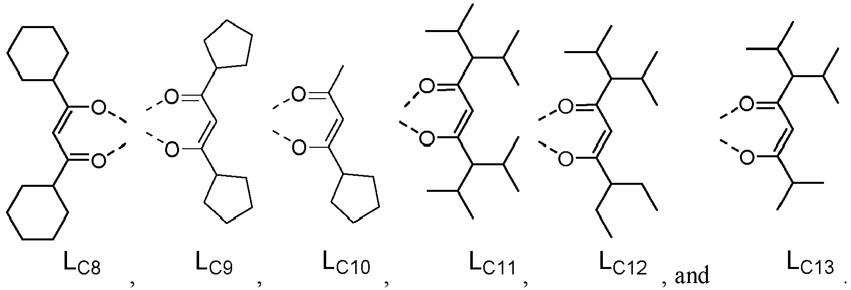

5. The phosphorescent emitter of claim 3, wherein the phosphorescent emitter is selected from the group consisting of Compound A-1 through Compound A-140,400;
where each Compound A-x has the formula Ir(L_{A*i*})(L_{B*j*})(L_{C*k*});
wherein x = 10,800(*k*-1)+200(*j*-1)+*i*, *i* is an integer from 1 to 200, *j* is an integer from 1 to 54; and *k* is an integer from 1 to 13;
wherein L_{B*j*} has the following structure: 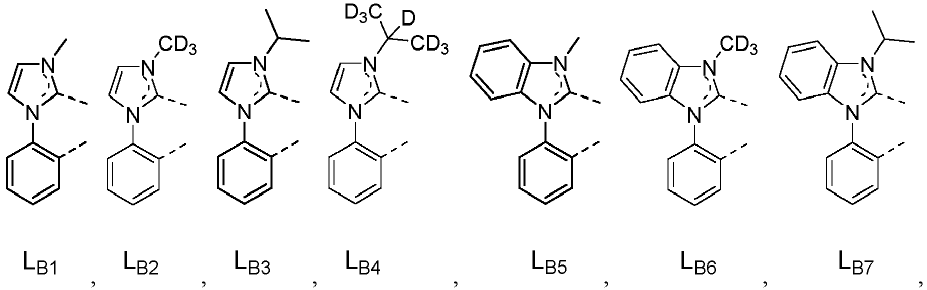 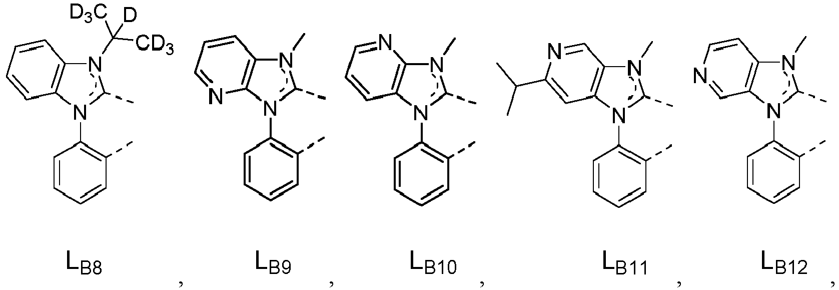 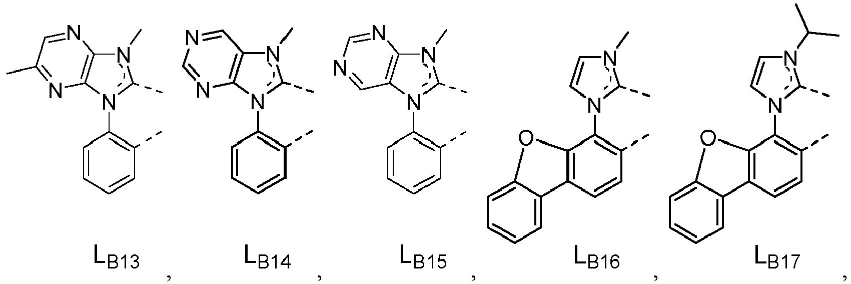 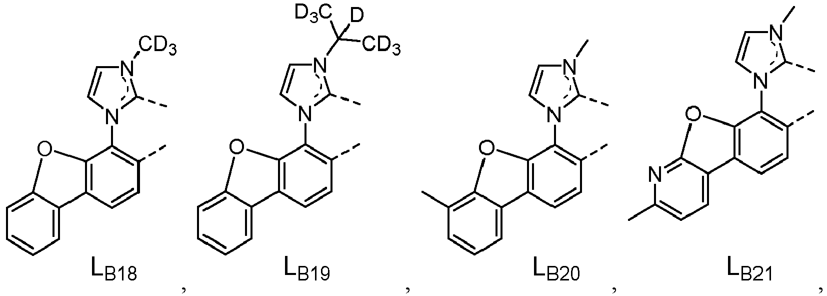 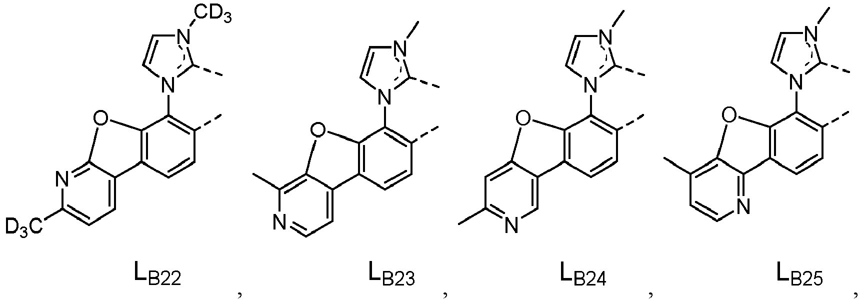 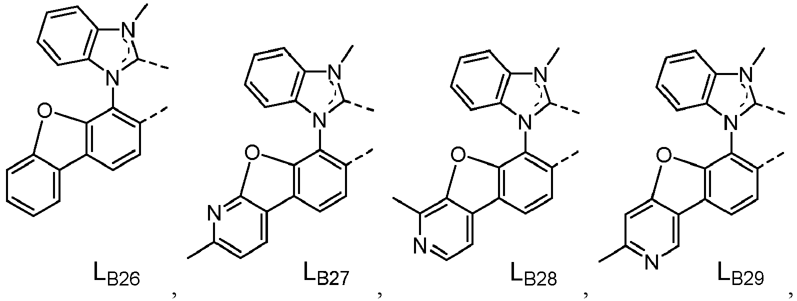 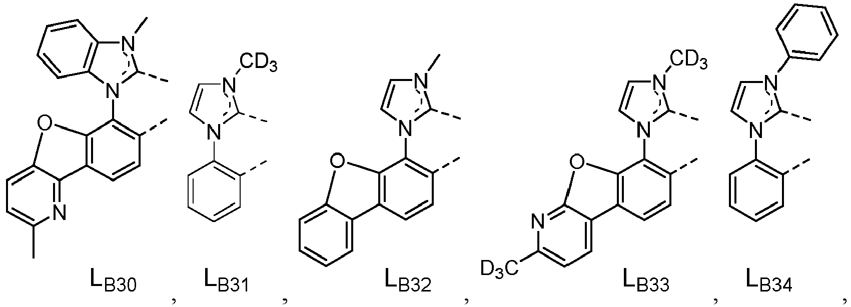 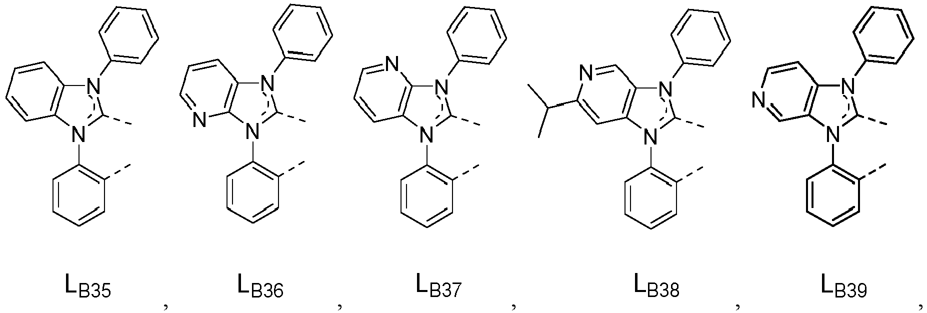 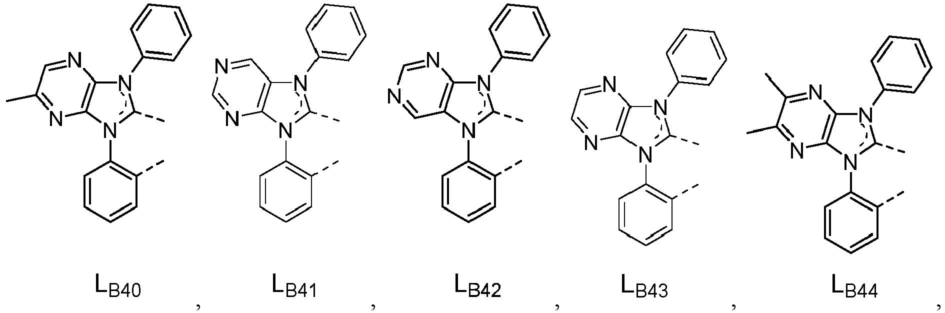 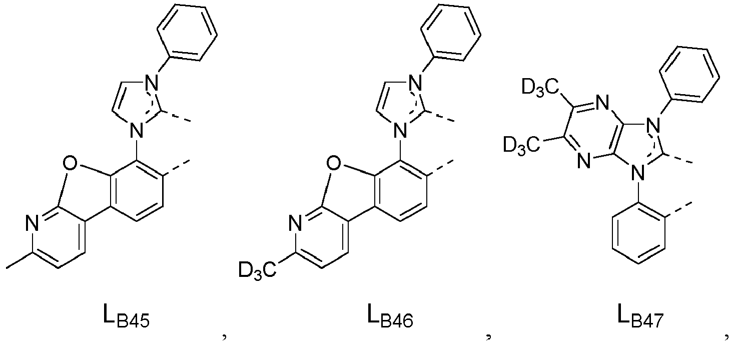 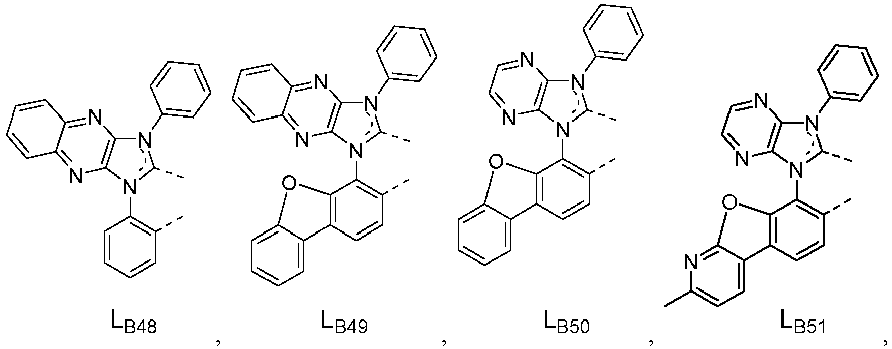 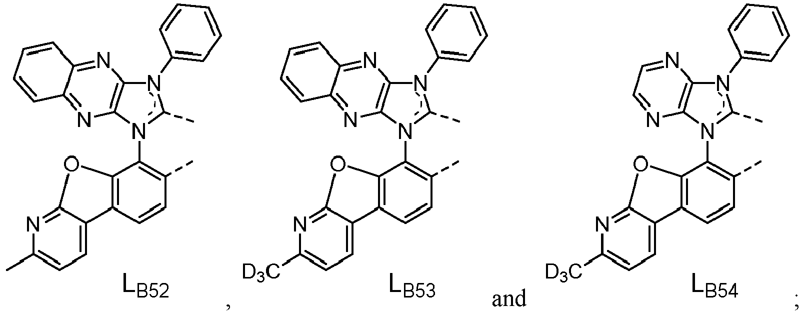 wherein L_{C*k*} has the following structure:

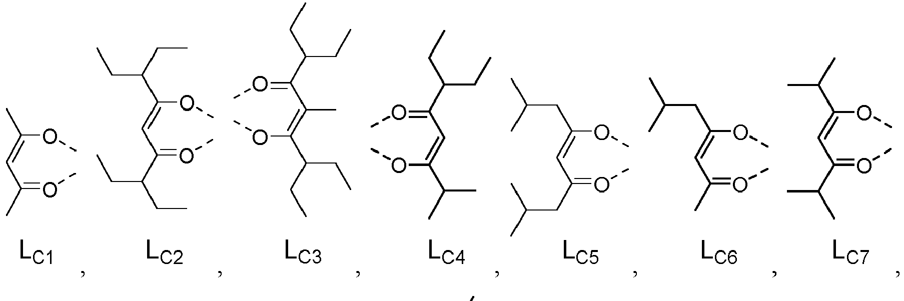

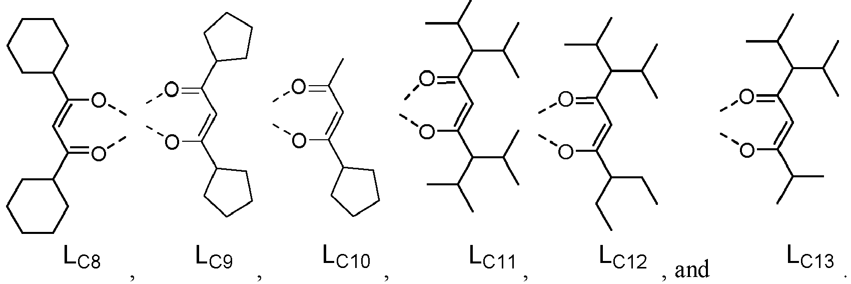

6. The phosphorescent emitter of claim 3, wherein the phosphorescent emitter has the formula lr(L_{A*i*})(L_{B}*j*)(L_{B*j*'}), *j* is not equal to *j*';
wherein *i* is an integer from 1 to 200, *j* is an integer from 1 to 54; and *j*' is an integer from 1 to 54;
wherein L_{B*j*} has the following structure:

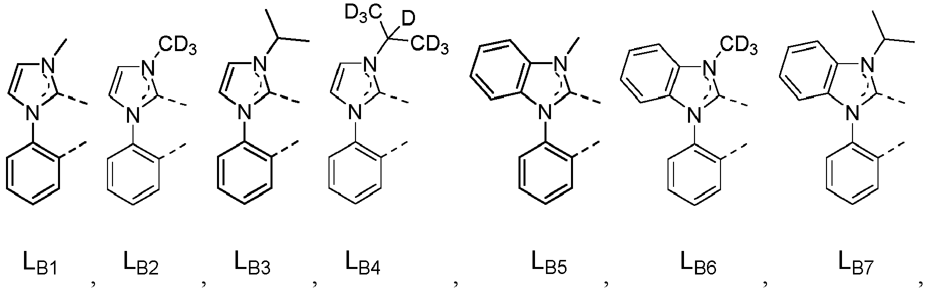

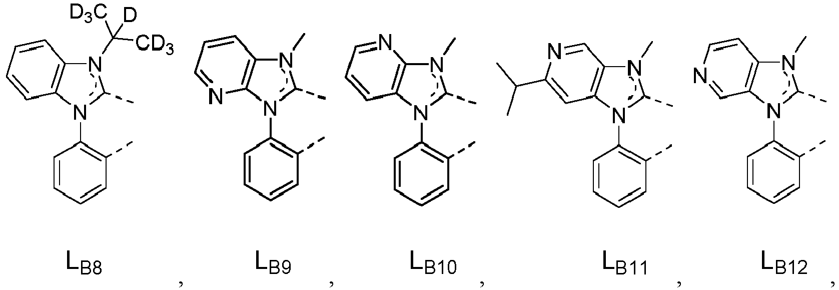

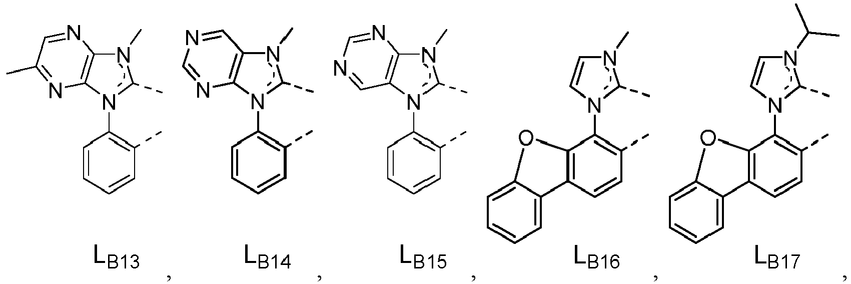

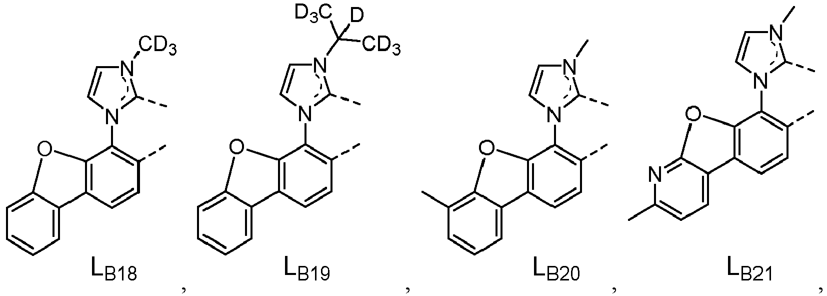

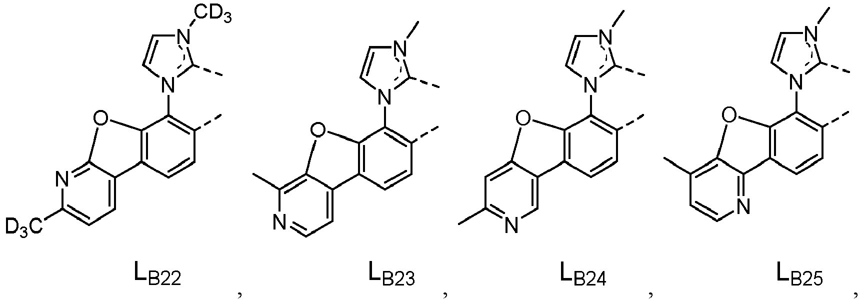

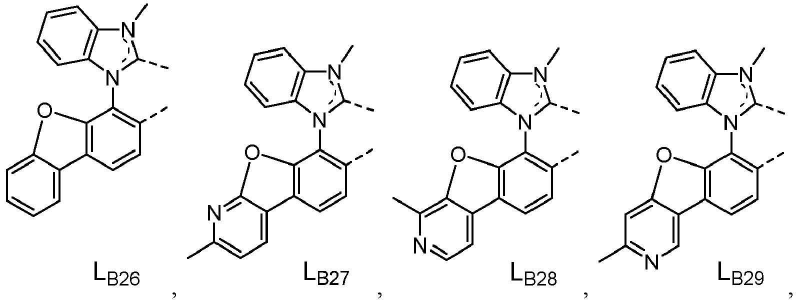

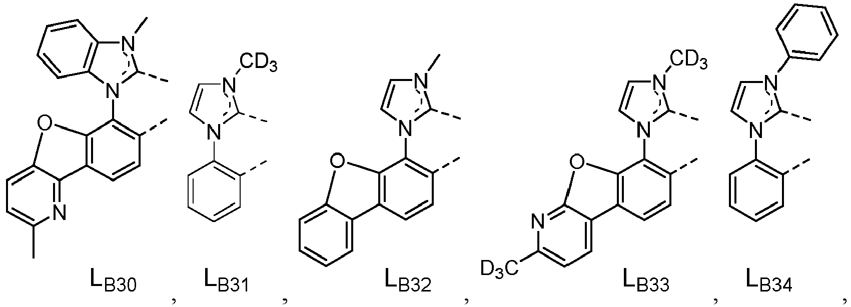

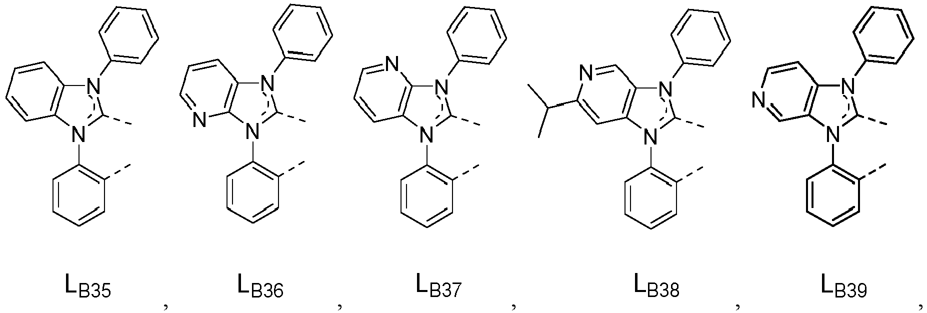

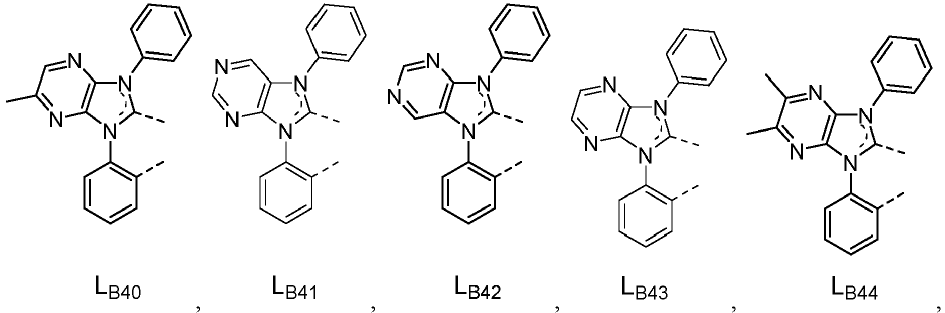

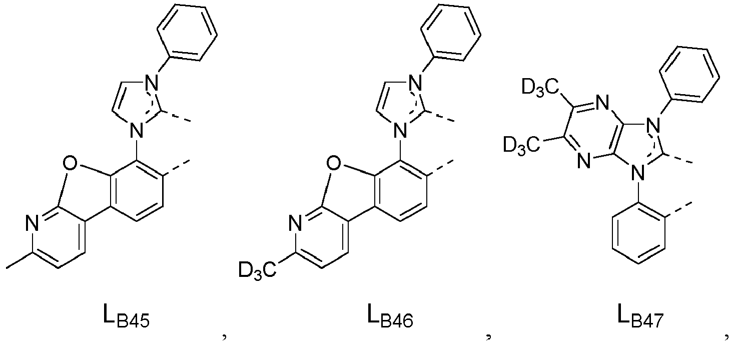

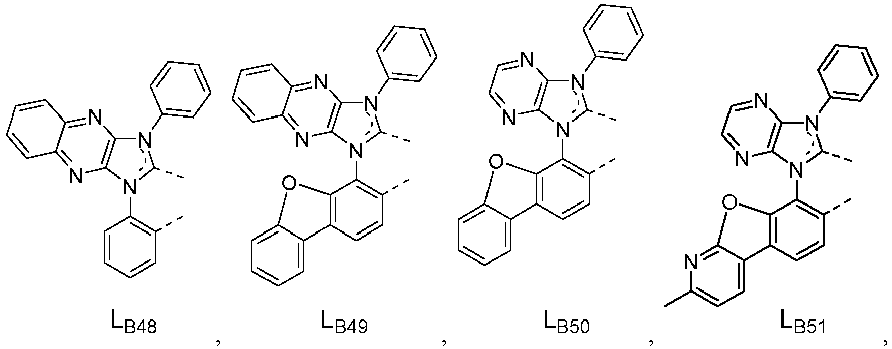

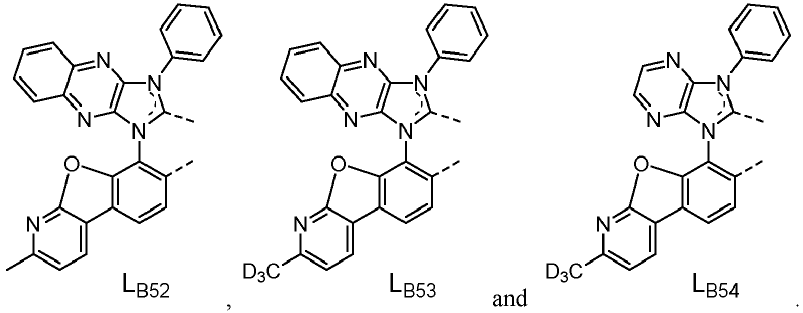

7. The phosphorescent emitter of claim 6, the phosphorescent emitter has the formula Ir(L_{B*j*})(L_{B*j*'})(L_{B*j*"});
wherein each of *j*, *j'*, and *j*" is an integer from 1 to 54; and
wherein *j*, *j*', and *j*" are different.

8. An organic light-emitting device (OLED) comprising:
an anode;
a cathode; and
an organic layer, disposed between the anode and the cathode, comprising a phosphorescent emitter as defined in any one of claims 1 to 7.

9. A consumer product comprising an organic light-emitting device (OLED), the OLED comprising a compound having a formula M(L_{A})ₓ(L_{B})_{y}(L_{C})_{z}:
wherein the ligand L_{A} is 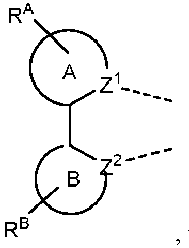 the ligand L_{B} is 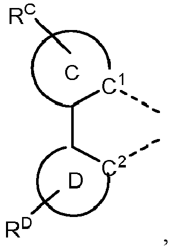 and the ligand Lc is 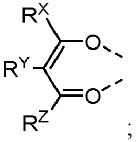
wherein M is a metal having an atomic number greater than 40;
wherein x is 0, 1, or 2;
wherein y is 1, 2, or 3;
wherein z is 0, 1, or 2;
wherein x+y+z is the oxidation state of the metal M;
wherein L_{A} is different from L_{B}, and when x, y, or z is larger than 1, each plurality of L_{A}, L_{B}, or L_{C} are also different;
wherein rings A, B, C, and D are each independently a 5 or 6-membered carbocyclic or heterocyclic ring;
wherein R^{A}, R^{B}, R^{C}, and R^{D} each independently represent mono substitution up to the maximum possible number of substitutions, or no substitution;
wherein Z¹ and Z² are each independently selected from the group consisting of carbon or nitrogen;
wherein C¹ is an anionic donor carbon atom, C² is a neutral carbene carbon atom;
wherein each of R^{A}, R^{B}, R^{C}, R^{D}, R^{X}, R^{Y}, and R^{Z} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any adjacent substituents are optionally joined or fused into a ring.

10. The consumer product of claim 9, wherein the consumer product is one of a flat panel display, a fully or partially transparent display, or a flexible display.

11. The consumer product of claim 9, wherein the consumer product is one of a medical monitor, computer monitor, a television, a heads-up display, a laser printer, or a laptop computer.

12. The consumer product of claim 9, wherein the consumer product is one of a telephone, a cell phone, tablet, a phablet, a personal digital assistant (PDA), a wearable device, a digital camera, a camcorder, a viewfinder, a micro-display, or a 3-D display.

13. The consumer product of claim 9, wherein the consumer product is one of organic solar cells and organic photodetectors, or an organic transistor.

14. The consumer product of claim 9, wherein the consumer product is one of a billboard, a large area wall, a theater or stadium screen, or a sign.

15. The consumer product of claim 9, wherein the consumer product is one of a light for interior or exterior illumination and/or signaling, or a vehicle.
